(19) **Europäisches Patentamt European Patent Office Office européen des brevets**

(11) **EP 4 580 360 A1**

(12) **EUROPEAN PATENT APPLICATION**
published in accordance with Art. 153(4) EPC

(43) Date of publication:
**02.07.2025 Bulletin 2025/27**

(21) Application number: **22965526.1**

(22) Date of filing: **17.11.2022**

(51) International Patent Classification (IPC):
***H10K 59/121*** (2023.01)

(52) Cooperative Patent Classification (CPC):
**H10K 59/88; H10K 59/121; H10K 59/1213;
H10K 59/1216; H10K 59/122; H10K 59/131;
H10K 59/1315**

(86) International application number:
**PCT/CN2022/132588**

(87) International publication number:
**WO 2024/103344 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
- **Boe Technology Group Co., Ltd.
  Beijing 100015 (CN)**
- **Beijing BOE Technology Development Co., Ltd.
  Beijing 100176 (CN)**

(72) Inventors:
- **WU, Tong
  Beijing 100176 (CN)**
- **WANG, Hongli
  Beijing 100176 (CN)**

- **LI, Pan
  Beijing 100176 (CN)**
- **HAN, Ying
  Beijing 100176 (CN)**
- **CUI, Ying
  Beijing 100176 (CN)**
- **YUAN, Can
  Beijing 100176 (CN)**
- **ZHANG, Xing
  Beijing 100176 (CN)**
- **ZHANG, Ruqin
  Beijing 100176 (CN)**
- **LONG, Chunping
  Beijing 100176 (CN)**

(74) Representative: **Brötz, Helmut et al
Rieder & Partner mbB
Patentanwälte - Rechtsanwalt
Yale-Allee 26
42329 Wuppertal (DE)**

(54) **DISPLAY SUBSTRATE AND DISPLAY DEVICE**

(57) Provided are a display substrate and a display device. The display substrate comprises a driving transistor and a storage capacitor. The storage capacitor comprises a first electrode plate and a second electrode plate. The second electrode plate and a channel of the driving transistor are arranged on the same layer, the second electrode plate is closer to a base substrate than the first electrode plate, and the orthographic projection of the second electrode plate on the base substrate overlaps the orthographic projections of pixel openings on the base substrate. The display substrate satisfies the following relations : the value range of (W*L+S2)*M1/M2 is [0.014, 0.133], and the value range of S2/(W*L) is [2.82, 28.85], wherein W is the width of the channel of the driving transistor, L is the length of the channel of the driving transistor, S2 is the opposite area of the second electrode plate and the first electrode plate, M1 is the number of pixel openings of the display substrate, and M2 is the area of the display substrate. Therefore, the opposite area of the electrode plates of the storage capacitor is increased, the electric capacity is improved, the holding capacity of a capacitor is improved, the area ratio of the storage capacitor to the pixel openings is increased, the area proportion of the storage capacitor is improved, and the display quality is improved.

EP 4 580 360 A1

Fig. 5

**Description**

TECHNICAL FIELD

Embodiments of the present disclosure relate to a display substrate and a display device.

BACKGROUND

With the rapid development of science and technology, display media has become an important part of people's life. Organic light-emitting diode (OLED) display medium has excellent color and image quality due to its self-luminescence.

SUMMARY

The embodiments of the present disclosure provide a display substrate and a display device, so as to improve display quality and/or reduce power consumption.

The embodiments of the present disclosure provide a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, and the first electrode plate of the storage capacitor being connected to a gate electrode of the driving transistor; and a light-emitting element, electrically connected to the pixel circuit, the pixel circuit being configured to drive the light-emitting element; the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, and the display substrate satisfies a following relationship: a value range of $(W*L+S2)*M1/M2$ is $[0.014, 0.133]$, and a value range of $S2/(W*L)$ is $[2.82, 28.85]$, where W is a width of the channel of the driving transistor, L is a length of the channel of the driving transistor, S2 is a facing area between the second electrode plate and the first electrode plate, M1 is a count of pixel openings in the display substrate, and M2 is an area of the display substrate.

For example, the second electrode plate of the storage capacitor is connected to a first electrode of the driving transistor, the storage capacitor further includes a third electrode plate, the third electrode plate and the second electrode plate are connected to each other, and the third electrode plate and the second electrode plate are arranged at both sides of the first electrode plate, respectively.

For example, the second electrode plate includes a first plate-shaped portion, and the first plate-shaped portion and the channel of the driving transistor are of an integral structure.

For example, the second electrode plate further includes a second plate-shaped portion, the first plate-shaped portion and the second plate-shaped portion are separated from each other, and an area of the first plate-shaped portion is greater than an area of the second plate-shaped portion, or both the first plate-shaped portion and the second plate-shaped portion are connected with the channel of the driving transistor.

For example, the channel of the driving transistor is made of a semiconductor material, and the second electrode plate is a conductor obtained by doping on a same semiconductor material as the channel of the driving transistor.

For example, the channel of the driving transistor extends in a first direction, the pixel opening has a central axis extending in the first direction, a maximum size of the pixel opening in a second direction is WO, the first direction intersects with the second direction, a distance between the channel of the driving transistor and the central axis is D1, and a value range of $2*D1/WO$ is $[0.2, 0.4]$ or $[0.6, 0.8]$.

For example, the display substrate further includes a plurality of signal lines located at one side of the storage capacitor, each of the plurality of signal lines extends in the second direction, orthographic projections of the plurality of signal lines on the base substrate overlap with the orthographic projection of the pixel opening on the base substrate, a size of the pixel opening in the first direction is H0, a distance between farthest edges of the plurality of signal lines in the first direction is Hs, and a value range of $L/(H0-Hs)$ is $[0.16, 0.61]$.

For example, the display substrate further includes a data line, a first gate line, a second gate line, and a first initialization line, the pixel circuit further includes a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line, a first electrode of the first reset transistor is connected to the first initialization line, a second electrode of the first reset transistor is connected to the gate electrode of the driving transistor, and a gate electrode of the first reset transistor is connected to the second gate line, and the plurality of signal lines include the first gate line, the second gate line, and the first initialization line.

For example, an area of the pixel opening is S0, a sum of the facing area between the second electrode plate and the first electrode plate and an area of the channel of the driving transistor is Ss, and a relationship between Ss and S0 satisfies: Ss=A*S0+B, where a value range of A is [0.42, 0.82] and a value range of B is [-2700, -3100].

For example, the orthographic projection of the pixel opening on the base substrate overlaps with an orthographic projection of the third electrode plate on the base substrate, the third electrode plate includes a first edge extending in a first direction and a second edge extending in the first direction, and the pixel opening includes a first edge extending in the first direction and a second edge extending in the first direction, the first edge of the third electrode plate is closer to the first edge of the pixel opening than the second edge of the third electrode plate, and the second edge of the third electrode plate is closer to the second edge of the pixel opening than the first edge of the third electrode plate, the sub-pixel satisfies a following formula: $\Delta U=|U02-U01|$, where U01 is a coordinate distance between a chromaticity coordinate point at a first viewing angle and a chromaticity coordinate point at a 0-degree viewing angle, U02 is a coordinate distance between a chromaticity coordinate point at a second viewing angle and the chromaticity coordinate point at the 0-degree viewing angle, and $\Delta U$ is an absolute value of a difference between U02 and U01, the chromaticity coordinate point at the 0-degree viewing angle is a chromaticity coordinate point at a normal line passing through a center of the display substrate, the first viewing angle and the second viewing angle are arranged at opposite sides of the normal line and have an equal included angle value with the normal line, and $\Delta U \leq 0.0020$.

For example, the display substrate further includes a first power line, the first power line is configured to provide a first voltage signal to the pixel circuit, the first power line includes a first power connection line extending in the first direction and a first power signal line extending in a second direction, an orthographic projection of the first power connection line on the base substrate overlaps with the orthographic projection of the pixel opening on the base substrate, a facing area between the third electrode plate and the first electrode plate is Sc1, and an overlapping area between the orthographic projection of the third electrode plate on the base substrate and the orthographic projection of the pixel opening on the base substrate is Sc2, and $Sc2/Sc1 \geq 0.9$; a width of the first power connection line is W1, an overlapping width between the first power connection line and the pixel opening is W2, and $W2/W1 \geq 0.9$.

For example, a maximum size of the pixel opening in a second direction is WO, a value range of $2 \times W2/WO$ is [0.71, 0.99], and a value range of cross voltage Uc/size Lg is [0.32, 0.74], where the cross voltage Uc is a cross voltage of the light-emitting element, a unit of the cross voltage Uc is volts, the size Lg is a diagonal length of the display substrate, and a unit of the size Lg is inches.

For example, the pixel opening has a central axis extending in the first direction, a minimum distance between the first power connection line and the central axis is Xd1, a minimum distance between the third electrode plate and the central axis is Xd2, and a value range of Xd1/Xd2 is [0.9, 1.1].

For example, the display substrate further includes a plurality of signal lines located at one side of the storage capacitor, orthographic projections of the plurality of signal lines on the base substrate overlap with the orthographic projection of the pixel opening on the base substrate, the plurality of signal lines are arranged in the first direction, each of the plurality of signal lines extends in a second direction, the first direction intersects with the second direction, a distance between the third electrode plate and one of the plurality of signal lines closest to the third electrode plate is Xd3, a width of the signal line is Xd4, and a value range of Xd3/Xd4 is [0.9, 1.1].

For example, the display substrate further includes a first power line, the first power line is configured to provide a first voltage signal to the pixel circuit, the first power line includes a first power connection line extending in the first direction and a first power signal line extending in a second direction, the pixel opening has a central axis extending in the first direction, a minimum distance between the first power connection line and the central axis is Xd1, a minimum distance between the first power connection line and the third electrode plate is Xd0, $DP=|Xd1-Xd0|/2$, a maximum size of the pixel opening in the second direction is WO, and a value range of DP/WO is [0.01, 0.19].

For example, the display substrate further includes a first signal line, the first signal line extends in the first direction, the plurality of sub-pixels includes a first sub-pixel and a second sub-pixel that are adjacent to each other in a second direction, the first signal line is configured to provide a data signal to the pixel circuit of the first sub-pixel, the pixel opening of the first sub-pixel and the pixel opening of the second sub-pixel are separated from each other, and the first signal line is located between the pixel opening of the first sub-pixel and the pixel opening of the second sub-pixel.

For example, a minimum distance between the pixel opening of the first sub-pixel and the first signal line is Xa1, a minimum distance between the pixel opening of the second sub-pixel and the first signal line is Xa2, and a value range of Xa1/Xa2 is [0.8, 1.2].

For example, the display substrate further includes a second signal line, the second signal line extends in the first direction, the first signal line and the second signal line are located at opposite sides of a same third electrode plate, and an orthographic projection of the second signal line on the base substrate overlaps with an orthographic projection of the pixel opening of the second sub-pixel on the base substrate.

For example, a distance between the third electrode plate and the second signal line is Xa3, a distance between the third electrode plate and the first signal line is Xa4, and a value range of Xa3/Xa4 is [0.8, 1.2].

For example, the display substrate further includes a third signal line, the third signal line extends in the first direction, an orthographic projection of the third signal line on the base substrate overlaps with an orthographic projection of the pixel opening of the first sub-pixel on the base substrate, a minimum distance between the third electrode plate of the first sub-pixel and the third signal line is Xa5, a minimum distance between the third signal line and the first signal line is Xa6, and a value range of Xa5/Xa6 is [0.8, 1.2].

For example, the first signal line includes a data line, and at least one of the second signal line and the third signal line includes a first power connection line.

For example, the display substrate further includes a data line and a first power line, the data line is configured to provide a data voltage to the pixel circuit, and the data line extends in a first direction, the first power line is configured to provide a first voltage signal to the pixel circuit, and the first power line includes a first power connection line extending in the first direction and a first power signal line extending in a second direction, the plurality of sub-pixels include a first sub-pixel and a second sub-pixel that are adjacent to each other in the second direction, and an orthographic projection of the first power connection line on the base substrate overlaps with an orthographic projection of the pixel opening of the first sub-pixel on the base substrate, and overlaps with an orthographic projection of the pixel opening of the second sub-pixel on the base substrate.

For example, two data lines are arranged at two sides of the first power connection line, respectively, and orthographic projections of the two data lines on the base substrate overlap with the orthographic projections of the pixel opening of the first sub-pixel and the pixel opening of the second sub-pixel on the base substrate, respectively.

For example, two data lines are arranged at two sides of the first power connection line, respectively, and orthographic projections of the two data lines on the base substrate do not overlap with the orthographic projection of the pixel opening of the first sub-pixel on the base substrate, and do not overlap with the orthographic projection of the pixel opening of the second sub-pixel on the base substrate.

For example, the display substrate further includes a first power line, the first power line is configured to provide a first voltage signal to the pixel circuit, the first power line includes a first power connection line extending in a first direction and a first power signal line extending in a second direction, and an orthographic projection of the first power connection line on the base substrate overlaps with the orthographic projection of the pixel opening on the base substrate, a maximum size of the pixel opening in the second direction is WO, the plurality of sub-pixels include a first sub-pixel and a second sub-pixel that are adjacent to each other in the second direction, a size of one of two first power connection lines in the second direction is Xb1, a size of the other of the two first power connection lines in the second direction is Xb2, and a value range of (Xb1+Xb2)/WO is [0.08, 0.48].

For example, the display substrate further includes a driving circuit, the driving circuit is located at one side of the display substrate, one sub-pixel away from the driving circuit has a first brightness L1, one sub-pixel close to the driving circuit has a second brightness L2, and a value range of |L1-L2| is [1, 9].

For example, the display substrate further includes two driving circuits, the two driving circuits are located at opposite sides of a display region of the display substrate, one sub-pixel at a central axis of the display substrate has a third brightness L3, one sub-pixel close to one of the two driving circuits has a fourth brightness L4, an extending direction of the central axis of the display substrate is the same as an extending direction of one of the two driving circuits, and a value range of |L3-L4| is [1, 9].

For example, a first defining portion is arranged between two pixel openings that are adjacent to each other in a first direction, a second defining portion is arranged between two pixel openings that are adjacent to each other in a second direction, and the first direction intersects with the second direction; a thickness of the first defining portion is H1, a thickness of the second defining portion is H2, and H1≠H2.

For example, H1 is less than H2.

For example, the display substrate further includes an insulating layer, a barrier dam, and an encapsulation layer, the light-emitting element includes a first electrode, a second electrode, and a light-emitting functional layer located therebetween, and the first electrode of the light-emitting element is connected to the pixel circuit through a via hole penetrating the insulating layer, the encapsulation layer is configured to encapsulate the light-emitting element, the encapsulation layer includes a stack of an inorganic encapsulation film and an organic encapsulation film, an encapsulation adhesive is provided at an outer side of the encapsulation layer, the insulating layer includes a planarization layer, the planarization layer includes a first planarization portion and a second planarization portion, and a groove is arranged between the first planarization portion and the second planarization portion, the barrier dam is located at a periphery of a display region of the display substrate, and an orthographic projection of the barrier dam on the base substrate covers an orthographic projection of the groove on the base substrate.

For example, the display substrate further includes a data line, a first gate line, a second gate line, and a first initialization line, the pixel circuit further includes a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line, a first electrode of the first reset transistor is connected to the first initialization line, a second electrode of the first reset transistor is connected to the gate electrode of the driving transistor, and a gate electrode of the first reset transistor is connected to the second gate line, a dummy sub-pixel is arranged in a vicinity of an edge of the display substrate, the dummy sub-pixel is provided with a dummy driving transistor and a first dummy reset transistor, the first dummy reset transistor is connected to a gate electrode of the dummy driving transistor, and the first dummy reset transistor is disconnected from the first initialization line.

For example, the display substrate further includes a dummy data line, the dummy data line extends in a first direction, the dummy data line and the data line are insulated from each other, the dummy sub-pixel includes at least two dummy sub-pixels that are adjacent to each other in a second direction, dummy data lines of the at least two dummy sub-pixels are connected to each other.

For example, the dummy data line is connected to a constant voltage terminal, so as to be configured to provide a constant voltage.

For example, the at least two dummy sub-pixels include a first dummy sub-pixel, a second dummy sub-pixel, and a third dummy sub-pixel, and three dummy data lines of the first dummy sub-pixel, the second dummy sub-pixel, and the third dummy sub-pixel are connected to each other.

For example, the display substrate further includes a first power line, the pixel circuit further includes a light-emitting control transistor, a first electrode of the light-emitting control transistor is connected to the first power line, a second electrode of the light-emitting control transistor is connected to a second electrode of the driving transistor, the dummy sub-pixel further includes a dummy light-emitting control transistor, a first electrode of the dummy light-emitting control transistor is disconnected from the first power line, and a second electrode of the dummy light-emitting control transistor is connected to a second electrode of the dummy driving transistor.

For example, the display substrate further includes a pixel defining layer, the pixel defining layer includes a defining portion, the pixel opening is defined by the defining portion, the light-emitting element includes a first electrode and a light-emitting functional layer, the pixel defining layer is configured to expose at least a part of the first electrode of the light-emitting element, and the light-emitting functional layer covers a sidewall of the defining portion.

For example, the light-emitting element further includes a second electrode, the light-emitting functional layer is located between the first electrode and the second electrode of the light-emitting element, and the second electrode of the light-emitting element is in contact with a top wall of the defining portion.

For example, the display substrate further includes an insulating layer, the first electrode of the light-emitting element is connected to the pixel circuit through a via hole penetrating the insulating layer, the defining portion includes a first defining portion and a second defining portion, a thickness of the first defining portion is less than a thickness of the second defining portion, and an orthographic projection of the via hole on the base substrate overlaps with an orthographic projection of the first defining portion on the base substrate.

For example, the display substrate further includes a dummy pixel defining layer, the dummy pixel defining layer includes a plurality of dummy defining portions, and an extending direction of each of the plurality of dummy defining portions is the same as an extending direction of the second defining portion, and a spacing between two adjacent dummy defining portions is greater than a spacing between two adjacent second defining portions.

For example, the spacing between two adjacent dummy defining portions is 2-20 times the spacing between two adjacent second defining portions.

For example, the display substrate further includes a second reset transistor, a second initialization line, and an initialization bus, the initialization bus is arranged at an outer side of a display region of the display substrate, a first electrode of the second reset transistor is connected to the initialization bus through the second initialization line, a second electrode of the second reset transistor is connected to the light-emitting element through the driving transistor, the second reset transistor is connected to a row of sub-pixels, and in terms of a same row of sub-pixels, a count of second reset transistors is less than a count of sub-pixels.

For example, the display substrate further includes a light-emitting control transistor, a first power line, and a first power bus, the first power line is configured to provide a first voltage signal to the pixel circuit, and the first power line is connected to the first power bus, a first electrode of the light-emitting control transistor is connected to the first power line, and a second electrode of the light-emitting control transistor is connected to a second electrode of the driving transistor, a count of light-emitting control transistors of sub-pixels in one row is less than a count of sub-pixels in the row.

For example, a count of light-emitting control transistors of sub-pixels in one row is greater than a count of second reset transistors in the row.

For example, the second electrode plate is arranged in a same layer as the channel of the driving transistor, the second electrode plate is closer to the base substrate than the first electrode plate, and an orthographic projection of the second electrode plate on the base substrate overlaps with the orthographic projection of the pixel opening on the base substrate.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, and the display substrate satisfies a following relationship: a value range of $(W*L+S2)*M1/M2$ is $[0.014, 0.133]$, and $P=k0*(W/L)*Uc$, where a value range of $k0$ is $[2.8*E-07, 5.8*E-06]$, where $W$ is a width of the channel of the driving transistor, $L$ is a length of the channel of the driving transistor, $S2$ is a facing area between the second electrode plate and the first electrode plate, $M1$ is a count of pixel openings in the display substrate, $M2$ is an area of the display substrate, $Uc$ is a cross voltage of the light-emitting element, and $P$ is power consumption of the sub-pixel.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, a first defining portion is arranged between two pixel openings that are adjacent to each other in a first direction, a second defining portion is arranged between two pixel openings that are adjacent to each other in a second direction, and the first direction intersects with the second direction; a thickness of the first defining portion is H1, a thickness of the second defining portion is H2, and $H1{\neq}H2$; and the display substrate satisfies a following relationship: a value range of $S2/(W*L)$ is $[2.82, 28.85]$, where $W$ is a width of the channel of the driving transistor, $L$ is a length of the channel of the driving transistor, $S2$ is a facing area between the second electrode plate and the first electrode plate.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, the display substrate further includes an insulating layer, a barrier dam, and an encapsulation layer; the light-emitting element includes a first electrode, a second electrode, and a light-emitting functional layer located therebetween, and the first electrode of the light-emitting element is connected to the pixel circuit through a via hole penetrating the insulating layer, the encapsulation layer is configured to encapsulate the light-emitting element, the encapsulation layer includes a stack of an inorganic encapsulation film and an organic encapsulation film, an encapsulation adhesive is provided at an outer side of the encapsulation layer, the insulating layer includes a planarization layer, the planarization layer includes a first planarization portion and a second planarization portion, and a groove is arranged between the first planarization portion and the second planarization portion, the barrier dam is located at a periphery of a display region of the display substrate, and an orthographic projection of the barrier dam on the base substrate covers an orthographic projection of the groove on the base substrate; and the display substrate satisfies a following relationship: a value range of $S2/(W*L)$ is $[2.82, 28.85]$, where $W$ is a width of the channel of the driving transistor, $L$ is a length of the channel of the driving transistor, $S2$ is a facing area between the second electrode plate and the first electrode plate.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, the display substrate satisfies a following relationship: a value range of S2/(W*L) is [2.82, 28.85], where W is a width of the channel of the driving transistor, L is a length of the channel of the driving transistor, S2 is a facing area between the second electrode plate and the first electrode plate.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, the display substrate further includes a data line, a first gate line, a second gate line, and a first initialization line, the pixel circuit further includes a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line, a first electrode of the first reset transistor is connected to the first initialization line, a second electrode of the first reset transistor is connected to the gate electrode of the driving transistor, and a gate electrode of the first reset transistor is connected to the second gate line, a dummy sub-pixel is arranged in a vicinity of an edge of the display substrate, the dummy sub-pixel is provided with a dummy driving transistor and a first dummy reset transistor, the first dummy reset transistor is connected to a gate electrode of the dummy driving transistor, the first dummy reset transistor is disconnected from the first initialization line; and the display substrate satisfies a following relationship: a value range of S2/(W*L) is [2.82, 28.85], where W is a width of the channel of the driving transistor, L is a length of the channel of the driving transistor, S2 is a facing area between the second electrode plate and the first electrode plate.

Embodiments of the present disclosure further provides a display substrate, including: a base substrate and a plurality of sub-pixels disposed on the base substrate; each of the plurality of sub-pixels includes: a pixel circuit, including a driving transistor and a storage capacitor, the storage capacitor including a first electrode plate and a second electrode plate, the first electrode plate of the storage capacitor being connected to a gate electrode of the driving transistor, and the second electrode plate of the storage capacitor being connected to a first electrode of the driving transistor; and a light-emitting element, electrically connected to the pixel circuit, the pixel circuit being configured to drive the light-emitting element, the sub-pixel includes a pixel opening, the pixel opening is configured to define a light-emitting region of the sub-pixel, an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, the second electrode plate is arranged in a same layer as the channel of the driving transistor, the second electrode plate is closer to the base substrate than the first electrode plate, the display substrate further includes a pixel defining layer, the pixel defining layer includes a defining portion, the pixel opening is defined by the defining portion, the light-emitting element includes a first electrode and a light-emitting functional layer, the pixel defining layer is configured to expose at least a part of the first electrode of the light-emitting element, the light-emitting functional layer covers a sidewall of the defining portion, and the display substrate satisfies a following relationship: a value range of S2/(W*L) is [2.82, 28.85], where W is a width of the channel of the driving transistor, L is a length of the channel of the driving transistor, S2 is a facing area between the second electrode plate and the first electrode plate.

For example, for any one of the display substrates satisfying that a value range of S2/(W*L) is [2.82, 28.85], the display substrate can also satisfy a following relationship: a value range of (W*L+S2)*M1/M2 is [0.014, 0.133], where M1 is a count of pixel openings in the display substrate, and M2 is an area of the display substrate.

For example, for any one of the display substrates satisfying that a value range of S2/(W*L) is [2.82, 28.85] and/or satisfying that a value range of (W*L+S2)*M1/M2 is [0.014, 0.133], the display substrate can also satisfy a following relationship: $P=k0*(W/L)*Uc$, where a value range of k0 is [2.8*E-07, 5.8*E-06], Uc is a cross voltage of the light-emitting element, and P is power consumption of the sub-pixel.

Embodiments of the present disclosure further provides a display device, including any one of the display substrates as described above.

BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not construed as any limitation to the present disclosure.

Fig. 1 is a schematic diagram of pixel arrangement of a display substrate.

Fig. 2 is a schematic diagram of a pixel circuit, which drives a light-emitting element to emit light, in a display substrate provided by an embodiment of the present disclosure.

Fig. 3 is a schematic circuit diagram of a display substrate provided by another embodiment of the present disclosure.

Fig. 4 is a schematic circuit diagram of a display substrate provided by another embodiment of the present disclosure.

Fig. 5 is a layout diagram of a display substrate provided by an embodiment of the present disclosure.

Fig. 6 is a cross-sectional view taken along line A1-A2 of Fig. 5.

Fig. 7A-Fig. 7G are plan views of a single layer of the display substrate in Fig. 5.

Fig. 8A-Fig. 8E are plan views of part of stacked layers of the display substrate in Fig. 5.

Fig. 8F is a schematic diagram of a width and length of a channel of a driving transistor in the display substrate of Fig. 5.

Fig. 9 is a layout diagram of a display substrate provided by an embodiment of the present disclosure.

Fig. 10 is a layout diagram of a display substrate provided by another embodiment of the present disclosure.

Fig. 11 is a layout diagram of a display substrate provided by another embodiment of the present disclosure.

Fig. 12 is a layout diagram of a display substrate provided by another embodiment of the present disclosure.

Fig. 13 is a layout diagram of a display substrate provided by another embodiment of the present disclosure.

Fig. 14 is a layout diagram of a display substrate provided by another embodiment of the present disclosure.

Fig. 15 is a diagram of stacked layers of some film layers in Fig. 14.

Fig. 16 is a layout diagram of a display substrate provided by another embodiment of the present disclosure.

Fig. 17 is a diagram of stacked layers of some film layers in Fig. 16.

Fig. 18 is a diagram of stacked layers of some film layers in a display substrate provided by an embodiment of the present disclosure.

Fig. 19 is a diagram of stacked layers of some film layers in a display substrate provided by an embodiment of the present disclosure.

Fig. 20 is a diagram of stacked layers of some film layers in a display substrate provided by an embodiment of the present disclosure.

Fig. 21 is a schematic diagram of a central-point pixel of a display substrate provided by an embodiment of the present disclosure.

Fig. 22 is a cross-sectional view taken along line B1-B2 of Fig. 21.

Fig. 23 is a schematic diagram showing a coordinate distance between chromaticity coordinate points at two different viewing angles of a display substrate.

Fig. 24 is a layout diagram of a display substrate provided by an embodiment of the present disclosure.

Fig. 25 is a plan view of a display substrate provided by an embodiment of the present disclosure.

Fig. 26 is a plan view of a display substrate provided by an embodiment of the present disclosure.

Fig. 27 is a plan view of a display substrate provided by an embodiment of the present disclosure.

Fig. 28 is a plan view of a display substrate provided by an embodiment of the present disclosure.

Fig. 29 is a layout diagram of a display substrate provided by an embodiment of the present disclosure.

Fig. 30 is a schematic diagram of a display substrate provided by an embodiment of the present disclosure.

Fig. 31 is a schematic diagram of a display substrate provided by an embodiment of the present disclosure.

Fig. 32 is a schematic diagram of a display substrate provided by an embodiment of the present disclosure.

Fig. 33A is a plan view of a pixel defining layer in a display substrate provided by an embodiment of the present disclosure.

Fig. 33B is a plan view of a pixel defining layer in a display substrate provided by an embodiment of the present disclosure.

Fig. 34 is a schematic diagram of a display substrate provided by an embodiment of the present disclosure.

Fig. 35 is an electron micrograph of a display substrate provided by an embodiment of the present disclosure.

Fig. 36 is a schematic diagram of a display substrate provided by an embodiment of the present disclosure.

Fig. 37 is a schematic diagram of a display substrate provided by an embodiment of the present disclosure.

Fig. 38 is a schematic circuit diagram of a dummy sub-pixel in a display substrate provided by an embodiment of the present disclosure.

Fig. 39 is a layout diagram of a dummy pixel circuit in a display substrate provided by an embodiment of the present disclosure.

Fig. 40 is a schematic diagram of a display substrate provided by an embodiment of the present disclosure.

Fig. 41A is a schematic diagram of a display substrate provided by an embodiment of the present disclosure.

Fig. 41B is a schematic diagram of a display substrate provided by another embodiment of the present disclosure.

Fig. 42 is a schematic diagram of a display substrate provided by an embodiment of the present disclosure.

Fig. 43 is a schematic diagram of a display substrate provided by an embodiment of the present disclosure.

Fig. 44 is a circuit diagram of a display substrate provided by an embodiment of the present disclosure.

Fig. 45 is a schematic diagram of a display substrate provided by an embodiment of the present disclosure.

Fig. 46 is a schematic diagram of a brightness test of a display substrate provided by an embodiment of the present disclosure.

## DETAILED DESCRIPTION

In order to make objectives, technical details and advantages of the embodiments of the present disclosure more clear, the technical solutions of the embodiments will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present disclosure, are not intended to indicate any sequence, amount or importance, but distinguish various components. Also , the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected" and the like are not limited to a physical or mechanical connection, but also include an electrical connection, either directly or indirectly. The terms "on," "under," "right," "left" and the like are only used to indicate relative position relationship, and when the position of the described object is changed, the relative position relationship may be changed accordingly.

In a traditional organic light-emitting diode display, the organic light-emitting layer needs to be completed by an evaporation process, and the process conditions are demanding and it is difficult to achieve a large-area design.

The use of inkjet printing to manufacturing OLED luminescent material layer is the best way to realize low-cost OLED production, and enable OLED displays to compete in the middle-end and high-end market. Inkjet printing is an efficient process. Compared with evaporation, inkjet printing has less material waste and is very quick.

When the light-emitting functional layer of an organic light-emitting diode is formed by inkjet printing, the main method is to dissolve the organic material by using a solvent to form a solution (ink), and then directly spray the solution (ink) onto the surface of the base substrate to form a light-emitting functional layer of a sub pixel, such as a red (R) sub-pixel, a green (G) sub-pixel, a blue (B) sub-pixel, etc. Inkjet printing OLED technology has significant advantages over evaporation technology in terms of production process, yield, and cost, etc. For example, the light-emitting functional layer includes a plurality of film layers, such as a light-emitting layer (a luminescent material layer); and the light-emitting functional layer can further include at least one of a hole injection layer, a hole transport layer, an electron transport layer, and an electron injection layer, etc. The organic light-emitting functional layer can be selected as needed. At least one film layer in the light-emitting functional layer can be manufactured by inkjet printing process.

Due to the high molecular weight of polymers, solutions are mainly used to form films, such as spin coating or printing, and inkjet printing technology is the best method to prepare luminescent polymer solutions. In recent years, people have made a lot of efforts to improve the pixel resolution, film uniformity and prolong the life of display screens, and the research on forming photoelectric materials by inkjet printing has become more and more active. For example, the film layers of the display screen, such as a hole transport layer, a hole injection layer, a light-emitting layer, etc., can be prepared by inkjet printing technology, which lays the foundation for producing the display screen by means of full printing.

When the film layer in the light-emitting functional layer is manufactured by inkjet printing process, the flatness of the light-emitting functional layer is required to be higher. The flatter the light-emitting functional layer in each sub-pixel, the more color shift can be alleviated or avoided, and the better the display effect of the display substrate. In order to obtain a flat light-emitting functional layer, it can be achieved by adjusting the structure of the display substrate. The display substrate provided by the embodiment of the present disclosure can solve the color shift problem of the whole display substrate at the left and right viewing angles of 45 degrees and 60 degrees.

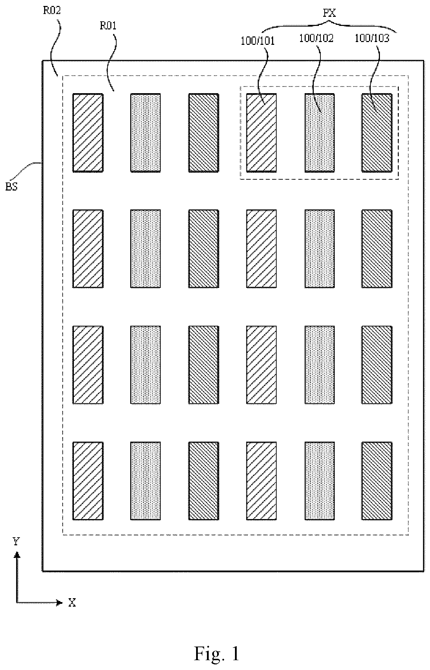

Fig. 1 is a schematic diagram of pixel arrangement of a display substrate. As shown in Fig. 1, the display substrate includes a plurality of sub-pixels 100 located on a base substrate, and a plurality of sub-pixels 100 are arranged in an array. As shown in Fig. 1, the plurality of sub-pixels 100 are arranged in an array in a first direction Y and a second direction X. The embodiment of the present disclosure is illustrated by taking the plurality of sub-pixels 100 arranged in an array shown in Fig. 1 as an example, but the arrangement manner of the plurality of sub-pixels 100 is not limited to that shown in Fig. 1.

As shown in Fig. 1, the display substrate includes a plurality of pixels PX, and each pixel PX includes multiple sub-pixels 100. As shown in Fig. 1, the multiple sub-pixels 100 include a first sub-pixel 101, a second sub-pixel 102, and a third sub-pixel 103. As shown in Fig. 1, each pixel PX includes one first sub-pixel 101, one second sub-pixel 102, and one third sub-pixel 103. The first sub-pixel 101, the second sub-pixel 102, and the third sub-pixel 103 have different light-emitting colors; the sub-pixels in the same column are sub-pixels emitting light of the same color; and in the same row, multiple pixels PX are arranged in sequence. The embodiment of the present disclosure is illustrated by taking that the first direction Y is the column direction and the second direction X is the row direction as an example. In some other embodiments, the first direction Y can be the row direction and the second direction X can be the column direction.

The embodiment of the present disclosure is illustrated by taking that the first sub-pixel 101 is a red sub-pixel, the second sub-pixel 102 is a green sub-pixel, and the third sub-pixel 103 is a blue sub-pixel as an example.

As shown in Fig. 1, the base substrate BS includes a display region R01 and a peripheral region R02 located on at least one side of the display region R01. Fig. 1 is illustrated by taking that the display region R01 is surrounded by the peripheral region R02 as an example.

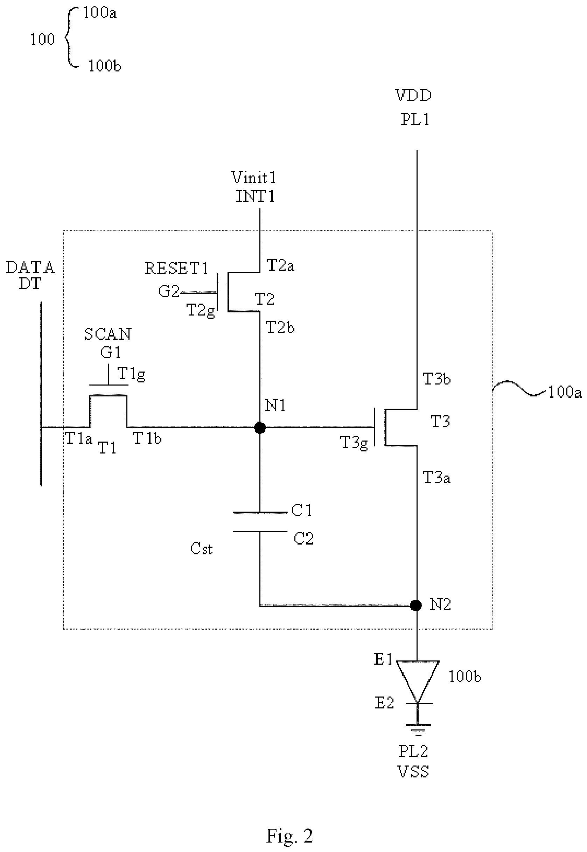

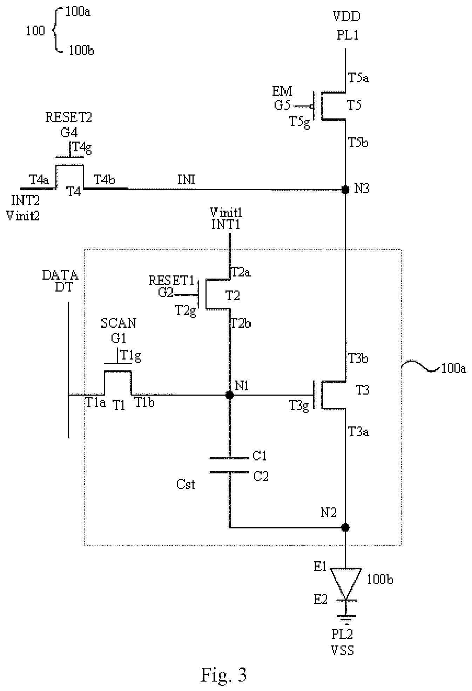

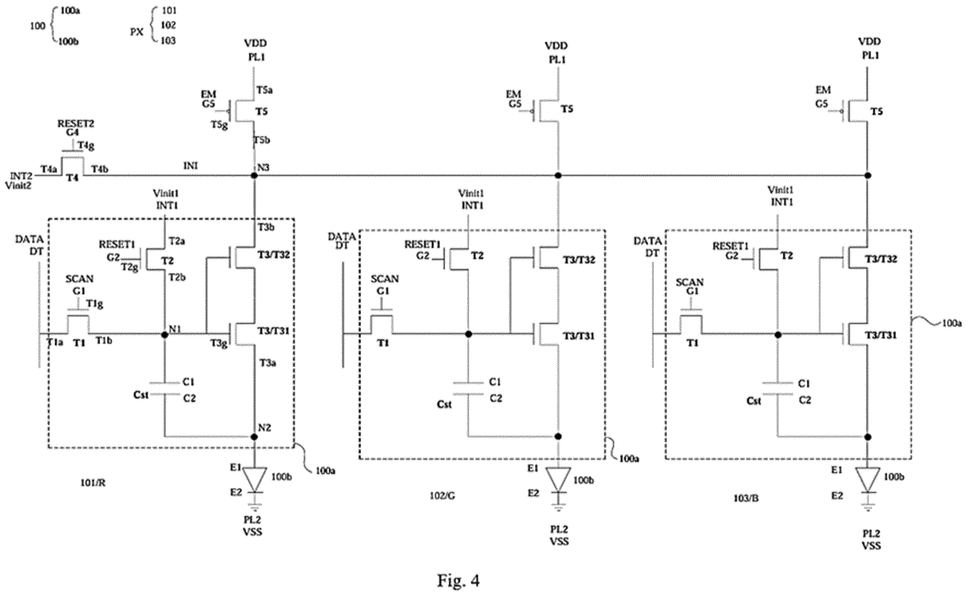

Fig. 2 is a schematic diagram of a pixel circuit, which drives a light-emitting element to emit light, in a display substrate provided by an embodiment of the present disclosure. Fig. 3 is a schematic circuit diagram of a display substrate provided by another embodiment of the present disclosure. Fig. 4 is a schematic circuit diagram of a display substrate provided by another embodiment of the present disclosure.

As shown in Fig. 2-Fig. 4, each sub-pixel 100 includes a pixel circuit 100a and a light-emitting element 100b, the pixel circuit 100a is electrically connected to the light-emitting element 100b, and the pixel circuit 100a is configured to drive the light-emitting element 100b. For example, the pixel circuit 100a is configured to drive the light-emitting element 100b to emit light. The light-emitting element 100b includes a light-emitting region. The pixel arrangement shown in Fig. 1 refers to the arrangement position of the light-emitting regions of the light-emitting elements 100b in the sub-pixels 100.

Fig. 2 and Fig. 3 include a pixel circuit and a light-emitting element in one sub-pixel. Fig. 4 shows three sub-pixels. The three sub-pixels in Fig. 4 are located in one row.

For example, as shown in Fig. 2-Fig. 4, in the sub-pixel 100, the pixel circuit 100a includes a data writing transistor T1, a reset transistor T2, a driving transistor T3, and a storage capacitor Cst, and the light-emitting element 100b is connected to the driving transistor T3. The reset transistor T2 is configured to reset the gate electrode T3g of the driving transistor T3. As shown in Fig. 2-Fig. 4, the storage capacitor Cst includes a first terminal C1 and a second terminal C2.

For example, as shown in Fig. 2-Fig. 4, the display substrate includes a gate line G1, a gate line G2, a data line DT, a first power line PL1, a second power line PL2, and an initialization line INT1, etc. The gate line G2 can also be referred to as a reset control signal line. For example, the first power line PL1 is configured to provide a constant first voltage signal VDD to the sub-pixel 100, the second power line PL2 is configured to provide a constant second voltage signal VSS to the sub-pixel 100, and the first voltage signal VDD is greater than the second voltage signal VSS. The gate line G1 is configured to provide a scan signal SCAN to the sub-pixel 100, the gate line G2 is configured to provide a reset control signal RESET1 to the sub-pixel 100, and the data line DT is configured to provide a data signal (data voltage) DATA to the sub-pixel 100. The initialization line INT1 is configured to provide an initialization signal Vinit1 to the sub-pixel 100.

As shown in Fig. 2-Fig. 4, the driving transistor T3 is electrically connected to the light-emitting element 100b, and outputs a driving current to drive the light-emitting element 100b to emit light under the control of the signals, such as the scan signal SCAN, the data signal DATA, the first voltage signal VDD, the second voltage signal VSS, etc.

For example, the light-emitting element 100b includes an organic light-emitting diode (OLED), and the light-emitting element 100b is driven by a corresponding pixel circuit 100a to emit red light, green light, blue light, or white light, etc.

For example, as shown in Fig. 2-Fig. 4, the first electrode E1 of the light-emitting element 100b is connected to the first electrode T3a of the driving transistor T3, the second electrode E2 of the light-emitting element 100b is connected to the second power line PL2, the second electrode T3b of the driving transistor T3 is connected to the first power line PL1, the gate electrode T3g of the driving transistor T3 is connected to the second electrode T1b of the data writing transistor T1, the first electrode T1a of the data writing transistor T1 is connected to the data line DT, and the gate electrode T1g of the data writing transistor T1 is connected to the gate line G1.

For example, as shown in Fig. 2-Fig. 4, the gate electrode T3g of the driving transistor T3 is connected to the first terminal C1 of the storage capacitor Cst, and the second terminal C2 of the storage capacitor Cst is connected to the first electrode T3a of the driving transistor T3. The first terminal C1 of the storage capacitor Cst is also connected to the second electrode T1b of the data writing transistor T1.

For example, as shown in Fig. 2-Fig. 4, the first electrode T2a of the reset transistor T2 is connected to the initialization line INT1, the second electrode T2b of the reset transistor T2 is connected to the gate electrode T3g of the driving transistor T3, and the gate electrode T2g of the reset transistor T2 is connected to the gate line G2. The first terminal C1 of the storage capacitor Cst is also connected to the second electrode T2b of the reset transistor T2.

For example, as shown in Fig. 2-Fig. 4, the gate electrode T3g of the driving transistor T3, the first terminal C1 of the storage capacitor Cst, the second electrode T1b of the data writing transistor T1, and the second electrode T2b of the reset transistor T2 are connected to each other, all of which are connected to a node N1 and have the same potential.

For example, as shown in Fig. 2-Fig. 4, the second terminal C2 of the storage capacitor Cst, the first electrode E1 of the light-emitting element 100b, and the first electrode T3a of the driving transistor T3 are connected to each other, all of which are connected to a node N2 and have the same potential.

For example, as shown in Fig. 3 and Fig. 4, the display substrate further includes a reset transistor T4, and the reset transistor T4 is configured to reset the first electrode E1 of the light-emitting element 100b.

For example, as shown in Fig. 3 and Fig. 4, the display substrate further includes a gate line G4, and the gate line G4 can also be referred to as a reset control signal line. The gate line G4 is configured to provide a reset control signal RESET2 to the reset transistor T4.

For example, as shown in Fig. 3 and Fig. 4, the display substrate further includes an initialization line INT2, and the initialization line INT2 is configured to provide an initialization signal Vinit2 to the reset transistor T4.

For example, as shown in Fig. 3 and Fig. 4, the first electrode T4a of the reset transistor T4 is connected to the initialization line INT2, the second electrode T4b of the reset transistor T4 is connected to the first electrode E1 of the light-emitting element 100b, and the gate electrode T4g of the reset transistor T4 is connected to the gate line G4.

For example, as shown in Fig. 3 and Fig. 4, the second electrode T4b of the reset transistor T4 is connected to the first electrode E1 of the light-emitting element 100b through the driving transistor T3, the first electrode T3a of the driving transistor T3 is connected to the first electrode E1 of the light-emitting element 100b, and the second electrode T3b of the driving transistor T3 is connected to the second electrode T4b of the reset transistor T4.

For example, the initialization signal Vinit1 and the initialization signal Vinit2 are constant voltage signals, which can be, for example, between the first voltage signal VDD and the second voltage signal VSS, but are not limited thereto. For example, the initialization signal Vinit1 and the initialization signal Vinit2 can both be less than or equal to the second voltage signal VSS.

For example, in some embodiments of the present disclosure, the initialization line INT1 and the initialization line INT2 are connected and are both configured to provide the same initialization signal, that is, the initialization signal Vinit1 and the initialization signal Vinit2 are equal, but are not limited thereto. In some other embodiments, the initialization line INT1 and the initialization line INT2 are insulated from each other to provide different initialization signals.

For example, as shown in Fig. 2, the second electrode T3b of the driving transistor T3 is directly connected to the first power line PL1. As shown in Fig. 3 and Fig. 4, the display substrate further includes a gate line G5 and a light-emitting control transistor T5, the gate line G5 is configured to provide a light-emitting control signal EM to the light-emitting control transistor T5, and the second electrode T3b of the driving transistor T3 is connected to the first power line PL1 through the light-emitting control transistor T5.

For example, as shown in Fig. 3 and Fig. 4, the first electrode T5a of the light-emitting control transistor T5 is connected to the first power line PL1, the second electrode T5b of the light-emitting control transistor T5 is connected to the second electrode T3b of the driving transistor T3, and the gate electrode T5g of the light-emitting control transistor T5 is connected to the gate line G5.

For example, as shown in Fig. 3 and Fig. 4, the second electrode T5b of the light-emitting control transistor T5, the second electrode T4b of the reset transistor T4, and the second electrode T3b of the driving transistor T3 are connected to each other, all of which are connected to a node N3 and have the same potential.

For example, as shown in Fig. 4, the plurality of sub-pixels 100 include a first sub-pixel 101, a second sub-pixel 102, and a third sub-pixel 103. For example, the first sub-pixel 101, the second sub-pixel 102, and the third sub-pixel 103 are sequentially arranged in the second direction X. Of course, the sub-pixels in one pixel can also be arranged in other ways.

For example, as shown in Fig. 4, the driving transistor T3 is a dual-gate transistor, which includes a sub-transistor T31 and a sub-transistor T32. As shown in Fig. 4, the sub-transistor T31 and the sub-transistor T32 are connected in series. Fig. 4 is illustrated by taking that the driving transistor T3 is a dual-gate transistor as an example. In some other embodiments, besides the driving transistor T3, other transistors can also be set as dual-gate transistors. That is, each transistor in the pixel circuit can be set as a single-gate transistor or a dual-gate transistor as needed.

For example, as shown in Fig. 3 and Fig. 4, the display substrate includes a reset signal transmission line INI, and the second electrode T4b of the reset transistor T4 is connected to the second electrode T3b (node N3) of the driving transistor through the reset signal transmission line INI.

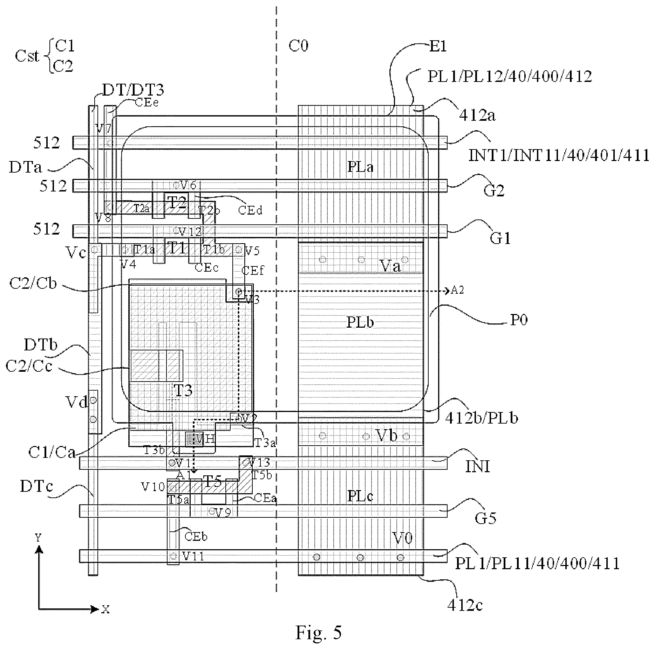

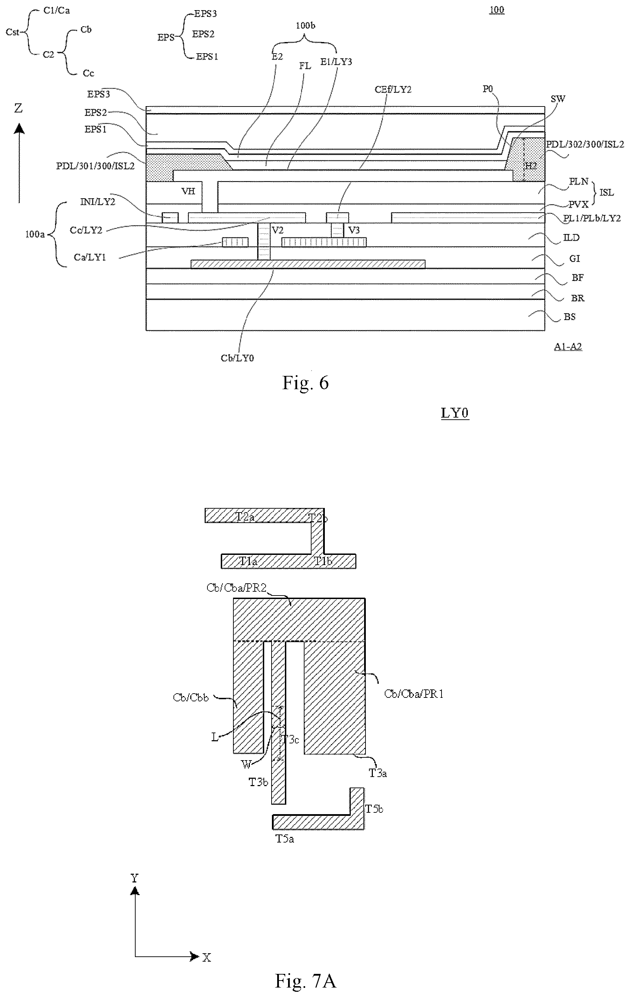

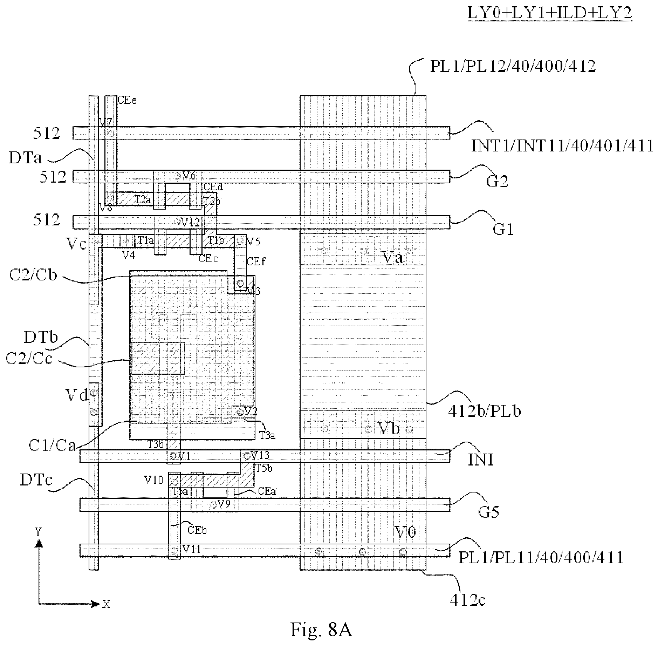

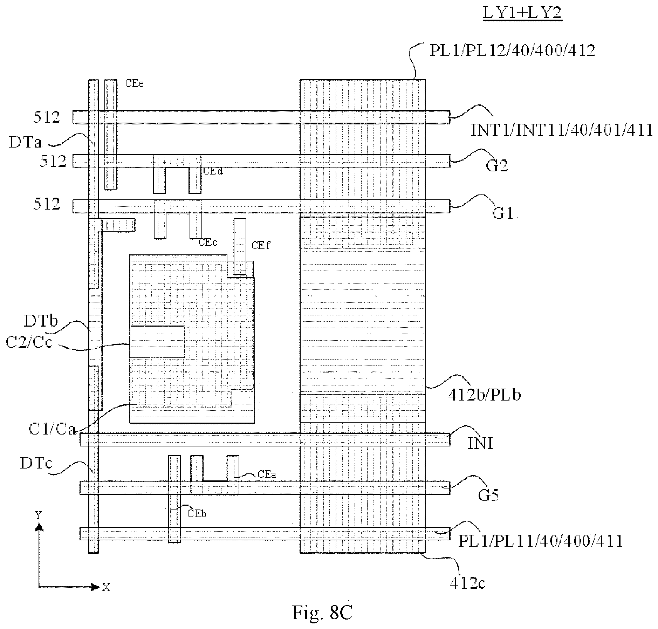

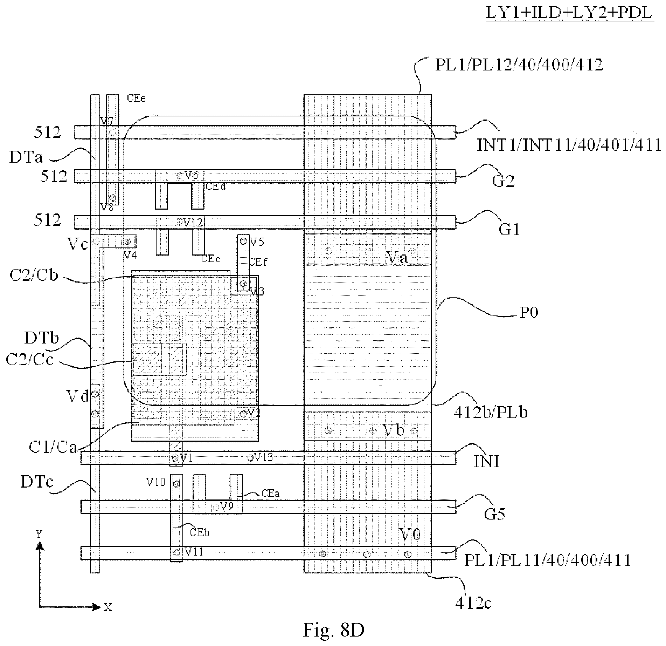

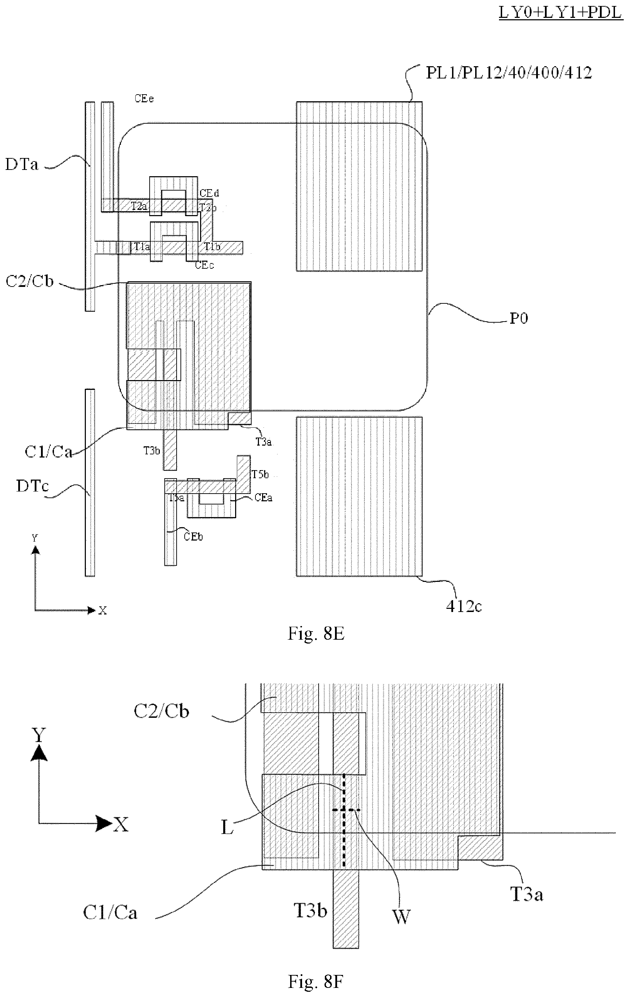

Fig. 5 is a layout diagram of a display substrate provided by an embodiment of the present disclosure. Fig. 6 is a cross-sectional view taken along line A1-A2 of Fig. 5. Fig. 7A-Fig. 7G1 are plan views of a single layer of the display substrate in Fig. 5. Fig. 8A-Fig. 8E are plan views of part of stacked layers of the display substrate in Fig. 5. Fig. 8F is a schematic diagram of a width and length of a channel of a driving transistor in the display substrate of Fig. 5.

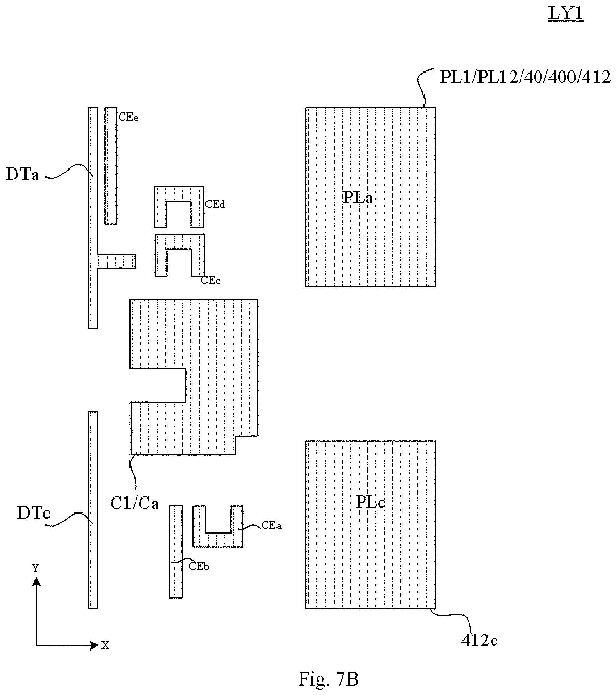

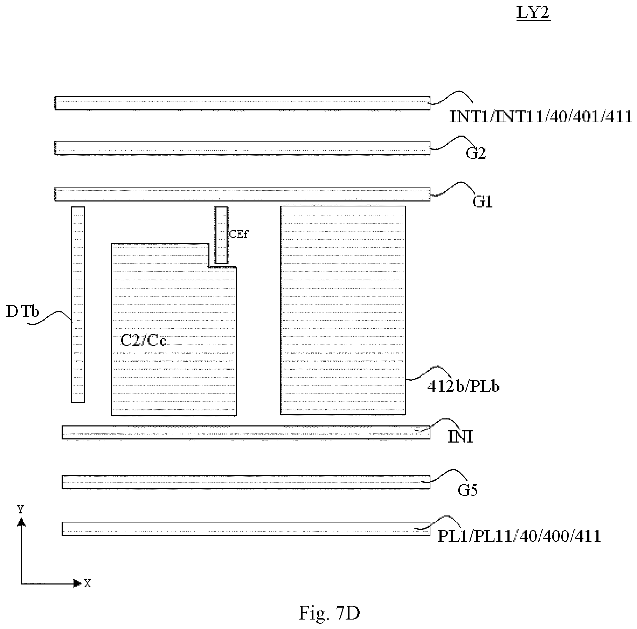

For example, as shown in Fig. 6, the display substrate includes a base substrate BS, and a barrier layer BR and a buffer layer BF which are located on the base substrate BS. As shown in Fig. 6, the buffer layer BF is provided thereon with an active layer LY0 and a gate insulating layer GI located on the active layer LY0, a first conductive pattern layer LY1 is located on the gate insulating layer GI, an interlayer insulating layer ILD is located on the first conductive pattern layer LY1, a second conductive pattern layer LY2 is located on the interlayer insulating layer ILD, an insulating layer ISL is located on the second conductive pattern layer LY2, and a first electrode layer LY3 is located on the insulating layer ISL. Fig. 5 and Fig. 6 show a first terminal C1 and a second terminal C2 of the storage capacitor Cst. The first terminal C1 includes a first electrode plate Ca (as shown in Fig. 7B), and the second terminal C2 includes a second electrode plate Cb (as shown in Fig. 7A) and a third electrode plate Cc (as shown in Fig. 7D).

For example, as shown in Fig. 6, the first conductive pattern layer LY1 is closer to the base substrate BS than the second conductive pattern layer LY2.

For example, as shown in Fig. 5 and Fig. 6, the display substrate provided by an embodiment of the present disclosure includes: a base substrate BS and sub-pixels 100 disposed on the base substrate BS. A plurality of sub-pixels 100 can be provided.

For example, as shown in Fig. 5 and Fig. 6, the display substrate further includes a pixel defining layer PDL, the sub-pixel 100 includes a pixel opening P0, the pixel opening P0 is configured to expose at least a part of the first electrode E1, and the pixel opening P0 is configured to define a light-emitting region of the sub-pixel 100. For example, as shown in Fig. 6, the slope angle of the portion of the pixel defining layer PDL that defines the pixel opening P0 is in the range of 40-65 degrees.

For example, as shown in Fig. 5 and Fig. 6, the sub-pixel 100 includes a pixel circuit 100a and a light-emitting element 100b, the pixel circuit 100a includes the storage capacitor Cst, the second electrode plate Cb is closer to the base substrate BS than the first electrode plate Ca, and the first electrode plate Ca is closer to the base substrate BS than the third electrode plate Cc; the light-emitting element 100b includes a first electrode E1, a second electrode E2, and a light-emitting functional layer FL located between the first electrode E1 and the second electrode E2, and the pixel circuit 100a is configured to drive the light-emitting element 100b.

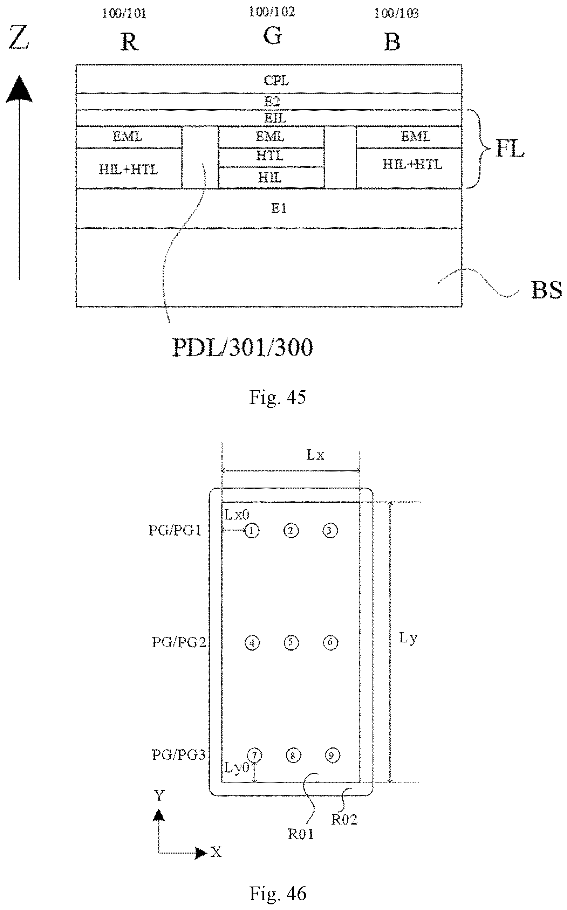

For example, in Fig. 6, each film layer of the light-emitting functional layer FL is formed by inkjet printing, that is, each film layer of the light-emitting functional layer FL is provided in the pixel opening P0. However, in some other implementations, some film layers in the light-emitting functional layer FL can be formed by inkjet printing, and some other film layers in the light-emitting functional layer FL can be formed by evaporation, and the film layers formed by evaporation can be common layers; and an embodiment of this situation can refer to Fig. 45.

In some accompanying drawings of the embodiments of the present disclosure, a plan view shows a first direction Y and a second direction X, and a cross-sectional view shows a third direction Z. Both the first direction Y and the second direction X are parallel to a main surface of the base substrate BS. The third direction Z is a direction perpendicular to the main surface of the base substrate BS. For example, the first direction Y and the second direction X are intersected. The embodiment of the present disclosure is illustrated by taking that the first direction Y is perpendicular to the second direction X as an example. As shown in Fig. 6, the main surface of the base substrate BS is a surface of the base substrate BS for manufacturing various elements. As shown in Fig. 6, the upper surface of the base substrate BS is the main surface of the base substrate BS.

For example, as shown in Fig. 5, Fig. 7B and Fig. 7D, the first power line PL1 includes a first power signal line PL11 extending in the second direction X and a first power connection line PL12 extending in the first direction Y, and the first power signal line PL11 is connected to the first power connection line PL12.

For example, as shown in Fig. 5, Fig. 7B and Fig. 7D, the data line DT extends in the first direction Y and the data line DT is formed in segments. The data line DT includes a first part DTa, a second part DTb, and a third part DTc; the first part DTa and the third part DTc are connected through the second part DTb; the first part DTa and the third part DTc are located in the first conductive pattern layer LY1, and the second part DTb is located in the second conductive pattern layer LY2.

In the embodiment of the present disclosure, elements located in the second conductive pattern layer LY2 can be connected to elements located in the first conductive pattern layer LY1 and elements located in the active layer LY0 through via holes, and elements located in the first conductive pattern layer LY1 and elements located in the active layer LY0 can be connected through elements located in the second conductive pattern layer LY2.

For example, insulating layers penetrated by a via hole can depend on the insulating layers between two conductive pattern layers connected through the via hole.

As shown in Fig. 5, Fig. 7B and Fig. 7D, in the display substrate provided by some embodiments of the present disclosure, the active layer LY0, the first conductive pattern layer LY1, and the second conductive pattern layer LY2 are used to form a pixel circuit 100a, so as to simplify the manufacturing process and reduce the thickness of the display substrate. The initialization line INT1 and/or the first power line PL1 can be referred to as conductive structures 40; the conductive structure 40 includes a signal transmission line 411 and a signal connection line 412, the conductive structure 40 is configured to provide a voltage signal to the sub-pixel 100, the signal transmission line 411 extends in the second direction X, the signal connection line 412 extends in the first direction Y, and the signal connection line 412 is electrically connected to the signal transmission line 411.

As shown in Fig. 5, the conductive structure 40 includes a conductive structure 400 and a conductive structure 401. As shown in Fig. 5, the first power line PL1 can be referred to as the conductive structure 400, and the initialization line INT1 can be referred to as the conductive structure 401.

For example, as shown in Fig. 5, the conductive structure 40 adopts a mesh structure, and includes a part extending in the first direction Y (i.e., signal connection line 412) and a part extending in the second direction X (i.e., signal transmission line 411), respectively.

For example, as shown in Fig. 5, Fig. 7B and Fig. 7D, the first power line PL1 of the pixel circuit 100a is formed by using two conductive pattern layers. As shown in Fig. 5, Fig. 7B and Fig. 7D, parts of the first power line PL1 extending in the first direction Y are all formed in segments. As shown in Fig. 5 and Fig. 7D, parts of the first power line PL1 extending in the second direction X are all located in the second conductive pattern layer LY2.

For example, as shown in Fig. 5, Fig. 7B and Fig. 7D, the signal connection line 412 includes a first part 412a, a second part 412b, and a third part 412c; the first part 412a and the third part 412c are connected through the second part 412b, the first part 412a and the third part 412c are located in the first conductive pattern layer LY1, and the second part 412b is located in the second conductive pattern layer LY2. The signal connection line 412 includes a first power connection line PL12.

For example, as shown in Fig. 5, a first part PLa and a second part PLb of the first power connection line PL12 are connected through a via hole Va, and the second part PLb and a third part PLc of the first power connection line PL12 are connected through a via hole Vb.

For example, as shown in Fig. 5, the first power signal line PL11 and the first power connection line PL12 are connected through a via hole V0.

For example, as shown in Fig. 5, the first part DTa and the second part DTb of the data line DT are connected through a via hole Vc, and the second part DTb and the third part DTc of the data line DT are connected through a via hole Vd.

Fig. 7A shows an active layer L0. The active layer LY0 includes polysilicon, but is not limited thereto.

Fig. 7B shows a first conductive pattern layer LY1. As shown in Fig. 7B, the first conductive pattern layer LY1 includes a first terminal C1 (first electrode plate Ca), a connection electrode CEa, a connection electrode CEb, a connection electrode CEc, a connection electrode CEd, a connection electrode CEe, a first part DTa of the data line DT, a third part DTc of the data line DT, a first part PLa of the first power connection line PL12, and a third part PLc of the first power connection line PL12.

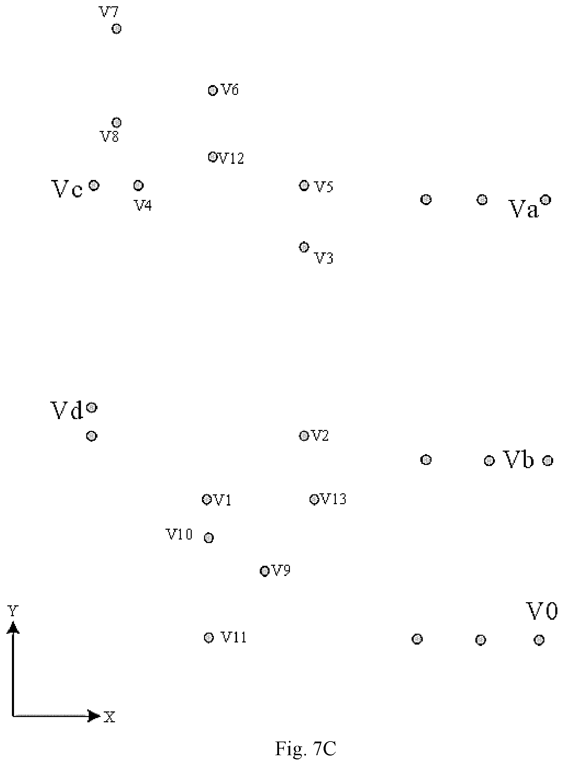

Fig. 7C shows an interlayer insulating layer ILD, which is represented by via holes in the interlayer insulating layer ILD. Fig. 7C shows via holes V1-V13, via holes Va-Vd, and a via hole V0.

Fig. 7D shows a second conductive pattern layer LY2. As shown in Fig. 7D, the second conductive pattern layer LY2 includes a third electrode plate Cc of the second terminal C2, a connection electrode CEf, a gate line G1, a gate line G2, a gate line G5, a reset signal transmission line INI, an initialization signal line INT11, and a first power signal line PL11.

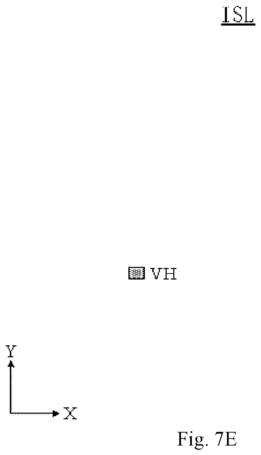

Fig. 7E shows an insulating layer ISL, which is represented by via holes in the insulating layer ISL. Fig. 7E shows a via hole VH.

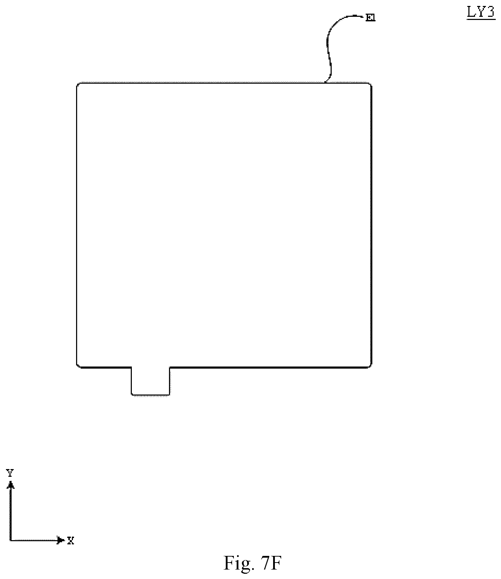

Fig. 7F shows a first electrode layer LY3 of the light-emitting element. Fig. 7F shows a first electrode E1.

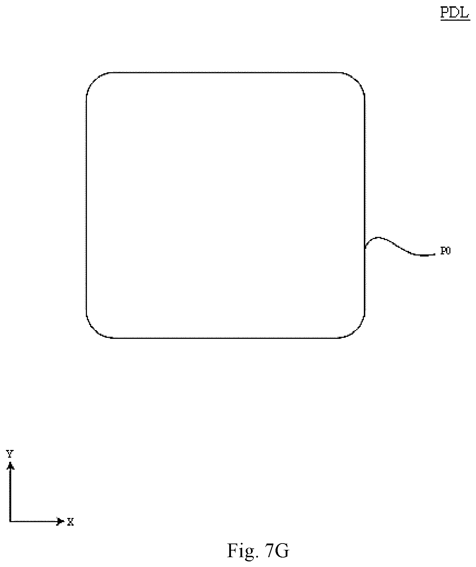

Fig. 7G shows a pixel defining layer PDL, which is represented by a pixel opening P0 in the pixel defining layer PDL. The pixel opening P0 corresponds to an effective light-emitting region of the sub-pixel. In the case where at least one film layer of the light-emitting functional layer FL in the display substrate is manufactured by inkjet printing process, the film layer manufactured by inkjet printing is located in the pixel opening P0 of the pixel defining layer PDL.

Referring to Fig. 5-Fig. 8E, the first power signal line PL11 and the first power connection line PL12 are connected through the via hole V0.

Referring to Fig. 5-Fig. 8E, the connection electrode CEa is connected to the gate line G5 through the via hole V9, and the connection electrode CEa serves as the gate electrode of the light-emitting control transistor T5.

Referring to Fig. 5-Fig. 8E, one end of the connection electrode CEb is connected to the first power line PL1 (first power signal line PL11) through the via hole V11, and the other end of the connection electrode CEb is connected to the first electrode T5a of the light-emitting control transistor T5 through the via hole V10.

Referring to Fig. 5-Fig. 8E, the connection electrode CEc is connected to the gate line G1 through the via hole V12, and the connection electrode CEc serves as the gate electrode of the data writing transistor T1.

Referring to Fig. 5-Fig. 8E, the data line DT is connected to the first electrode T1a of the data writing transistor T1 through the via hole V4.

Referring to Fig. 5-Fig. 8E, the connection electrode CEd is connected to the gate line G2 through the via hole V6, and the connection electrode CEd serves as the gate electrode of the reset transistor T2.

Referring to Fig. 5-Fig. 8E, one end of the connection electrode CEe is connected to the initialization line INT1 (initialization signal line INT11) through the via hole V7, and the other end of the connection electrode CEe is connected to the first electrode T2a of the reset transistor T2 through the via hole V8.

Referring to Fig. 5-Fig. 8E, one end of the connection electrode CEf is connected to the first terminal C1 (first electrode plate Ca, gate electrode of the driving transistor T3) through the via hole V3, and the other end of the connection electrode CEf is connected to the second electrode T1b of the data writing transistor T1 (i.e., second electrode T2b of the reset transistor T2) through the via hole V5.

Referring to Fig. 5-Fig. 8E, the third electrode plate Cc of the second terminal C2 is connected to the second electrode plate Cb of the second terminal C2 (i.e., first electrode T3a of the driving transistor T3) through the via hole V2.

Referring to Fig. 5-Fig. 8E, the reset signal transmission line INI is connected to the first electrode T3a of the driving transistor T3 through the via hole V1, and the reset signal transmission line INI is connected to the second electrode T5b of the light-emitting control transistor T5 through the via hole V13.

Referring to Fig. 5-Fig. 8E, the second electrode T5b of the light-emitting control transistor T5 and the second electrode T3b of the driving transistor T3 are connected through the reset signal transmission line INI.

As shown in Fig. 7A, a first plate-shaped portion Cba and a second plate-shaped portion Cbb can both be connected to the channel T3c of the driving transistor T3, and the first plate-shaped portion Cba, the second plate-shaped portion Cbb, and the channel T3c of the driving transistor T3 are located in the same layer. For example, the first plate-shaped portion Cba, the second plate-shaped portion Cbb, and the channel T3c of the driving transistor T3 are of an integral structure.

In the display substrate provided by the embodiment of the present disclosure, by the pattern design of the active layer L0 matching the pattern design of the channel of the driving transistor and the capacitor electrode plate located in the active layer, the balance relationship between luminescent uniformity and power consumption is optimized, the luminescent uniformity of the display substrate is improved, and the power consumption is reduced.

As shown in Fig. 7A, the first plate-shaped portion Cba includes a first part PR1 and a second part PR2, the first part PR1 extends in the first direction Y, the second part PR2 extends in the second direction X, and the first part PR1 and the second plate-shaped portion Cbb are opposite to each other and are respectively arranged at both sides of the channel T3c of the driving transistor T3 in the second direction X. In Fig. 7A, the first part PR1, the second part PR2, and the second plate-shaped portion Cbb are divided by dashed lines.

For example, referring to Fig. 5, Fig. 7A, Fig. 8B and Fig. 8E, the second electrode plate Cb and the channel of the driving transistor T3 are of an integral structure and can be formed by the same thin film through the same patterning process. The material of the channel of the driving transistor T3 is a semiconductor material, and the second electrode plate Cb is a conductor obtained by doping on the semiconductor material.

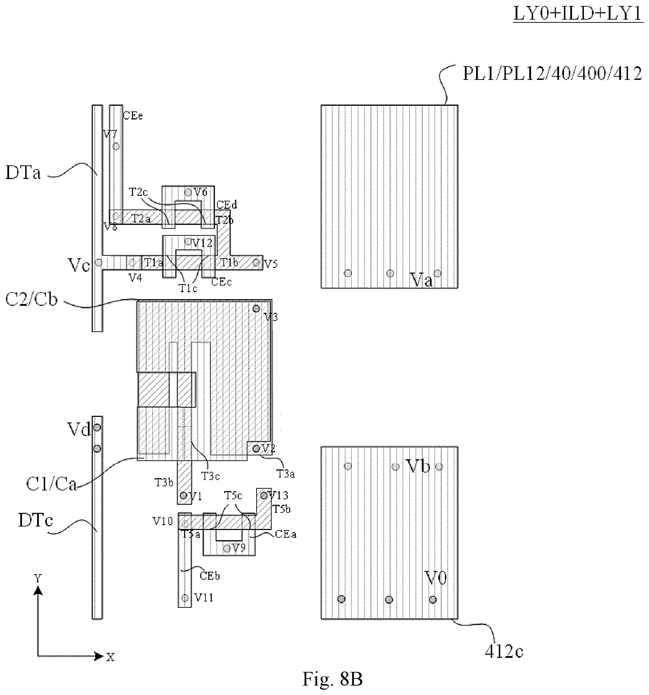

Fig. 8B shows a channel T1c of the data writing transistor T1, a channel T2c of the reset transistor T2, a channel T3c of the driving transistor T3, and a channel T5c of the light-emitting control transistor T5.

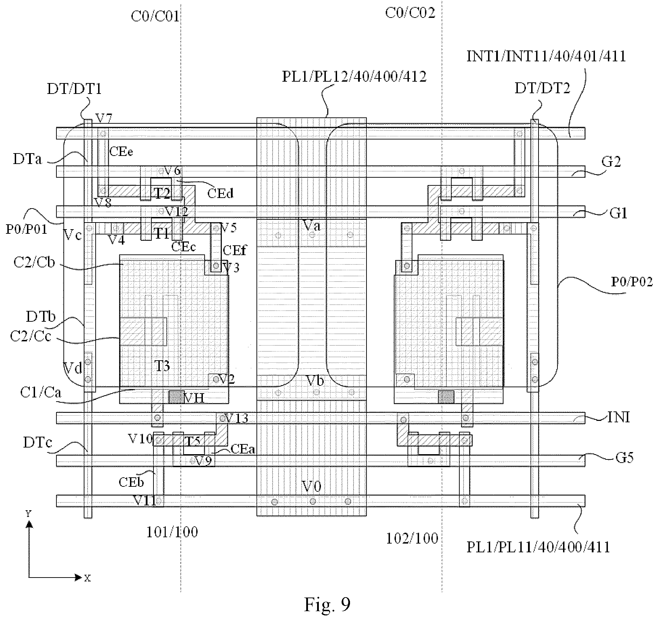

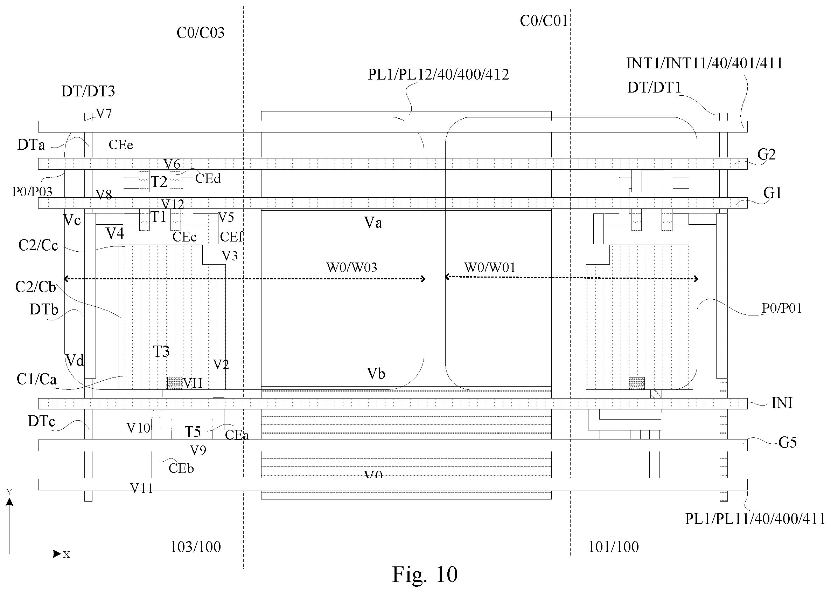

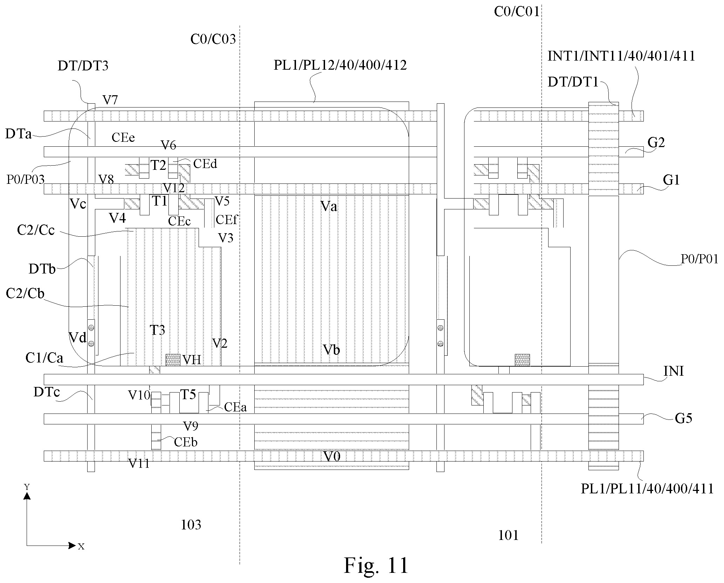

Fig. 9 is a layout diagram of a display substrate provided by an embodiment of the present disclosure. Fig. 10 is a layout diagram of a display substrate provided by another embodiment of the present disclosure. Fig. 11 is a layout diagram of a display substrate provided by another embodiment of the present disclosure.

Fig. 9 shows two sub-pixels 100: a first sub-pixel 101 and a second sub-pixel 102. As shown in Fig. 9, the first sub-pixel 101 and the second sub-pixel 102 are adjacent to each other and arranged in sequence in the second direction X. As shown in Fig. 9, the layout of the pixel circuit of the first sub-pixel 101 and the layout of the pixel circuit of the second sub-pixel 102 are arranged in a mirror symmetry manner. As shown in Fig. 9, the pixel circuit of the first sub-pixel 101 and the pixel circuit of the second sub-pixel 102 are axisymmetric, and are axisymmetric with respect to a straight line extending in the first direction Y.

As shown in Fig. 9, the pixel opening P0 (pixel opening P01) of the first sub-pixel 101 and the pixel opening P0 (pixel opening P02) of the second sub-pixel 102 overlap with the first power line PL1 (first power connection line PL12), respectively. That is, the orthographic projection of the pixel opening P01 on the base substrate overlaps with the orthographic projection of the first power line PL1 (first power connection line PL12) on the base substrate, and the orthographic projection of the pixel opening P02 on the base substrate overlaps with the orthographic projection of the first power line PL1 (first power connection line PL12) on the base substrate. The part of the first power line PL1 (first power connection line PL12) directly below the opening P0 can play the role of leveling, which further improves the flatness of the light-emitting layer to alleviate the color shift, and for example, to alleviate the color shift at the left and right viewing angles, and further improve the display quality. That is, the central axis of the third electrode plate Cc of the storage capacitor in the first direction Y is closer to the central axis C0 of the pixel opening P0 extending in the first direction Y, and the positions of the pixel opening P0 at both sides of the third electrode plate Cc are leveled with signal lines. Of course, the adjacent sub-pixels in Fig. 9 are not limited to the first sub-pixel 101 and the second sub-pixel 102, and can be in other forms, for example, the second sub-pixel 102 and the third sub-pixel 103 adjacent to each other, or the first sub-pixel 101 and the third sub-pixel 103 adjacent to each other. In Fig. 9, the two adjacent sub-pixels respectively overlap with the first power connection line PL12, and the embodiment of the present disclosure includes but is not limited to this case. For example, in some embodiments, one of two adjacent sub-pixels may overlap with the first power connection line PL12, and the other of the two adjacent sub-pixels may not overlap with the first power connection line PL12.

As shown in Fig. 10, the third electrode plate Cc and the first power connection line PL12 are respectively arranged at both sides of the central axis C0. In the display substrate shown in Fig. 10, the proportion of the first power line PL1 (first power connection line PL12) in the width direction (second direction X) of the pixel opening is larger, that is, the leveling size of the first power connection line PL12 in the width direction of the pixel opening is larger, so that the third electrode plate Cc and the first power connection line PL12, which are located at both sides of the central axis C0, play a leveling role together, so as to improve the flatness of the light-emitting layer and alleviate color shift, for example, alleviate color shift at the left and right viewing angels. Fig. 10 shows that the third sub-pixel 103 and the first sub-pixel 101 are adjacent to each other and arranged in sequence in the second direction X.

As shown in Fig. 10, the maximum size WO of the pixel opening P03 of the third sub-pixel 103 in the second direction X is different from the maximum size WO of the pixel opening P01 of the first sub-pixel 101 in the second direction X. Accordingly, the overlapping area between the first power connection line PL12 and the pixel opening P03 of the third sub-pixel 103 is different from the overlapping area between the first power connection line PL12 and the pixel opening P01 of the first sub-pixel 101. For example, the ratio of the overlapping area between the first power connection line PL12 and the pixel opening P03 of the third sub-pixel 103 to the area of the pixel opening P03 of the third sub-pixel 103 is equal to or approximately equal to the ratio of the overlapping area between the first power connection line PL12 and the pixel opening P01 of the first sub-pixel 101 to the area of the pixel opening P01 of the first sub-pixel 101.

As shown in Fig. 10, the maximum size WO of the pixel opening P03 of the third sub-pixel 103 in the second direction X is greater than the maximum size WO of the pixel opening P01 of the first sub-pixel 101 in the second direction X. Accordingly, the overlapping area between the first power connection line PL12 and the pixel opening P03 of the third sub-pixel 103 is greater than the overlapping area between the first power connection line PL12 and the pixel opening P01 of the first sub-pixel 101.

As shown in Fig. 10, the overlapping size between the first power connection line PL12 and the pixel opening P03 of the third sub-pixel 103 in the second direction X is greater than the overlapping size between the first power connection line PL12 and the pixel opening P01 of the first sub-pixel 101 in the second direction X.

Fig. 10 shows the maximum size WO3 of the pixel opening P03 of the third sub-pixel 103 in the second direction X and the maximum size WO1 of the pixel opening P01 of the first sub-pixel 101 in the second direction X.

Fig. 11 shows that one of the pixel openings P0 of two adjacent sub-pixels 100 overlaps with the first power connection line PL12, while the other of the pixel openings P0 of two adjacent sub-pixels 100 does not overlap with the first power connection line PL12. That is, the first power connection line PL12 plays a role of leveling one of the adjacent sub-pixels. For example, the first power connection line PL12 plays a role of leveling at least one of the adjacent sub-pixels.

Referring to Fig. 3- Fig. 11, the embodiment of the present disclosure provides a display substrate, which includes a base substrate BS and a plurality of sub-pixels 100 disposed on the base substrate BS. The sub-pixel 100 includes a pixel circuit 100a and a light-emitting element 100b. The pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode T3g of the driving transistor T3, and the second electrode plate Cb of the storage capacitor Cst is connected to the first electrode T3a of the driving transistor T3; the light-emitting element 100b is electrically connected to the pixel circuit 100a, the pixel circuit 100a is configured to drive the light-emitting element 100b, the sub-pixel 100 includes a pixel opening P0, and the pixel opening P0 is configured to define a light-emitting region of the sub-pixel 100.

As shown in Fig. 5, the orthographic projection of the storage capacitor Cst on the base substrate BS overlaps with the orthographic projection of the pixel opening P0 on the base substrate BS.

Referring to Fig. 5, Fig. 8E, Fig. 8F and Fig. 9-Fig. 11, the orthographic projection of the channel T3c of the driving transistor T3 on the base substrate BS overlaps with the orthographic projection of the pixel opening P0 on the base substrate BS. In Fig. 8E and Fig. 8F, the part of the active layer L0 at the dashed cross is a semiconductor, such as polysilicon, and the rest is a conductor, such as doped polysilicon. In the embodiment of the present disclosure, a semiconductor can be formed into a conductor through a doping process. For example, the doping process can be performed before forming the first conductive pattern layer LY1, but it is not limited thereto.

As shown in Fig. 5, Fig. 6, Fig. 7A, Fig. 7B, Fig. 8A, Fig. 8B, Fig. 8E and Fig. 9-Fig. 11, the second electrode plate Cb is arranged in the same layer as the channel T3c (as shown in Fig. 7A and Fig. 8E) of the driving transistor T3, the second electrode plate Cb is closer to the base substrate BS than the first electrode plate Ca, and the orthographic projection of the second electrode plate Cb on the base substrate BS overlaps with the orthographic projection of the pixel opening P0 on the base substrate BS.

For example, the display substrate satisfies the following relationship: the value range of (W*L+S2)*M1/M2 is [0.014, 0.133], and the value range of S2/(W*L) is [2.82, 28.85].

As shown in Fig. 7A, Fig. 8E and Fig. 8F, W is the width of the channel T3c of the driving transistor T3, and L is the length of the channel T3c of the driving transistor T3. As shown in Fig. 5, Fig. 6 and Fig. 9-Fig. 11, S2 is the facing area between the second electrode plate Cb and the first electrode plate Ca, M1 is the number (a count) of pixel openings P0 in the display substrate, and M2 is the area of the display substrate. For example, M2 is the total area of the display substrate in a plan view. For example, M2 is the sum of the area of the display region R01 and the area of the peripheral region R02.

In the display substrate provided by the embodiment of the present disclosure, the region where the storage capacitor is located is utilized to the maximum extent. The larger the area of the pixel opening, the greater the proportion of the region where the storage capacitor is located. Accordingly, the smaller the area of the pixel opening, the smaller the proportion of the region where the storage capacitor is located. The high-resolution display substrate needs to maximize the use of the region where the storage capacitor is located. A display substrate that satisfies the above value ranges, that is, a display substrate satisfying that the value range of (W*L+S2)*M1/M2 is [0.014, 0.133] and the value range of S2/(W*L) is [2.82, 28.85], can increase the facing area between the electrode plates of the storage capacitor, increase the capacitance, and improve the holding capacity of the capacitor, and is beneficial to increasing the area ratio of the storage capacitor to the pixel opening, increasing the area proportion of the storage capacitor, and improving the display quality.

Of course, in some other embodiments, the value range of S2/(W*L) may not be limited, as long as the value range of (W*L+S2)*M1/M2 is [0.014, 0.133]. In this case, it can also increase the facing area between the electrode plates of the storage capacitor, increase the capacitance, and improve the holding capacity of the capacitor, and is beneficial to increasing the area ratio of the storage capacitor to the pixel opening, increasing the area proportion of the storage capacitor, and improving the display quality.

For example, the value range of (W*L+S2)*M1/M2 can be [0.02, 0.1].

Further, for example, the value range of (W*L+S2)*M1/M2 can be [0.02, 0.05].

Further, for example, the value range of (W*L+S2)*M1/M2 can be [0.03, 0.05].

For example, the value range of S2/(W*L) can be [5, 28].

Further, for example, the value range of S2/(W*L) can be [6, 27.5].

Further, for example, the value range of S2/(W*L) can be [7, 27.5].

For example, in some embodiments, the display substrate can be a 27-inch product, and W=1.5-4 microns, and for example, W can be 2.5 microns, 2.6 microns, or 2.7 microns; L=10-20 microns, and for example, L can be 13 microns, 14 microns, or 15 microns; M1 is the number (a count) of pixel openings (multiplying the resolution, 4K): 3840*2160=8294400; for example, M2 ranges from 1900 square centimeters to 2100 square centimeters, and for example, M2=59.8*33.6=2009.28 square centimeters; for example, S2=900-1200 square microns, and for example, S2 can be 1020 square microns, 1030 square microns, or 1040 square microns.

For example, for a 27-inch product, W=2.5 microns, L=15 microns, M1=8294400, M2=2009.28 square centimeters, S2=1030 square microns, and the value of (W*L+S2)*M1/M2 is 0.04, and the value of S2/(W*L) is 27.4. During calculation, the units should be unified, and for example, square centimeters can be converted into square microns.

For example, in some embodiments, the display substrate can be a 65-inch product, and W=1.5-4 microns, and for example, W can be 2.5 microns, 2.6 microns, or 2.7 microns; L=20-30 microns, and for example, L can be 23 microns, 24 microns, or 25 microns; M1 is the number (a count) of pixel openings (multiplying the resolution, 8K): 7680*4320=33177600, and M2 ranges from 11600 square centimeters to 11700 square centimeters, and for example, M2=143.9*80.94=11647.27 square centimeters; for example, S2=900-1200 square microns, and for example, S2 can be 1020 square microns, 1030 square microns, or 1040 square microns.

For example, for a 65-inch product, W=2.7 microns; L=25 microns; M1=7680*4320=33177600, M2=143.9*80.94=11647.27 square centimeters; S2=1200 square microns, the value of (W*L+S2)*M1/M2 is 0.036, and the value of S2/(W*L) is 17.7.

For example, in some embodiments, the display substrate can be a 75-inch product, for example, W=1.5-4 microns, and for example, W can be 2.5 microns, 2.6 microns, or 2.7 microns; for example, L=35-45 microns, and for example, L can be 39 microns, 40 microns, or 41 microns; M1 is the number (a count) of pixel openings (multiplying the resolution, 8K): 7680*4320=33177600; for example, M2 ranges from 14400 square centimeters to 14500 square centimeters, and for example, M2=154.96*93.38=14470.16 square centimeters; S2=900-1200 square microns, and for example, S2 can be 1020 square microns, 1030 square microns, or 1040 square microns.

For example, for a 75-inch product, W=4 microns, L=39 microns, M1=33177600; M2=154.96*93.38=14470.16 square centimeters; S2=1200 square microns, the value of (W*L+S2)*M1/M2 is 0.031, and the value of S2/(W*L) is 7.69.

For example, referring to Fig. 5, Fig. 6, Fig. 7D, Fig. 8A, Fig. 8D and Fig. 9-Fig. 11, the storage capacitor Cst further includes a third electrode plate Cc, the third electrode plate Cc and the second electrode plate Cb are connected to each other, and the third electrode plate Cc and the second electrode plate Cb are respectively arranged at both sides of the first electrode plate Ca. By setting the second electrode plate Cb located below the first electrode plate Ca and the third electrode plate Cc located above the first electrode plate Ca, it is beneficial to increasing the capacitance of the storage capacitor and improving the display quality. Of course, the setting of the third electrode plate Cc can comprehensively consider the leveling design, the capacitance, the position of the first electrode plate Ca, and the position of the second electrode plate Cb.

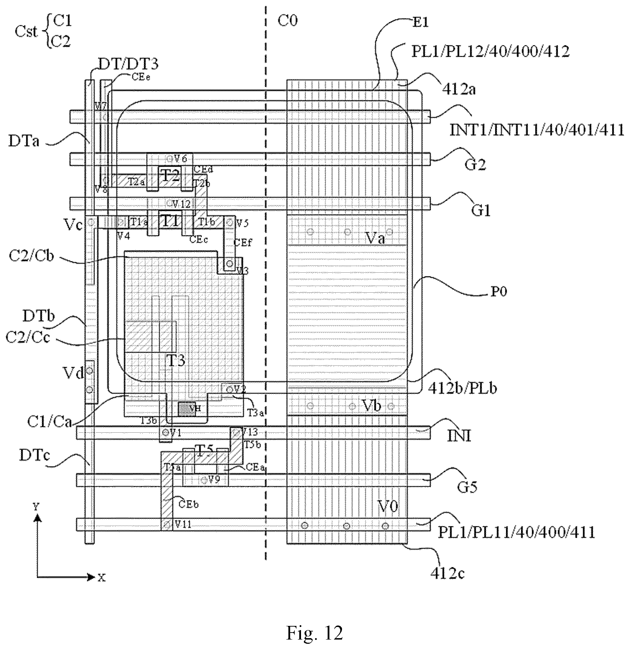

Fig. 12 is a layout diagram of a display substrate provided by another embodiment of the present disclosure. Compared with the display substrate shown in Fig. 5, in the display substrate shown in Fig. 12, the connection electrode CEb is located in the active layer L0, and the connection electrode CEb and the first electrode T5a of the light-emitting control transistor T5 are of an integral structure.

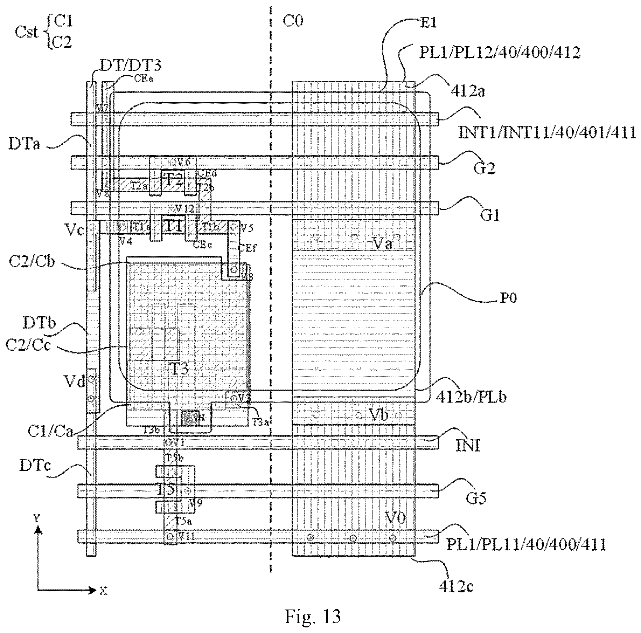

Fig. 13 is a layout diagram of a display substrate provided by another embodiment of the present disclosure. Compared with the display substrate shown in Fig. 5, in the display substrate shown in Fig. 13, the second electrode T5b of the light-emitting control transistor T5 is directly connected to the second electrode T3b of the driving transistor T3.

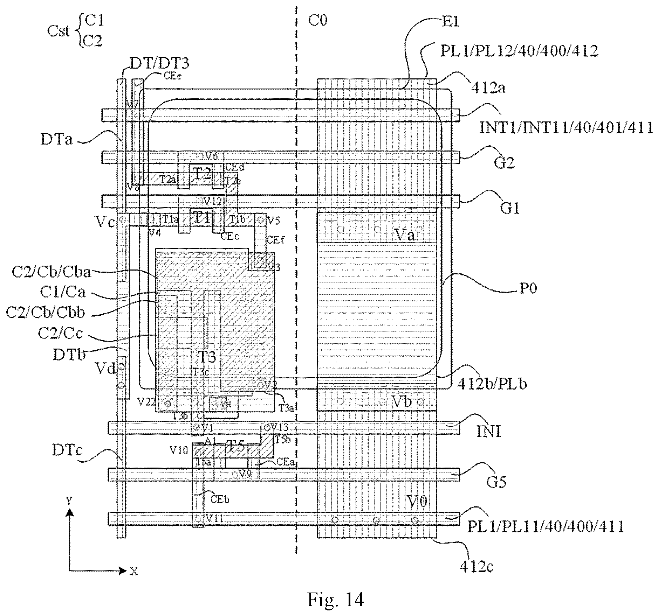

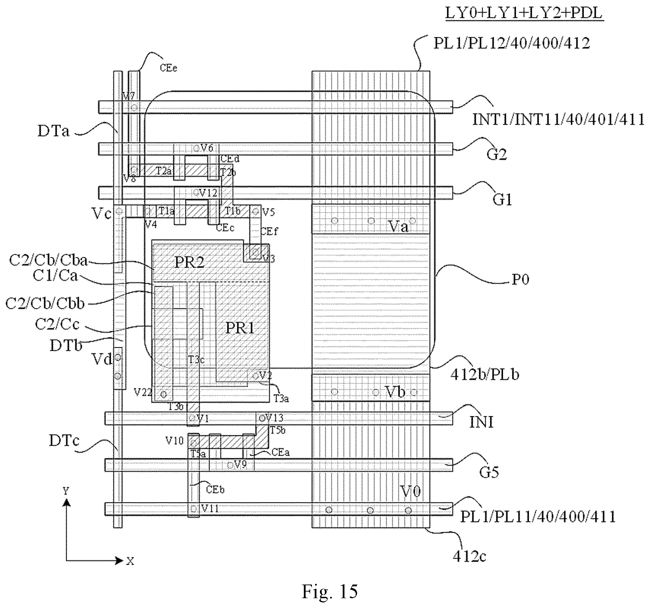

Fig. 14 is a layout diagram of a display substrate provided by another embodiment of the present disclosure. Fig. 15 shows stacked layers of some film layers in Fig. 14. As shown in Fig. 14 and Fig. 15, the second electrode plate Cb includes a first plate-shaped portion Cba, and the first plate-shaped portion Cba and the channel of the driving transistor T3 are of an integral structure.

For example, as shown in Fig. 14 and Fig. 15, the second electrode plate Cb further includes a second plate-shaped portion Cbb, the first plate-shaped portion Cba and the second plate-shaped portion Cbb are separated from each other, and the area of the first plate-shaped portion Cba is greater than the area of the second plate-shaped portion Cbb. As shown in Fig. 14 and Fig. 15, the second plate-shaped portion Cbb and the first plate-shaped portion Cba are located in the same layer and separated from each other. The first plate-shaped portion Cba, the second plate-shaped portion Cbb, and the channel of the driving transistor T3 are located in the same layer, and all of them are located in the active layer LY0.

As shown in Fig. 14 and Fig. 15, the second plate-shaped portion Cbb is connected to the third electrode plate Cc through a via hole V22.

As shown in Fig. 15, the first plate-shaped portion Cba includes a first part PR1 and a second part PR2, the first part PR1 extends in the first direction Y, the second part PR2 extends in the second direction X, and the first part PR1 and the second plate-shaped portion Cbb are opposite to each other and are respectively arranged at both sides of the channel T3c of the driving transistor T3 in the second direction X. For example, as shown in Fig. 15, the first part PR1 and the second part PR2 form a 7-shape. In Fig. 15, the first part PR1 and the second part PR2 are divided by a dashed line.

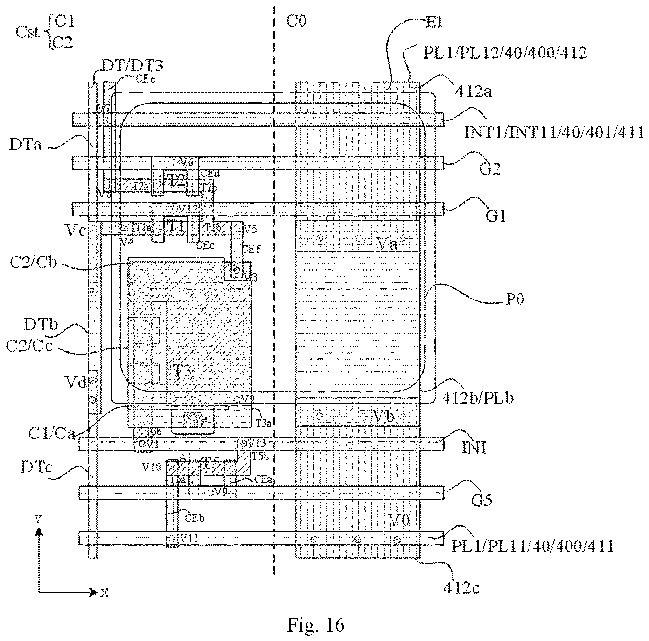

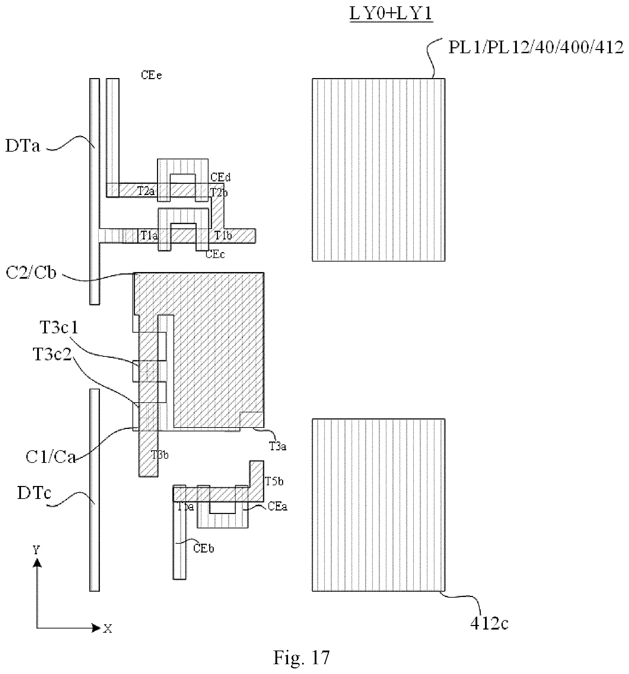

Fig. 16 is a layout diagram of a display substrate provided by another embodiment of the present disclosure. Fig. 17 shows stacked layers of some film layers in Fig. 16. As shown in Fig. 16 and Fig. 17, the driving transistor T3 adopts a dual-gate structure. Fig. 17 shows a channel T3c1 and a channel T3c2 of the driving transistor T3.

For example, the material of the channel of the driving transistor T3 is a semiconductor material, and the second electrode plate Cb is a conductor obtained by doping on the same semiconductor material as the channel of the driving transistor T3.

As shown in Fig. 5, Fig. 9-Fig. 14 and Fig. 16, the pixel opening P0 has a central axis C0 extending in the first direction Y. The pixel opening P0 is axisymmetric with respect to the central axis C0.

Referring to Fig. 9-Fig. 11, the pixel opening P0 of the sub-pixel 100 includes a pixel opening P01 of the first sub-pixel 101, a pixel opening P02 of the second sub-pixel 102, and a pixel opening P03 of the third sub-pixel 103.

Referring to Fig. 9-Fig. 11, the central axis C0 includes a central axis C01 of the pixel opening P0 (pixel opening P01) of the first sub-pixel 101, a central axis C02 of the pixel opening P0 (pixel opening P02) of the second sub-pixel 102, and a central axis C03 of the pixel opening P0 (pixel opening P03) of the third sub-pixel 103.

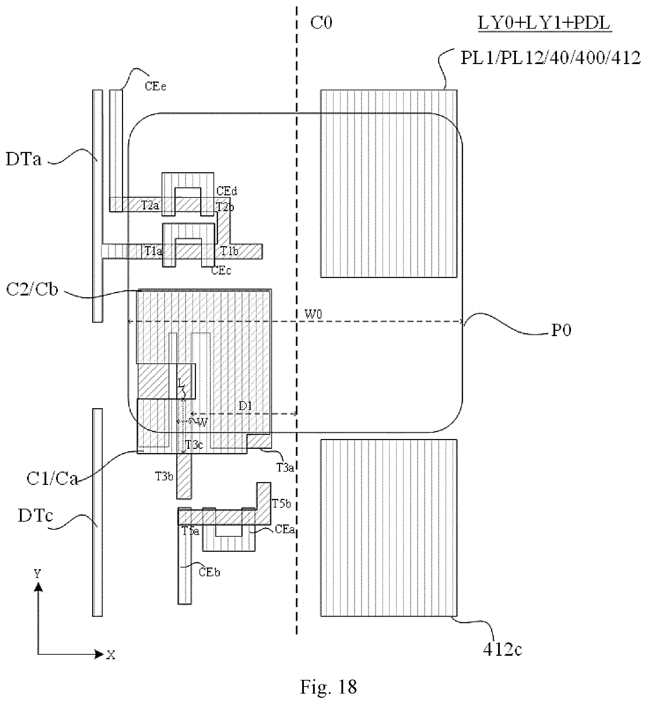

Fig. 18 shows stacked layers of some film layers in a display substrate provided by an embodiment of the present disclosure. For example, as shown in Fig. 18, the channel of the driving transistor T3 extends in the first direction Y, the pixel opening P0 has a central axis C0 extending in the first direction Y, the maximum size of the pixel opening P0 in the second direction X (the width of the pixel opening P0) is WO, the first direction Y intersects with the second direction X, the distance between the channel T3c of the driving transistor T3 and the central axis C0 is D1, and the value range of 2*D1/WO is [0.2, 0.4] or [0.6, 0.8]. The larger the value of D1, the smaller the proportion of the driving transistor T3, and the larger the area of the storage capacitor. The value of 2*D1/WO is within the above range, so as to define the position of the channel or gate electrode of the driving transistor, which is beneficial to improving the holding capacity of the storage capacitor, and is beneficial to increasing the area ratio of the storage capacitor to the pixel opening, increasing the area proportion of the storage capacitor, and improving the display quality.

For example, for a blue sub-pixel, WO=50 microns, D1=15.3 microns, and the value of 2*D1/WO is 0.6.

For example, for a green sub-pixel, WO=28 microns, D1=3.25 microns, and the value of 2*D1/WO is 0.2.

For example, for a red sub-pixel, WO=28 microns, D1=2.55 microns, and the value of 2*D1/WO is 0.2.

Several examples have been provided above, and the values of WO and D0 can be determined as needed, as long as the value range of 2*D1/WO is [0.2, 0.4] or [0.6, 0.8]. For a blue sub-pixel, the value range of 2*D1/WO is [0.6, 0.8], and for a green sub-pixel and/or a red sub-pixel, the value range of 2*D1/WO is [0.2, 0.4].

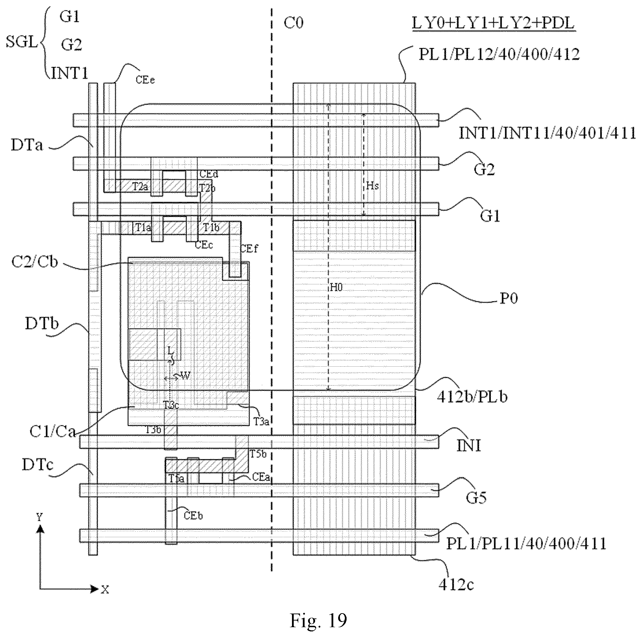

Fig. 19 shows stacked layers of some film layers in a display substrate provided by an embodiment of the present disclosure. For example, as shown in Fig. 19, the display substrate further includes a plurality of signal lines SGL located at one side of the storage capacitor Cst, the signal line SGL extends in the second direction X, the orthographic projections of the plurality of signal lines SGL on the base substrate BS overlap with the orthographic projection of the pixel opening P0 on the base substrate BS, the size of the pixel opening P0 in the first direction Y (the height of the pixel opening P0) is H0, the distance between the farthest edges of the plurality of signal lines SGL in the first direction Y is Hs, and the value range of L/(H0-Hs) is [0.59, 1.19]. The smaller the value of the length L of the channel T3c, the larger the area of the storage capacitor. The value of L/(H0-Hs) is within the above range, so as to define the position of the channel or gate electrode of the driving transistor, which is beneficial to obtaining a storage capacitor with large capacitance.

In some embodiments, the value of L is about 10-30μm, the value of H0 is about 50-75μm, and the value of Hs is about 10-25μm, but not limited thereto.

For example, L=30μm, H0=75μm, Hs=25μm, and the value of L/(H0-Hs) is 0.6.

For example, as shown in Fig. 19, the display substrate further includes a data line DT, a gate line G1, a gate line G2, and an initialization line INT1; the pixel circuit 100a further includes a data writing transistor T1 and a reset transistor T2, the first electrode of the data writing transistor T1 is connected to the data line DT, the gate electrode of the driving transistor T3 is connected to the second electrode of the data writing transistor T1, the gate electrode of the data writing transistor T1 is connected to the gate line G1, the first electrode of the reset transistor T2 is connected to the initialization line INT1, the second electrode of the reset transistor T2 is connected to the gate electrode of the driving transistor T3, the gate electrode of the reset transistor T2 is connected to the gate line G2, and the plurality of signal lines SGL include the gate line G1, the gate line G2, and the initialization line INT1. Of course, in some other embodiments, the plurality of signal lines SGL can also include at least one of the gate line G1, the gate line G2, and the initialization line INT1, or include other signal lines overlapping with the pixel opening P0.

For example, the area of the pixel opening P0 is S0, the sum of the facing area between the second electrode plate Cb and the first electrode plate Ca and the area of the channel T3c of the driving transistor T3 is Ss, and the relationship between Ss and S0 satisfies: Ss=A*S0+B, where the value range of A is [0.42, 0.82], and the value range of B is [-2700, -3100]. Through the above formula, the fitting of the design regions of the pixel opening, the storage capacitor, and the driving transistor is realized, which is beneficial to increasing the area ratio of the storage capacitor to the pixel opening, increasing the area proportion of the storage capacitor, and improving the display quality.

For example, in some embodiments, Ss=179, S0=4524, and the units of area S0 and area Ss are both square microns. In this case, A=0.686 and B=-2924.

For example, in some embodiments, Ss=2440, S0=7820, and the units of area S0 and area Ss are both square microns. In this case, A=0.686 and B=-2924.

For example, in some embodiments, Ss=370, S0=4802, and the units of area S0 and area Ss are both square microns. In this case, A=0.686 and B=-2924.

For example, in some embodiments, Ss=3219, S0=8955, and the units of area S0 and area Ss are both square microns. In this case, A=0.686 and B=-2924.

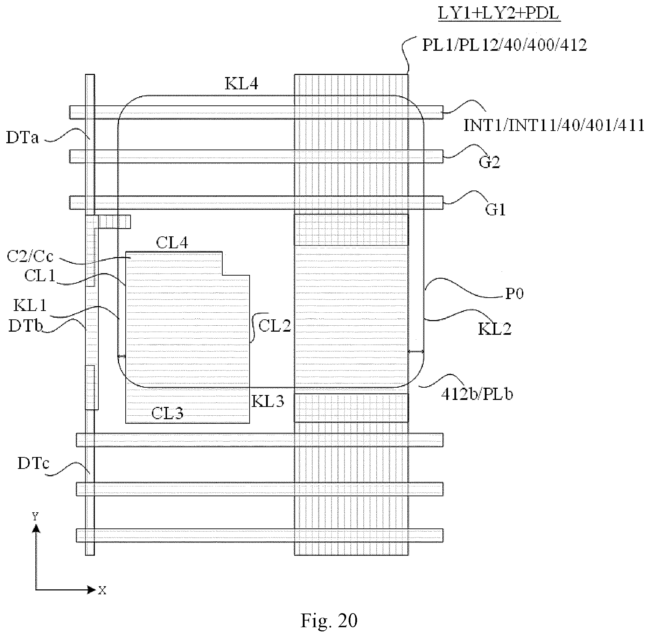

Fig. 20 shows stacked layers of some film layers in a display substrate provided by an embodiment of the present disclosure. For example, as shown in Fig. 5, Fig. 9-Fig. 11 and Fig. 20, the orthographic projection of the pixel opening P0 on the base substrate BS overlaps with the orthographic projection of the third electrode plate Cc on the base substrate BS.

For example, as shown in Fig. 20, the third electrode plate Cc includes a first edge CL1 extending in the first direction Y and a second edge CL2 extending in the first direction Y, and the pixel opening P0 includes a first edge KL1 extending in the first direction Y and a second edge KL2 extending in the first direction Y.

For example, as shown in Fig. 20, the first edge CL1 of the third electrode plate Cc is closer to the first edge KL1 of the pixel opening P0 than the second edge CL2 of the third electrode plate Cc, and the second edge CL2 of the third electrode plate Cc is closer to the second edge KL2 of the pixel opening P0 than the first edge CL1 of the third electrode plate Cc. The sub-pixel 100 satisfies the following formula:

$$\triangle U = |U02 - U01|,$$

where U01 is a coordinate distance between a chromaticity coordinate point at a first viewing angle and a chromaticity coordinate point at a 0-degree viewing angle, U02 is a coordinate distance between a chromaticity coordinate point at a second viewing angle and the chromaticity coordinate point at the 0-degree viewing angle, and $\triangle U$ is an absolute value of a difference between U02 and U01, the chromaticity coordinate point at the 0-degree viewing angle is a chromaticity coordinate point at a normal line passing through a center of the display substrate, the first viewing angle and the second viewing angle are arranged at opposite sides of the normal line and have an equal included angle value with the normal line, and $\triangle U \leq 0.0020$.

For example, as shown in Fig. 20, the sub-pixel 100 satisfies the following formula:

$$\triangle U = |U02 - U01| \leq k \times |Xb - Xa| / KW,$$

where k is a color shift influence coefficient, $0.009 \leq k \leq 0.03$, $\triangle U < 0.0020$, Xa is the minimum distance between the first edge CL1 of the third electrode plate Cc and the first edge KL1 of the pixel opening P0 in the second direction X, Xb is the minimum distance between the second edge CL2 of the third electrode plate Cc and the second edge KL2 of the pixel opening P0 in the second direction X, and the first direction Y intersects with the second direction X; KW is the maximum size of the pixel opening P0 in the second direction X, U01 is a coordinate distance between a chromaticity coordinate point at a first viewing angle and a chromaticity coordinate point at a 0-degree viewing angle, U02 is a coordinate distance between a chromaticity coordinate point at a second viewing angle and the chromaticity coordinate point at the 0-degree viewing angle, and △U is an absolute value of a difference between U02 and U01, the chromaticity coordinate point at the 0-degree viewing angle is a chromaticity coordinate point at a normal line passing through a center of the display substrate, and the first viewing angle and the second viewing angle are arranged at opposite sides of the normal line and have an equal included angle value with the normal line.

The size of KW is the maximum size WO of the pixel opening P0 in the second direction X (the width of the pixel opening P0).

For example, as shown in Fig. 20, the third electrode plate Cc further includes a third edge CL3 extending in the second direction X and a fourth edge CL4 extending in the second direction X, and the pixel opening P0 includes a third edge KL3 extending in the second direction X and a fourth edge KL4 extending in the second direction X.

As shown in Fig. 20, the orthographic projection of the third edge CL3 on the base substrate is located at the outer side of the orthographic projection of the pixel opening P0 on the base substrate.

As shown in Fig. 20, the orthographic projection of the fourth edge CL4 on the base substrate is located within the orthographic projection of the pixel opening P0 on the base substrate.

As shown in Fig. 20, the first edge CL1 and the second edge CL2 are arranged opposite to each other, and the third edge CL3 is connected to the first edge CL1 and the second edge CL2 through rounded corners, respectively. The third edge CL3 and the fourth edge CL4 are arranged opposite to each other, and the fourth edge CL4 is connected to the first edge CL1 and the second edge CL2 through rounded corners, respectively. Of course, in some other embodiments, the adjacent edges of the opening may not be connected by a rounded corner.

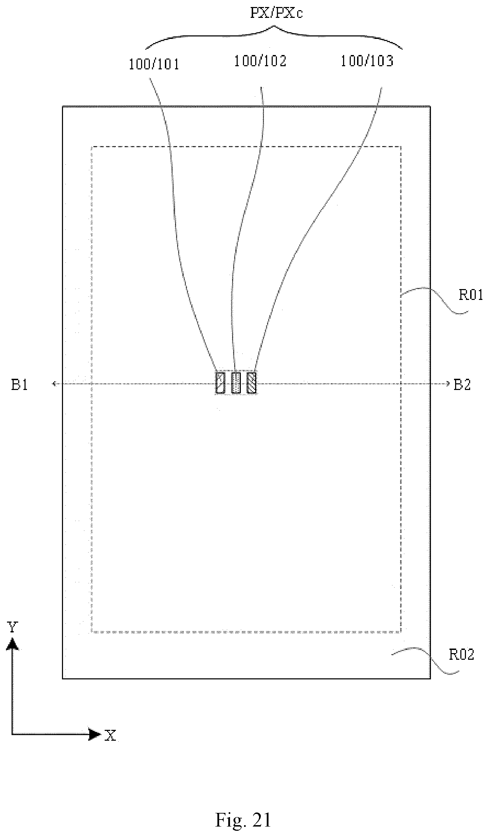

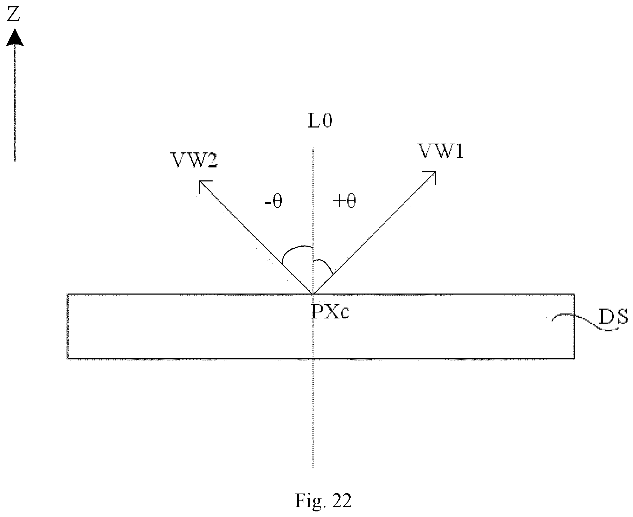

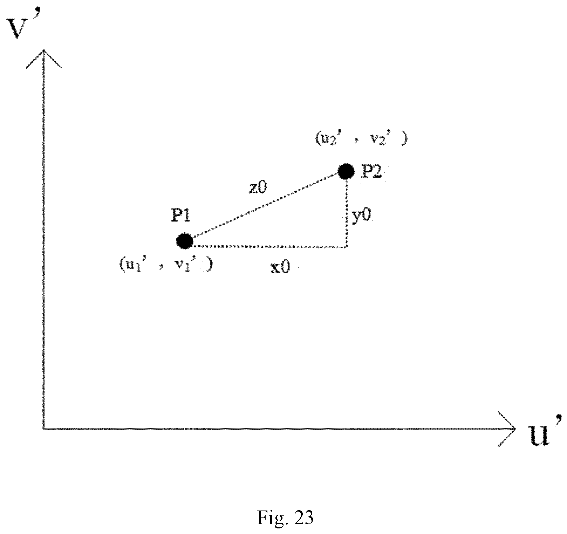

Fig. 21 is a schematic diagram of a central-point pixel of a display substrate provided by an embodiment of the present disclosure. Fig. 22 is a cross-sectional view taken along line B1-B2 of Fig. 21. Fig. 23 is a schematic diagram showing a coordinate distance between chromaticity coordinate points at two different viewing angles of a display substrate.

Fig. 21 shows a central-point pixel PXc. For example, the central-point pixel PXc is the pixel PX located at the center point of the display region R01.

For example, a non-contact spectrometer (such as PR630, 730; CS2000, 2000A) equipment can be used to perform random inspection testing on the display substrate (display panel) to be tested (more than 10 pieces are selected, and the worst data is selected) in a dark room (illumination below 11x) environment. The test point is the central-point pixel of the display substrate. Read the u' and v' coordinates of this point in the 1976UV chromaticity coordinate system of four colors RBGW. Measurement is performed at nine viewing angles: 0 degree, $\pm 15$ degrees, $\pm 30$ degrees, $\pm 45$ degrees and $\pm 60$ degrees. The u' value and v' value at each angle are measured. Take color shift at the viewing angle of -60 degrees as an example.

$$\Delta u' \quad v' \quad = \sqrt{\left(u_2' - u_1'\right)^2 + \left(v_2' - v_1'\right)^2}$$

,

where $(u_2', v_2')$ is the chromaticity coordinate at the viewing angle of -60 degrees, and $(u_1', v_1')$ is the chromaticity coordinate at the viewing angle of 0 degree.

Substituting into the formula, △u'v' of -60 degrees is obtained; in the same way, △u'v' of 60 degrees is calculated. By optimizing the structure of the display substrate, the difference between the two values of four colors (RGBW) can be less than 0.0015, and the value of △u'v' at each angle is less than 0.025. The first sub-pixel 101 is a red sub-pixel, the second sub-pixel 102 is a green sub-pixel, and the third sub-pixel 103 is a blue sub-pixel. When measuring the color shift of white light, the first sub-pixel 101, the second sub-pixel 102, and the third sub-pixel 103 in the central-point pixel PXc are all lit.

The uniform color space CIE1976 is transformed from CIE1931XYZ.

The calculation formulas of CIE1976Luv include:

$$\begin{cases} u' = \dfrac{4X}{X+15Y+3Z} \\[4mm] v' = \dfrac{9Y}{X+15Y+3Z} \end{cases}$$

,

where u' and v' are chromaticity coordinates of the color sample, and X, Y and Z are tristimulus values of the sample.

It should be noted that the color shift measurement method is not limited to the above description, and the measuring apparatus used are not limited to the enumerated ones. The same measuring apparatus can be used to measure the chromaticity coordinates at different viewing angles, and the coordinate distance between the chromaticity coordinate point at each viewing angle and the chromaticity coordinate point at the 0-degree viewing angle can be obtained.

The embodiment of the present disclosure is illustrated by taking the measurement of the color shift of the central-point pixel PXc as an example, and of course, the color shift of each sub-pixel in other suitable pixels can also be measured.

Fig. 23 shows a coordinate distance between a chromaticity coordinate point P2 and a chromaticity coordinate point P1. As shown in Fig. 23, x0 is a coordinate distance between the abscissas of the chromaticity coordinate point P2 and the chromaticity coordinate point P1, y0 is a coordinate distance between the ordinates of the chromaticity coordinate point P2 and the chromaticity coordinate point P1, and z0 is the coordinate distance between the chromaticity coordinate point P2 and the chromaticity coordinate point P1.

For example, the coordinate distance between chromaticity coordinate points at two viewing angles refers to a square root of the sum of the square of the difference between the abscissas of the two chromaticity coordinate points and the square of the difference between the ordinates of the two chromaticity coordinate points.

Fig. 22 shows a normal line L0 passing through the center of the display substrate, and the normal line L0 is parallel to the third direction Z. Fig. 22 shows a first viewing angle VW1 and a second viewing angle VW2. The included angle between the first viewing angle VW1 and the normal line L0 is +θ, and the included angle between the second viewing angle VW2 and the normal line L0 is -θ. At the positive viewing angle θ, the normal line L0 is clockwise rotated by angel θ to obtain this viewing angle; and at the negative viewing angle θ, the normal line L0 is counterclockwise rotated by angel θ to obtain this viewing angle.

The situations shown in Fig. 21 and Fig. 22 are used to measure the color shift of the left and right viewing angles. When measuring the color shift of the up and down viewing angles, the first viewing angle VW1 and the second viewing angle VW2 are arranged at both sides of the normal line L0 in the first direction Y.

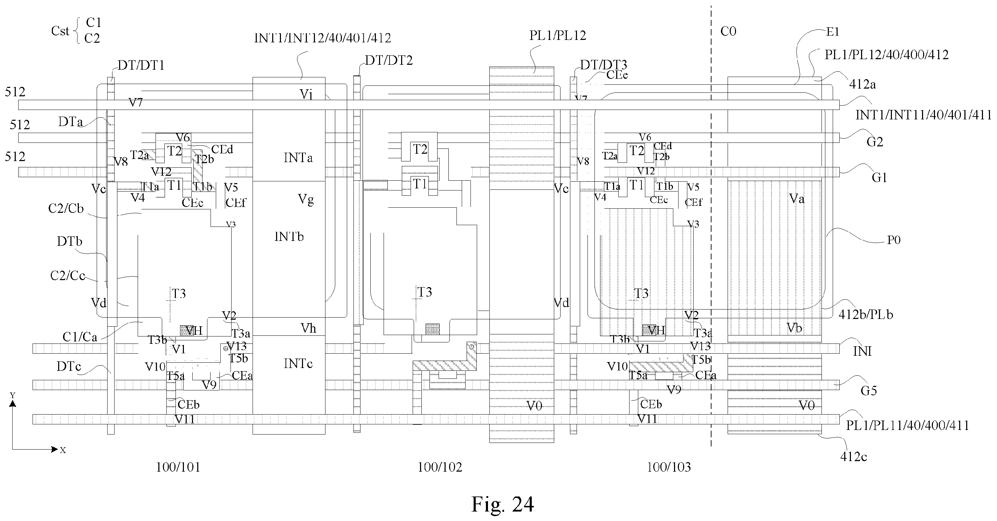

Fig. 24 is a layout diagram of a display substrate provided by an embodiment of the present disclosure. Fig. 24 shows a first sub-pixel 101, a second sub-pixel 102, and a third sub-pixel 103. As shown in Fig. 24, the first sub-pixel 101, the second sub-pixel 102, and the third sub-pixel 103 are sequentially arranged in the second direction X.

As shown in Fig. 24, the initialization line INT1 includes an initialization signal line INT11 and an initialization connection line INT12, and the initialization signal line INT11 and the initialization connection line INT12 are connected. As shown in Fig. 24, the initialization signal line INT11 and the initialization connection line INT12 are connected through a via hole Vj. As shown in Fig. 24, the initialization signal line INT11 extends in the second direction X, and the initialization connection line INT12 extends in the first direction Y.

As shown in Fig. 24, the initialization connection line INT12 and the first power connection line PL12 are alternately arranged in the second direction X at the corresponding positions.

As shown in Fig. 24, a first part INTa and a second part INTb of the initialization connection line INT12 are connected through a via hole Vg, and the second part INTb and a third part INTc of the initialization connection line INT12 are connected through a via hole Vh.

As shown in Fig. 24, the initialization connection line INT12 passes through the first sub-pixel 101, and two adjacent first power connection lines PL1 pass through the second sub-pixel 102 and the third sub-pixel 103, respectively. That is, the initialization connection line INT12, one first power connection line PL12, and another first power connection line PL12 are sequentially arranged in the second direction X. The initialization connection line INT12 extends in the first direction Y, and the first power connection line PL12 extends in the first direction Y.

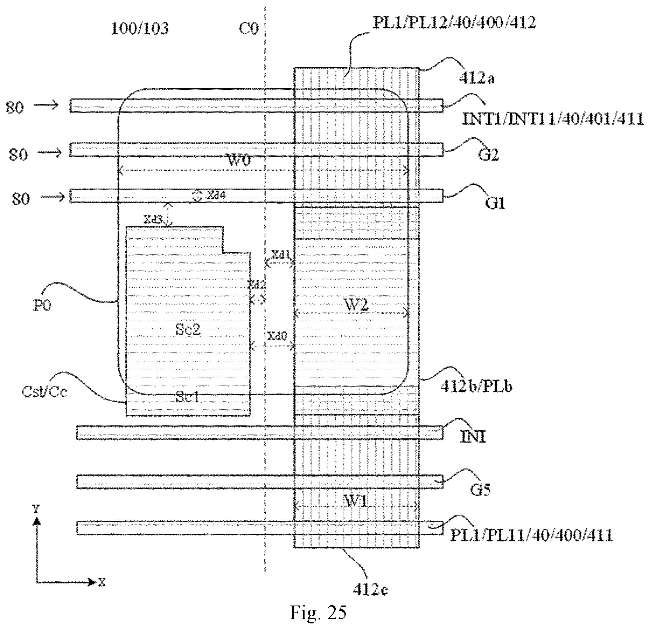

Fig. 25 is a plan view of a display substrate provided by an embodiment of the present disclosure. For example, the sub-pixel 100 shown in Fig. 25 is a third sub-pixel 103, and the third sub-pixel 103 is a blue sub-pixel.

For example, as shown in Fig. 5 and Fig. 25, the display substrate further includes a first power line PL1, the first power line PL1 is configured to provide a first voltage signal to the pixel circuit 100a, the first power line PL1 includes a first power connection line PL12 extending in the first direction Y and a first power signal line PL11 extending in the second direction X, and the orthographic projection of the first power connection line PL12 on the base substrate BS overlaps with the orthographic projection of the pixel opening P0 on the base substrate BS.

As shown in Fig. 5 and Fig. 25, the first power connection line PL12 is formed by connecting a plurality of conductive parts located in two conductive pattern layers. The embodiment of the present disclosure includes but is not limited to this case. In some other embodiments, the first power connection line PL12 can also be formed of conductive lines located in the same layer, or formed by connecting a plurality of conductive parts located in three or more conductive pattern layers.

For example, referring to Fig. 5 and Fig. 25, the area of the third electrode plate Cc is Sc1, the overlapping area between the orthographic projection of the third electrode plate Cc on the base substrate BS and the orthographic projection of the pixel opening P0 on the base substrate BS is Sc2, and Sc2/Sc1$\geq$0.9. The third electrode plate Cc can play a role of leveling, and can level the bottom surface of the pixel opening P0 of the sub-pixel 100, so as to improve the flatness of the light-emitting layer, and improve the display quality. For example, the sub-pixel satisfying Sc2/Sc1$\geq$0.9 can be a blue sub-pixel, so as to level the blue sub-pixel, improve the flatness of the light-emitting layer of the blue sub-pixel, and improve the display quality. Further, for example, in order to play a better role of leveling, Sc2/Sc1$\geq$0.95.

For example, referring to Fig. 5 and Fig. 25, the width of the first power connection line PL12 is W1, the overlapping width between the first power connection line PL12 and the pixel opening P0 is W2, and W2/W1$\geq$0.9, so that the first power connection line PL12 can better level the pixel opening P0 of the sub-pixel 100 to improve the flatness of the light-emitting layer. Further, for example, in order to play a better role of leveling, W2/W1$\geq$0.95.

In the embodiment of the present disclosure, the width of a line refers to the size of the line in a direction perpendicular to the extending direction of the line.

For example, as shown in Fig. 25, the maximum size of the pixel opening P0 in the second direction X is WO, and the value range of $2 \times$W2/WO is [0.71, 0.99], so as to enhance the leveling effect of the first power connection line PL12 and improve the flatness of the light-emitting layer; and the value range of cross voltage Uc(V)/size Lg(inch) is [0.32, 0.74], so as to improve current uniformity, where the size Lg is a diagonal length of the display substrate. For example, the cross voltage Uc is the voltage difference between the first electrode and the second electrode of the light-emitting element. For example, the cross voltage Uc is the difference between the first voltage signal VDD and the second voltage signal VSS. Referring to Fig. 1, the largest rectangular frame represents a display substrate, the diagonal of the rectangle is the diagonal of the display substrate, and the unit of the diagonal length is inches.

For example, in some embodiments, the first voltage signal VDD is 17V, the second voltage signal VSS is 2V, Uc=15V, Lg=27 inches, and cross voltage Uc(V)/size Lg(inch) is 0.55.

Further, for example, the value range of $2 \times$W2/WO is [0.80, 0.99], and the value range of cross voltage Uc(V)/size Lg(inch) is [0.52, 0.74].

For example, as shown in Fig. 25, the pixel opening P0 has a central axis C0 extending in the first direction Y, the minimum distance between the first power connection line PL12 and the central axis C0 is Xd1, the minimum distance between the third electrode plate Cc and the central axis C0 is Xd2, and the value range of Xd1/Xd2 is [0.9, 1.1], so as to facilitate the first power connection line PL12 and the third electrode plate Cc to level the bottom surface of the pixel opening of the sub-pixel and improve the flatness of the light-emitting layer, thus improving the display quality.

For example, in some embodiments, Xd1=1.57 microns, Xd2=1.73 microns, and Xd1/Xd2=0.9. For example, in some other embodiments, Xd1=1.73 microns, Xd2=1.57 microns, and Xd1/Xd2=1.1. Xd1 and Xd2 are not limited to the above values, and can be determined as needed.

For example, as shown in Fig. 25, the display substrate further includes a plurality of signal lines 80 located at one side of the storage capacitor Cst (the storage capacitor Cst is shown by the third electrode plate Cc in Fig. 25), the orthographic projections of the plurality of signal lines 80 on the base substrate BS overlap with the orthographic projection of the pixel opening P0 on the base substrate BS, the signal line 80 extends in the second direction X, the distance between the third electrode plate Cc and a signal line closest to the third electrode plate Cc is Xd3, the width of the signal line is Xd4, and the value range of Xd3/Xd4 is [0.9, 1.1], which is helpful to improve the leveling effect of the signal line 80 and the third electrode plate Cc on the bottom surface of the pixel opening of the sub-pixel, alleviate the color shift between the up and down directions, and improve the consistency of the color shift between the up and down directions.

For example, in some embodiments, Xd3=3 microns, Xd4=3 microns, and Xd3/Xd4=1. Xd3 and Xd4 are not limited to the above values, and can be determined as needed.

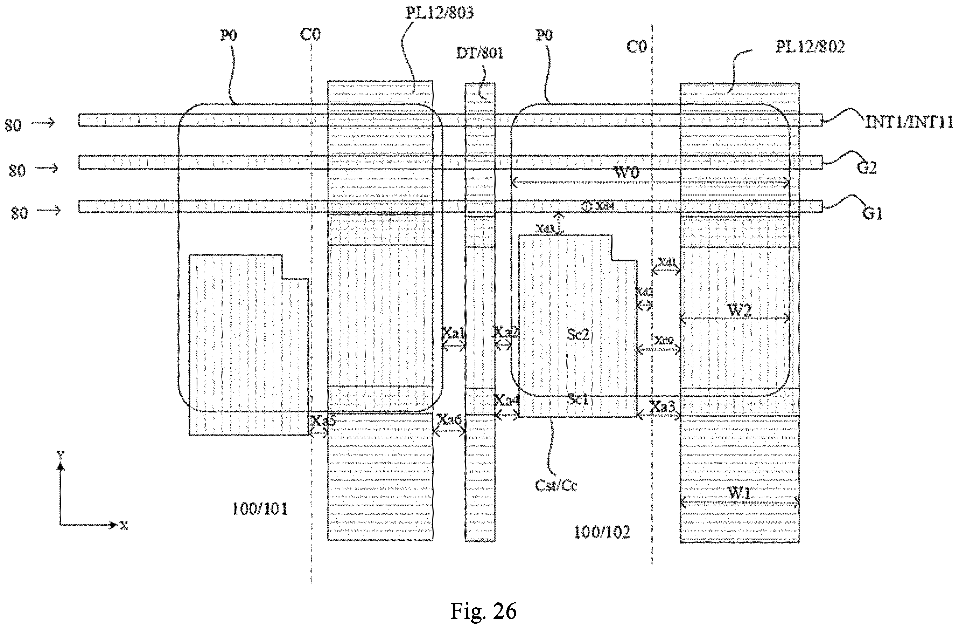

Fig. 26 is a plan view of a display substrate provided by an embodiment of the present disclosure. Fig. 26 shows two sub-pixels 100. The first sub-pixel 101 is a red sub-pixel, and the second sub-pixel 102 is a green sub-pixel.

For example, as shown in Fig. 26, the display substrate further includes a first power line PL1, the first power line PL1 is configured to provide a first voltage signal to the pixel circuit 100a, the first power line PL1 includes a first power connection line PL12 extending in the first direction Y and a first power signal line PL11 extending in the second direction X, the minimum distance between the first power connection line PL12 and the central axis C0 is Xd1, the minimum distance between the first power connection line PL12 and the third electrode plate Cc is Xd0, DP=|Xd1-Xd0|/2, the maximum size of the pixel opening P0 in the second direction X (the width of the pixel opening P0) is WO, and the value range of DP/WO is [0.01, 0.19], which is beneficial to the leveling effect of the first power connection line PL12 and the third electrode plate Cc on the bottom surface of the pixel opening of the sub-pixel and improving the flatness of the light-emitting layer. For example, the red sub-pixel or the green sub-pixel in the display substrate satisfies that the value range of DP/WO is [0.01, 0.19].

For example, in some embodiments, Xd1=22 microns, Xd0=8 microns, DP=7 microns, WO=52 microns, and DP/WO=0.13.

For example, in some embodiments, the display substrate further satisfies at least one of the following settings: W2/W1≥0.9, the value range of 2×W2/WO is [0.71, 0.99], the value range of cross voltage Uc(V)/size Lg(inch) is [0.32, 0.74], the value range of Xd1/Xd2 is [0.9, 1.1], the value range of Xd3/Xd4 is [0.9, 1.1], and the value range of DP/WO is [0.01, 0.19], so that the display substrate satisfies that ΔU≤0.0020. That is, by the design of at least one of the above sizes, the color shift of the display substrate is relatively small.

For example, as shown in Fig. 26, the display substrate further includes a first signal line 801, the first signal line 801 extends in the first direction Y, the sub-pixels 100 include a first sub-pixel 101 and a second sub-pixel 102 that are adjacent to each other in the second direction X, the first signal line 801 is configured to provide a data signal to the pixel circuit 100a of the first sub-pixel 101, the pixel opening P0 of the first sub-pixel 101 and the pixel opening P0 of the second sub-pixel 102 are separated from each other, and the first signal line 801 is located between the pixel opening P0 of the first sub-pixel 101 and the pixel opening P0 of the second sub-pixel 102.

For example, as shown in Fig. 26, the minimum distance between the pixel opening P0 of the first sub-pixel 101 and the first signal line 801 is Xa1, the minimum distance between the pixel opening P0 of the second sub-pixel 102 and the first signal line 801 is Xa2, and the value range of Xa1/Xa2 is [0.8, 1.2]. The first signal line 801 extends in the first direction Y and is located between the pixel openings P0 of adjacent sub-pixels. The body material of the pixel defining layer is arranged directly on the first signal line 801. By defining the ratio of the minimum distances between the adjacent pixel openings and the first signal line 801, the voltage drop can be reduced, and the color shift can be alleviated.

For example, in some embodiments, Xa1=12 microns, Xa2=12 microns, and Xa1/Xa2=1. Of course, Xa1 and Xa2 can fluctuate up and down on the basis of the above values, as long as the value range of Xa1/Xa2 is [0.8, 1.2].

For example, as shown in Fig. 26, the display substrate further includes a second signal line 802, the second signal line 802 extends in the first direction Y, the first signal line 801 and the second signal line 802 are located at opposite sides of the same third electrode plate Cc, and the orthographic projection of the second signal line 802 on the base substrate BS overlaps with the orthographic projection of the pixel opening P0 of the second sub-pixel 102 on the base substrate BS.

For example, as shown in Fig. 26, the spacing between the third electrode plate Cc and the second signal line 802 is Xa3, the spacing between the third electrode plate Cc and the first signal line 801 is Xa4, and the value range of Xa3/Xa4 is [0.8, 1.2], so as to enhance the leveling effect of the third electrode plate Cc and the second signal line 802 on the bottom surface of the pixel opening of the second sub-pixel 102, improve the flatness of the light-emitting layer, and alleviate the color shift.

For example, in some embodiments, Xa3=8.6 microns, Xa4=10 microns, and Xa3/Xa4=0.86. Of course, Xa3 and Xa4 can fluctuate up and down on the basis of the above values, as long as the value range of Xa3/Xa4 is [0.8, 1.2].

For example, as shown in Fig. 26, the display substrate further includes a third signal line 803, the third signal line 803 extends in the first direction Y, the orthographic projection of the third signal line 803 on the base substrate BS overlaps with the orthographic projection of the pixel opening P0 of the first sub-pixel 101 on the base substrate BS, the minimum distance between the third electrode plate Cc of the first sub-pixel 101 and the third signal line 803 is Xa5, the minimum distance between the third signal line 803 and the first signal line 801 is Xa6, and the value range of Xa5/Xa6 is [0.8, 1.2], so as to enhance the leveling effect of the third electrode plate Cc and the third signal line 803 on the bottom surface of the pixel opening of the first sub-pixel 101, improve the flatness of the light-emitting layer, and alleviate the color shift.

For example, in some embodiments, Xa5=8.7 microns, Xa6=7.3 microns, and Xa5/Xa6=1.2. Of course, Xa5 and Xa6 can fluctuate up and down on the basis of the above values, as long as the value range of Xa5/Xa6 is [0.8, 1.2].

For example, as shown in Fig. 26, the first signal line 801 includes a data line DT, and at least one of the second signal line 802 and the third signal line 803 includes a first power connection line PL12 or an initialization connection line INT12. Fig. 26 is illustrated by taking that the second signal line 802 and the third signal line 803 are both first power connection lines PL12 as an example. In some other embodiments, the second signal line 802 is the first power connection line PL12, and the third signal line 803 is the initialization connection line INT12. As shown in Fig. 26, the third signal line 803, the first signal line 801, and the second signal line 802 are sequentially arranged in the second direction X.

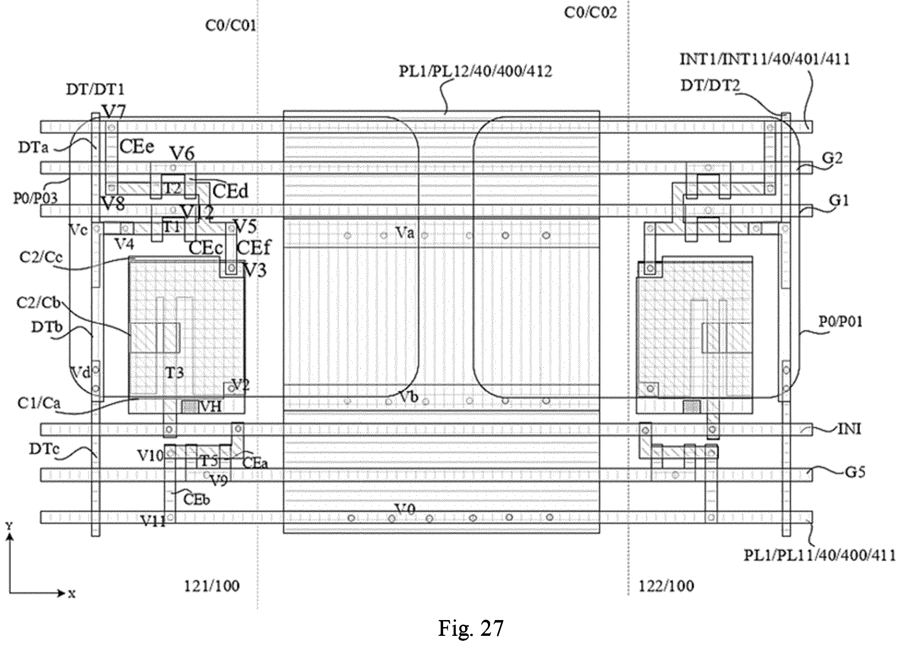

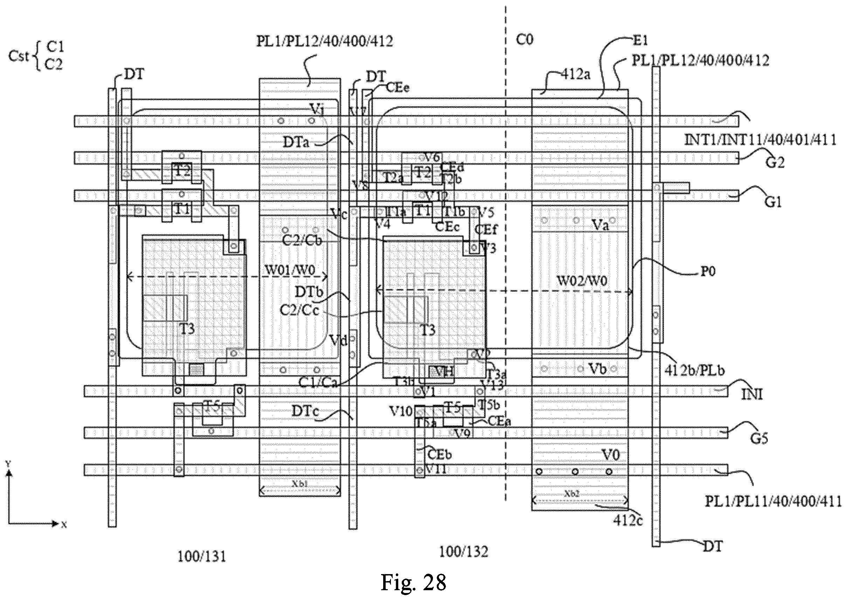

Fig. 27 is a plan view of a display substrate provided by an embodiment of the present disclosure. Fig. 28 is a plan view of a display substrate provided by an embodiment of the present disclosure. For example, as shown in Fig. 27 and Fig. 28, the display substrate further includes a data line DT and a first power line PL1, the data line DT is configured to provide a data voltage to the pixel circuit 100a, the date line extends in the first direction Y, the first power line PL1 is configured to provide a first voltage signal VDD to the pixel circuit 100a, the first power line PL1 includes a first power connection line PL12 extending in the first direction Y and a first power signal line PL11 extending in the second direction X, the sub-pixels 100 include a sub-pixel 121 and a sub-pixel 122 that are adjacent to each other in the second direction X, and the orthographic projection of the first power connection line PL12 on the base substrate overlaps with the pixel opening P0 of the sub-pixel 121 on the base substrate, and overlaps with the pixel opening P0 of the sub-pixel 122 on the base substrate.

For example, as shown in Fig. 27, two data lines DT are arranged at two sides of the first power connection line PL12, respectively, and the orthographic projections of the two data lines DT on the base substrate overlap with the orthographic projections of the pixel opening P0 of the sub-pixel 121 and the pixel opening P0 of the sub-pixel 122 on the base substrate, respectively. Fig. 27 shows a data line DT1 and a data line DT2, the data line DT1 and the data line DT2 provide data voltages for the sub-pixel 121 and the sub-pixel 122, respectively; and the orthographic projections of the data line DT1 and the data line DT2 on the base substrate overlap with the orthographic projections of the pixel opening P01 of the sub-pixel 121 and the pixel opening P02 of the sub-pixel 122, respectively. Therefore, by widening the first power connection line PL12 and cooperation of the first power connection line PL12 and the two data lines DT (data line DT1 and data line DT2), the sub-pixel 121 and the sub-pixel 122 are leveled, the flatness of the light-emitting layer is improved, the color shift is alleviated, and the voltage drop problem of the large-sized and medium-sized display substrates can be solved, and the brightness uniformity is improved.

Fig. 27 is illustrated by taking that the orthographic projections of two data lines DT on the base substrate overlap with the orthographic projections of the pixel opening P0 of the sub-pixel 121 and the pixel opening P0 of the sub-pixel 122 on the base substrate respectively as an example. However, the embodiment of the present disclosure is not limited to this case. For example, by adjusting the layout design, the orthographic projections of the two data lines DT on the base substrate BS do not overlap with the orthographic projection of the pixel opening P0 of the sub-pixel 121 on the base substrate BS, and do not overlap with the orthographic projection of the pixel opening P0 of the sub-pixel 122 on the base substrate BS. Therefore, by widening the first power connection line PL12 and cooperation of the first power connection line PL12, the third electrode plate Cc of the sub-pixel 121, and the third electrode plate Cc of the sub-pixel 122, the sub-pixel 121 and the sub-pixel 122 are leveled, thereby improving the flatness of the light-emitting layer and alleviating the color shift.

For example, as shown in Fig. 28, the display substrate further includes a first power line PL1, the first power line PL1 is configured to provide a first voltage signal VDD to the pixel circuit 100a, the first power line PL1 includes a first power connection line PL12 extending in the first direction Y and a first power signal line PL11 extending in the second direction X, the orthographic projection of the first power connection line PL12 on the base substrate BS overlaps with the orthographic projection of the pixel opening P0 on the base substrate BS, the maximum size of the pixel opening P0 of the sub-pixel 100 in the second direction X is WO, the sub-pixels 100 include a sub-pixel 131 and a sub-pixel 132 that are adjacent to each other in the second direction X, the size of one of two first power connection lines PL12 in the second direction X is Xb1, the size of the other of the two first power connection lines PL12 in the second direction X is Xb2, and the value range of (Xb1+Xb2)/WO is [0.08, 0.48], so as to enhance the leveling effect of the first power connection line PL12 on the bottom surfaces of the pixel openings of the sub-pixel 131 and the sub-pixel 132, improve the flatness of the light-emitting layers, and alleviate the color shift, for example, alleviate the color shift of the left and right viewing angles. Fig. 28 shows the size WO1 of the pixel opening P0 of the sub-pixel 131 in the second direction X and the size WO2 of the pixel opening P0 of the sub-pixel 132 in the second direction X. The size WO of the sub-pixel 100 in the second direction X can be one of the size WO1 and the size WO2, or the average of them. For example, one of the sub-pixel 131 and the sub-pixel 132 can be a red sub-pixel, and the other of the sub-pixel 131 and the sub-pixel 132 can be a green sub-pixel. The embodiment of the present disclosure is illustrated by taking that the sub-pixel 131 is a green sub-pixel and the sub-pixel 132 is a red sub-pixel as an example.

For example, in some embodiments, Xb1=6 microns, Xb2=54 microns, WO=163 microns, and the value of (Xb1+Xb2)/WO is 0.37. The values of Xb1, Xb2 and WO are not limited to the above examples, as long as the value range of (Xb1+Xb2)/WO is [0.08, 0.48].

For example, in some embodiments, the sub-pixels include a red sub-pixel, a green sub-pixel, and a blue sub-pixel, and the blue sub-pixel can be as shown in Fig. 25, while the red sub-pixel and the green sub-pixel can be as shown in Fig. 26.

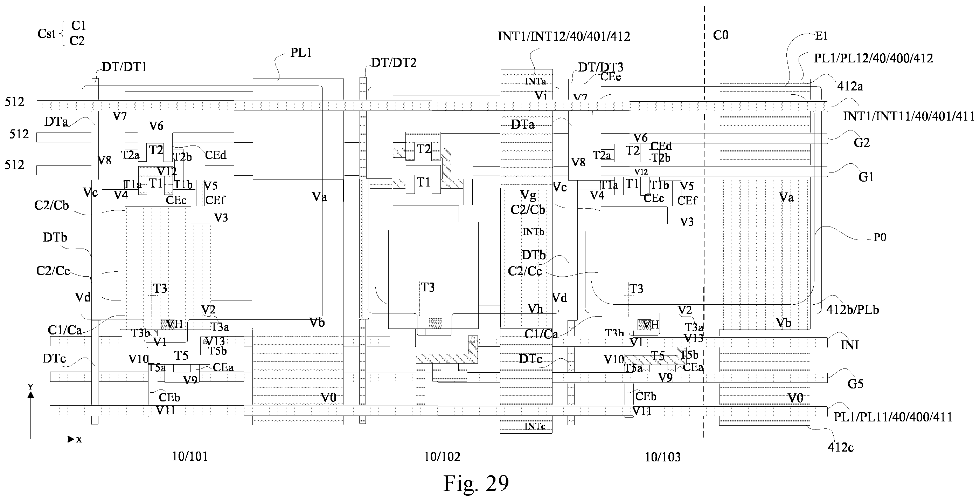

Fig. 29 is a layout diagram of a display substrate provided by an embodiment of the present disclosure. Compared with the display substrate shown in Fig. 24, in the display substrate shown in Fig. 29, the initialization connection line INT12 is located in the second sub-pixel 102, and two first power connection lines PL12 are located in the first sub-pixel 101 and the third sub-pixel 103, respectively. That is, one first power connection line PL12, the initialization connection line INT12, and another first power connection line PL12 are sequentially arranged in the second direction X. It should be noted that the setting mode of the initialization connection line INT12 is not limited to that shown in the figure, as long as the plurality of initialization signal lines INT11 arranged in the first direction Y can be connected; the setting mode of the first power connection line PL12 is not limited to that shown in the figure, as long as the plurality of first power signal lines PL11 arranged in the first direction Y can be connected; and the setting modes of the initialization connection line INT12 and the first power connection line PL12 can be determined as needed.

Referring to Fig. 24 and Fig. 29, the first power connection line PL12 and the initialization connection line INT12 play a role of leveling the sub-pixel, and the size of the first power connection line PL12 in the second direction X is about half of the size of the pixel opening P0 overlapping with the first power connection line PL12 in the second direction X. The size of the initialization connection line INT12 in the second direction X is less than half of the size of the pixel opening P0 overlapping with the initialization connection line INT12 in the second direction X, so as to take into account the design of the storage capacitor in the second sub-pixel 102 and provide space for the storage capacitor.

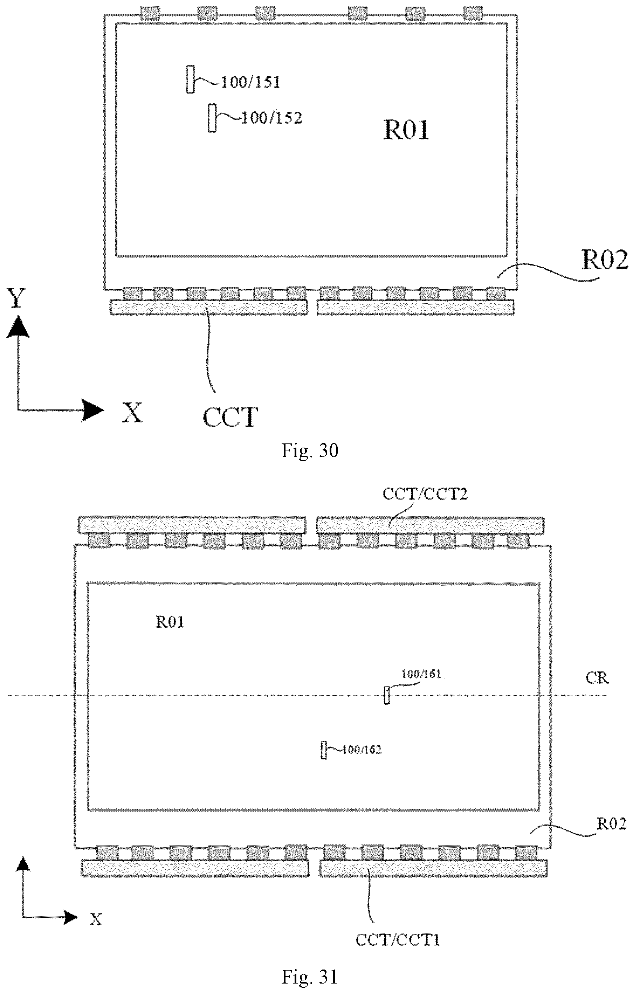

Fig. 30 is a schematic diagram of a display substrate provided by an embodiment of the present disclosure. For example, as shown in Fig. 30, the display substrate further includes a driving circuit CCT, the driving circuit CCT is located at one side of the display substrate, one sub-pixel 100 (sub-pixel 151) away from the driving circuit CCT has a first brightness L1; one sub-pixel 100 (sub-pixel 152) close to the driving circuit CCT has a second brightness L2, and the value range of |L1-L2| is [1, 9], where the unit of brightness is nits. The brightness difference between sub-pixels with different distances from the driving circuit CCT is reduced, and for example, less than or equal to 9 nits; and the current uniformity of the display substrate is improved, so that the voltage drop meets the design requirements. Fig. 30 shows two driving circuits CCT located at the same side of the display substrate. The sub-pixel 151 and the sub-pixel 152 have different distances from the driving circuit CCT in the first direction Y, and the distance between the sub-pixel 151 and the sub-pixel 152 in the second direction X is not limited. The driving circuit CCT can be a driving integrated circuit (IC).

For example, referring to Fig. 28 and Fig. 30, because the display substrate satisfies that the value range of (Xb1+Xb2)/WO is [0.08, 0.48], the problem of voltage drop and the problem of color shift can be solved; and the brightness difference can be reduced, and for example, the value range of |L1-L2| can be [1, 9]. That is, some display substrates satisfy that the value range of (Xb1+Xb2)/WO is [0.08, 0.48] and the value range of |L1-L2| is [1, 9].

Fig. 31 is a schematic diagram of a display substrate provided by an embodiment of the present disclosure. For example, as shown in Fig. 31, the display substrate further includes two driving circuits CCT, the two driving circuits CCT (driving circuit CCT1 and driving circuit CCT2) are located at opposite sides of the display region R01 of the display substrate, the sub-pixel 100 at the central axis of the display substrate has a third brightness L3, one sub-pixel 100 close to one of the two driving circuits CCT has a fourth brightness L4, and the value range of |L3-L4| is [1, 9], where the unit of brightness is nits. The brightness difference between sub-pixels with different distances from the driving circuit CCT is reduced, and the current uniformity of the display substrate is improved, so that the voltage drop meets the design requirements. Fig. 31 shows the central axis CR extending in the second direction X. As shown in Fig. 31, the extending direction of the central axis CR is the same as the extending direction of the driving circuit CCT. As shown in Fig. 31, the central axis CR is located between the two driving circuits CCT. The sub-pixel 161 and the sub-pixel 162 have different distances from one of the two driving circuits CCT in the first direction Y, and the distance between the sub-pixel 161 and the sub-pixel 162 in the second direction X is not limited.

For example, referring to Fig. 28 and Fig. 31, because the display substrate satisfies that the value range of (Xb1+Xb2)/WO is [0.08, 0.48], the problem of voltage drop and the problem of color shift can be solved; and the brightness difference can be reduced, and for example, the value range of |L1-L2| can be [1, 9]. That is, some display substrates satisfy that the value range of (Xb1+Xb2)/WO is [0.08, 0.48] and the value range of |L1-L2| is [1, 9].

In some embodiments, the display substrate satisfies that the value range of |L1-L2| is [1, 9], and satisfies that the value range of |L3-L4| is [1, 9].

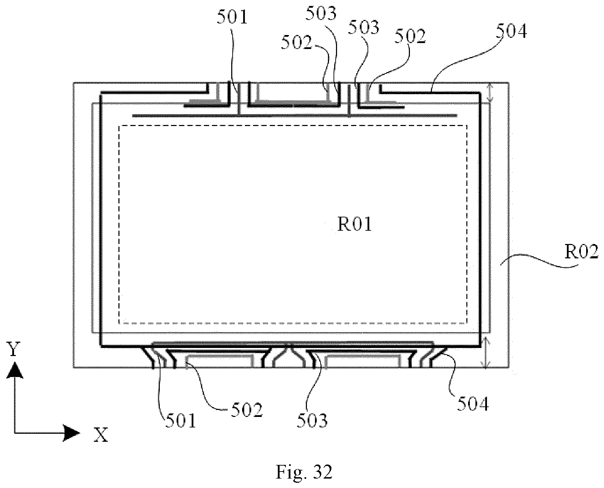

Fig. 32 is a schematic diagram of a display substrate provided by an embodiment of the present disclosure. For example, as shown in Fig. 32, the display substrate includes a power bus 501, a power bus 502, an initialization bus 503, and an initialization bus 504. For example, the power bus 501 is connected to the first power line PL1, the power bus 502 is connected to the second power line PL2, the initialization bus 503 is connected to the initialization line INT1, and the initialization bus 504 is connected to the initialization line INT2. The display substrate shown in Fig. 32 is provided with a driving circuit on the lower side thereof. It should be noted that the setting positions of the power bus 501, the power bus 502, the initialization bus 503, and the initialization bus 504 are not limited to those shown in the figure. Fig. 30-Fig. 32 show a display region R01.

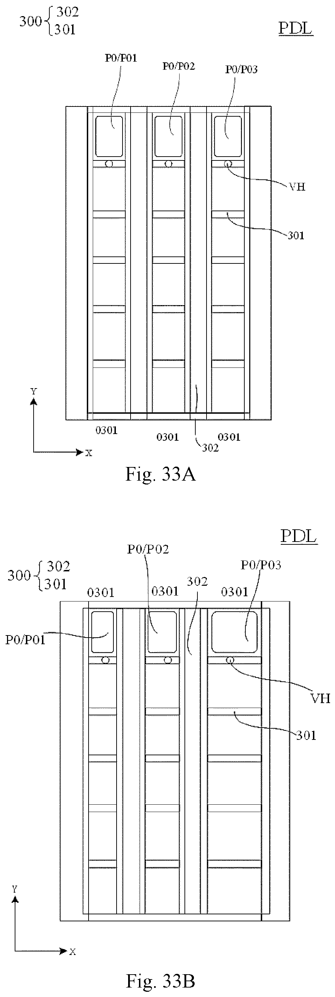

Fig. 33A is a plan view of a pixel defining layer in a display substrate provided by an embodiment of the present disclosure. Fig. 33B is a plan view of a pixel defining layer in a display substrate provided by an embodiment of the present disclosure. For example, as shown in Fig. 33A and Fig. 33B, the pixel defining layer PDL includes a plurality of first defining portions 301 and a plurality of second defining portions 302, the plurality of second defining portions 302 are arranged in the second direction X, each of the plurality of second defining portions 302 extends in the first direction Y, the plurality of first defining portions 301 are arranged as a plurality of groups 0301, each group of first defining portions 301 is located between two adjacent second defining portions 302, each of the plurality of first defining portions 301 extends in the second direction X, and the first defining portions 301 in each group are arranged in the first direction Y.

As shown in Fig. 33A and Fig. 33B, a groove is formed between two adjacent second defining portions 302, and each groove extends in the first direction Y. During inkjet printing, ink flows in the groove. Taking that the first direction Y is the column direction and the second direction X is the row direction as an example, the display substrate includes a plurality of columns of grooves. One column of grooves defines multiple pixel openings P0.

As shown in Fig. 6, Fig. 33A and Fig. 33B, the maximum height H1 from the first defining portion 301 to the planarization layer PLN is less than the maximum height H2 from the second defining portion 302 to the planarization layer PLN. That is, the thickness of the first defining portion 301 is less than the thickness of the second defining portion 302.

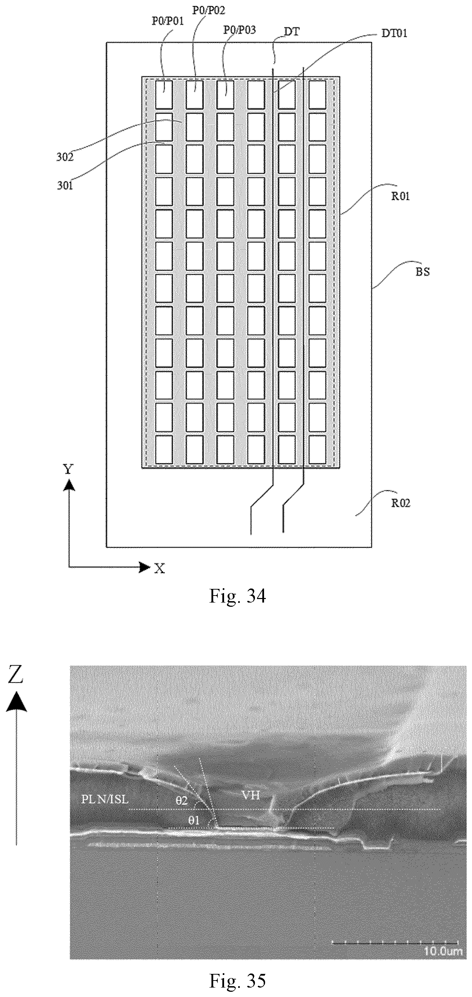

Fig. 34 is a schematic diagram of a display substrate provided by an embodiment of the present disclosure. As shown in Fig. 34, the base substrate BS includes a display region R01 and a peripheral region R02 located on at least one side of the display region R01. As shown in Fig. 34, the orthographic projection of the part DT01 of the data line DT located in the display region R01 on the base substrate BS is located within the orthographic projection of the second defining portion 302 on the base substrate BS. The orthographic projection of the data line DT on the base substrate BS overlaps with the orthographic projection of the second defining portion 302 of the pixel defining layer PDL on the base substrate BS, so that the second defining portion 302 have a protrusion to facilitate the ink to flow into the pixel opening in the pixel defining layer during inkjet printing. As shown in Fig. 34, the orthographic projection of the display region R01 on the base substrate BS overlaps with the orthographic projection of the pixel defining layer PDL on the base substrate BS. The orthographic projection of the pixel opening P0 of the pixel defining layer PDL on the base substrate BS falls within the orthographic projection of the display region R01 on the base substrate BS.

Fig. 34 shows only two data lines DT. For example, one second defining portion 302 can correspond to one data line, but it is not limited thereto.

In the embodiment of the present disclosure, the pixel circuit is not limited to that shown in the given circuit diagram, and other suitable pixel circuits can be adopted; and the layout of the display substrate is not limited to that shown in the given layout diagram, and can be adjusted on the basis of the given layout diagram, or other layout manners can be adopted.

For example, as shown in Fig. 34, a first defining portion 301 is arranged between two pixel openings P0 that are adjacent to each other in the first direction Y, a second defining portion 302 is arranged between two pixel openings P0 that are adjacent to each other in the second direction X, and the first direction Y intersects with the second direction X. As shown in Fig. 6, the thickness of the first defining portion 301 is H1, the thickness of the second defining portion 302 is H2, and H1≠H2. For example, H1 is less than H2.

Fig. 35 is an electron micrograph of a display substrate provided by an embodiment of the present disclosure. As shown in Fig. 35, at the via hole VH, the slope angle of the bottom angle θ1 is in the range of 65-75 degrees; the slope angle θ2 is in the range of 45-55 degrees. The slope angle θ2 is a slope angle of the planarization layer PLN at the via hole VH in the case where a reference plane (at half the thickness of the planarization layer PLN) serves as the bottom surface. The bottom angle θ1 is an included angle between the planarization layer PLN at the bottom surface of the via hole VH and the structure below the planarization layer PLN.

For example, as shown in Fig. 6 and Fig. 35, the display substrate further includes an insulating layer ISL; the light-emitting element 100b includes a first electrode E1, a second electrode E2, and a light-emitting functional layer FL located between the first electrode E1 and the second electrode E2; and the first electrode E1 of the light-emitting element 100b is connected to the pixel circuit 100a through the via hole VH penetrating the insulating layer ISL.

For example, as shown in Fig. 6, the display substrate further includes an encapsulation layer EPS, the encapsulation layer EPS is configured to encapsulate the light-emitting element 100b, and the encapsulation layer EPS includes a stack of an inorganic encapsulation film and an organic encapsulation film. As shown in Fig. 6, the encapsulation layer EPS includes an inorganic encapsulation film EPS1, an organic encapsulation film EPS2, and an inorganic encapsulation film EPS3. It should be noted that the stacking order of the organic encapsulation film and the inorganic encapsulation film is not limited to that shown in the figure, nor is the structure of the encapsulation layer EPS limited to that shown in the figure.

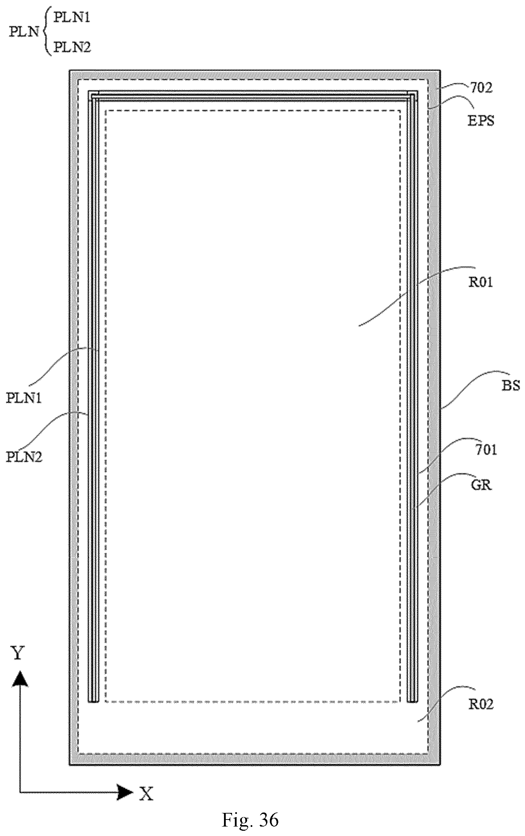

Fig. 36 is a schematic diagram of a display substrate provided by an embodiment of the present disclosure. For example, as shown in Fig. 36, the display substrate further includes a barrier dam 701, an encapsulation adhesive 702 is provided at an outer side of the encapsulation layer EPS, and the encapsulation adhesive 702 plays a bonding role. Fig. 36 shows the encapsulation layer EPS with the boundary of the encapsulation layer EPS. As shown in Fig. 6 and Fig. 36, the insulating layer ISL includes a planarization layer PLN, the planarization layer PLN includes a first planarization portion PLN1 and a second planarization portion PLN2, a groove GR is arranged between the first planarization portion PLN1 and the second planarization portion PLN2, the barrier dam 701 is located at the periphery of the display region R01 of the display substrate, and the orthographic projection of the barrier dam 701 on the base substrate BS covers the orthographic projection of the groove GR on the base substrate BS, so as to alleviate or prevent water and oxygen from entering the display region along the planarization layer PLN, and avoid affecting the light-emitting elements in the display region R01. Of course, in some other embodiments, the orthographic projection of the barrier dam 701 on the base substrate BS may not cover the orthographic projection of the groove GR on the substrate BS.

For example, the minimum distance between the edge of the display region R01 and the edge of the peripheral region R02 ranges from 1 mm to 5 mm. That is, the size of the bezel ranges from 1 mm to 5 mm.

For example, in order to obtain a better effect of blocking water and oxygen, the groove GR is a through hole penetrating the planarization layer PLN. As shown in Fig. 36, the portion of the planarization layer PLN located at the inner side of the groove GR is the first planarization portion PLN1, and the portion of the planarization layer PLN located at the outer side of the groove GR is the second planarization portion PLN2. Fig. 36 shows the first planarization portion PLN1 with the boundary of the first planarization portion PLN1 and the second planarization portion PLN2 with the boundary of the second planarization portion PLN2. Fig. 36 is illustrated by taking the case of providing one groove GR as an example, but the number of grooves GR is not limited to one, and can be set as needed. The number of grooves GR depends on the narrow degree of narrow bezel. The narrower the bezel, the fewer the number of grooves GR. Of course, in some other embodiments, the groove GR may not be provided.

For example, as shown in Fig. 3-Fig. 5, the display substrate further includes a data line DT, a gate line G1, a gate line G2 and an initialization line INT1, the pixel circuit 100a further includes a data writing transistor T1 and a reset transistor T2, the first electrode of the data writing transistor T1 is connected to the data line DT, the gate electrode of the driving transistor T3 is connected to the second electrode of the data writing transistor T1, the gate electrode of the data writing transistor T1 is connected to the gate line G1, the first electrode of the reset transistor T2 is connected to the initialization line INT1, the second electrode of the reset transistor T2 is connected to the gate electrode of the driving transistor T3, and the gate electrode of the reset transistor T2 is connected to the gate line G2.

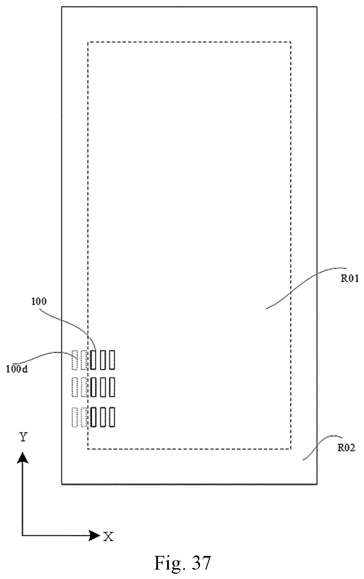

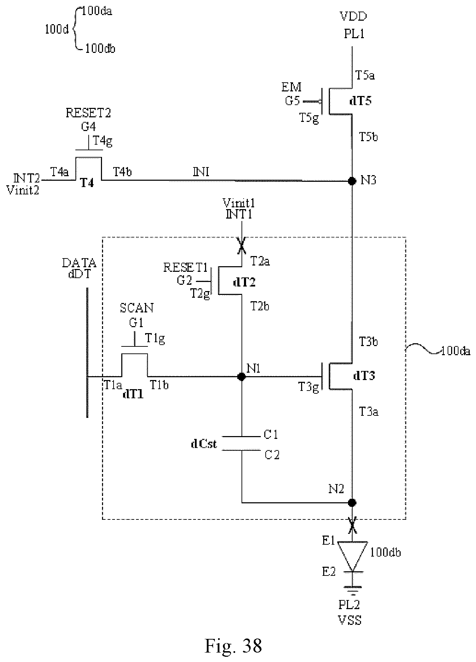

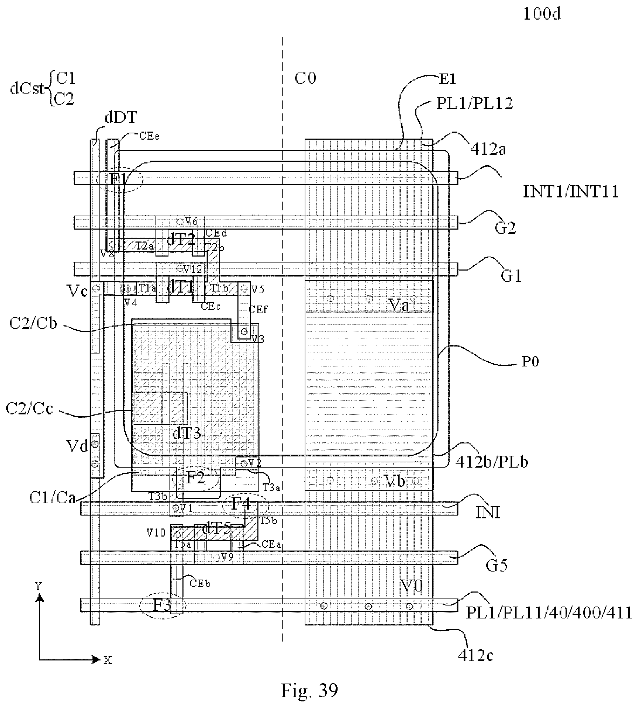

Fig. 37 is a schematic diagram of a display substrate provided by an embodiment of the present disclosure. Fig. 38 is a schematic circuit diagram of a dummy sub-pixel in a display substrate provided by an embodiment of the present disclosure. Fig. 39 is a layout diagram of a dummy pixel circuit in a display substrate provided by an embodiment of the present disclosure.

As shown in Fig. 37, a dummy sub-pixel 100d is arranged in the vicinity of an edge of the display substrate. For the sake of clarity, Fig. 37 does not show all dummy sub-pixels nor all sub-pixels 100. As shown in Fig. 37, the dummy sub-pixel 100d is located in the peripheral region R02, and the sub-pixel 100 is located in the display region R01. The dummy sub-pixel 100d does not emit light, and providing the dummy sub-pixel 100d can improve etching uniformity and improve the display quality.

As shown in Fig. 38, the dummy sub-pixel 100d is provided with a dummy driving transistor dT3 and a dummy reset transistor dT2, the dummy reset transistor dT2 is connected to the gate electrode of the dummy driving transistor dT3, and the dummy reset transistor dT2 is disconnected from the initialization line INT1, so as to reduce power consumption. The dummy sub-pixel 100d is provided to improve the etching uniformity, instead of realizing the luminescent function. As shown in Fig. 38, the dummy sub-pixel 100d includes a dummy pixel circuit 100da and a dummy light-emitting element 100db. As shown in Fig. 38, the composition of the dummy pixel circuit 100da can refer to the composition of the pixel circuit 100a, and the composition of the dummy light-emitting element 100db can refer to the composition of the light-emitting element 100b. But the dummy pixel circuit 100da may have a disconnected line therein. The dummy pixel circuit 100da shown in Fig. 38 is illustrated by taking the example that the first electrode E1 of the dummy light-emitting element 100db is not connected to the node N2 (first electrode T3a of the dummy driving transistor dT3) and the dummy reset transistor dT2 is not connected to the initialization line INT1. In some other embodiments, other disconnection methods can be used to make the dummy sub-pixel 100d not emit light. A bold cross in Fig. 38 indicates disconnection. For example, in order to disconnect the dummy reset transistor dT2 of the dummy sub-pixel 100d from the initialization line INT1, a via hole may not be provided.

As shown in Fig. 38, the dummy sub-pixel 100d further includes a dummy data writing transistor dT1. Fig. 38 and Fig. 39 further show a dummy data line dDT.

As shown in Fig. 38, the dummy sub-pixel 100d further includes a dummy storage capacitor dCst.

In the embodiment of the present disclosure, the components in the dummy sub-pixel 100d are given new reference numerals except the main components such as transistors and storage capacitors, etc., and the reference numerals of other components can refer to those in the sub-pixel 100.

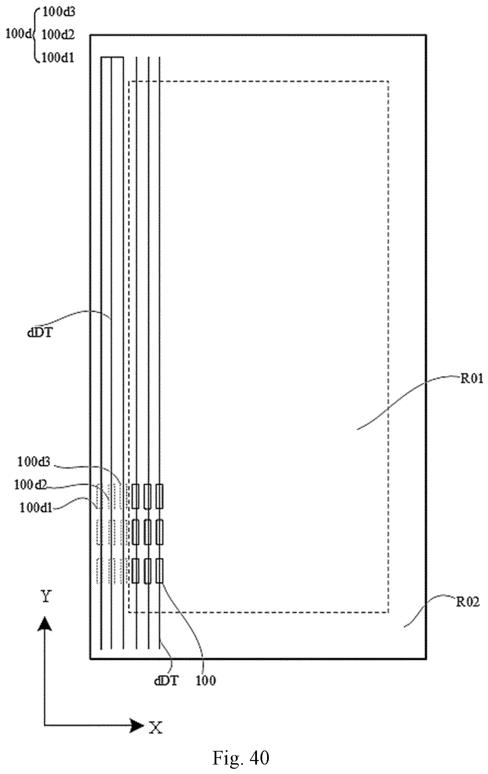

Fig. 40 is a schematic diagram of a display substrate provided by an embodiment of the present disclosure. For example, as shown in Fig. 40, the display substrate further includes a dummy data line dDT, the dummy data line dDT extends in the first direction Y, the dummy data line dDT and the data line DT are insulated from each other, the dummy sub-pixel 100d includes at least two dummy sub-pixels 100d that are adjacent to each other in the second direction X, and the dummy data lines dDT of the at least two dummy sub-pixels 100d are connected to each other. As shown in Fig. 40, the dummy data line dDT is located in the peripheral region R02. As shown in Fig. 40, the peripheral region R02 surrounds the display region R01.

For example, the dummy data line dDT is connected to a constant voltage terminal, so as to be configured to provide a constant voltage. For example, the constant voltage terminal includes a terminal that provides the first voltage signal VDD, a terminal that provides the second voltage signal VSS, or a terminal that provides the initialization signal Vinit1. For example, the dummy data line dDT is connected to the first power line PL1, the second power line PL2, or the initialization line INT1. The dummy data line dDT is connected to the constant voltage terminal, which is beneficial to reducing the resistance of the power line connected to the constant voltage terminal and improve the display quality.

For example, as shown in Fig. 40, the at least two dummy sub-pixels 100d include a first dummy sub-pixel 100d1, a second dummy sub-pixel 100d2, and a third dummy sub-pixel 100d3, and three dummy data lines dDT of the first dummy sub-pixel 100d1, the second dummy sub-pixel 100d2, and the third dummy sub-pixel 100d3 are connected to each other. Fig. 40 shows three dummy data lines dDT connected to each other.

For example, as shown in Fig. 3-Fig. 5, the display substrate further includes a first power line PL1, the pixel circuit 100a further includes a light-emitting control transistor T5, the first electrode of the light-emitting control transistor T5 is connected to the first power line PL1, and the second electrode of the light-emitting control transistor T5 is connected to the second electrode of the driving transistor T3.

For example, as shown in Fig. 38 and Fig. 39, the dummy sub-pixel 100d further includes a dummy light-emitting control transistor dT5, the first electrode of the dummy light-emitting control transistor dT5 is disconnected from the first power line PL1, and the second electrode of the dummy light-emitting control transistor dT5 is connected to or disconnected from the second electrode of the dummy driving transistor dT3.

As shown in Fig. 39, in the dashed frame F1 (corresponding to the via hole V7 in Fig. 5), no via hole is provided, so that the dummy reset transistor dT2 is disconnected from the initialization line INT1. As shown in Fig. 39, in the dashed frame F2 (corresponding to the via hole VH in Fig. 5), no via hole is provided, so that the dummy pixel circuit 100da is disconnected from the dummy light-emitting element 100db. As shown in Fig. 39, in the dashed frame F3 (corresponding to the via hole V11 in Fig. 5), no via hole is provided, so that the first electrode of the dummy light-emitting control transistor dT5 is disconnected from the first power line PL1. As shown in Fig. 39, in the dashed frame F4 (corresponding to the via hole V13 in Fig. 5), no via hole is provided, so that the second electrode of the dummy light-emitting control transistor dT5 is disconnected from the second electrode of the dummy driving transistor dT3. Of course, in order to make the second electrode of the dummy light-emitting control transistor dT5 and the second electrode of the dummy driving transistor dT3 connected, it is necessary to provide a via hole at the corresponding position, the same situation applies as at other positions.

For example, as shown in Fig. 5, Fig. 6, Fig. 33A and Fig. 33B, the display substrate further includes a pixel defining layer PDL, the pixel defining layer PDL includes a defining portion 300, the pixel opening P0 is defined by the defining portion 300, the light-emitting element 100b includes a first electrode E1 and a light-emitting functional layer FL, the pixel defining layer PDL is configured to expose at least a part of the first electrode E1, and at least a part of film layers in the light-emitting functional layer FL covers the sidewall SW of the defining portion 300 (as shown in Fig. 6). Fig. 6 is illustrated by taking that the light-emitting functional layer FL is located in the pixel opening P0 as an example. In some other embodiments, the light-emitting functional layer FL can include a common layer, as shown in Fig. 45.

For example, as shown in Fig. 6, the light-emitting element 100b further includes a second electrode E2, the light-emitting functional layer FL is located between the first electrode E1 and the second electrode E2, and the second electrode E2 is in contact with the top wall of the defining portion 300. Of course, as shown in Fig. 45, in the case where the light-emitting functional layer FL includes a common layer, the second electrode E2 is in contact with the common layer in the light-emitting functional layer FL. For example, the second electrode E2 is in contact with a common layer, close to the second electrode E2, in the light-emitting functional layer FL. The common layer in Fig. 45 is an electron injection layer EIL. As shown in Fig. 6 and Fig. 45, the orthographic projection of the second electrode E2 on the base substrate BS overlaps with the orthographic projection of the top wall of the defining portion 300 on the base substrate BS.

For example, as shown in Fig. 6, the display substrate further includes an insulating layer ISL, the first electrode E1 of the light-emitting element 100b is connected to the pixel circuit 100a through a via hole VH penetrating the insulating layer ISL, and the orthographic projection of the via hole VH on the base substrate BS overlaps with the orthographic projection of the first defining portion 301 on the base substrate BS. As shown in Fig. 6, Fig. 33A and Fig. 33B, the defining portion 300 includes a first defining portion 301 and a second defining portion 302, and the thickness H1 of the first defining portion 301 is less than the thickness H2 of the second defining portion 302.

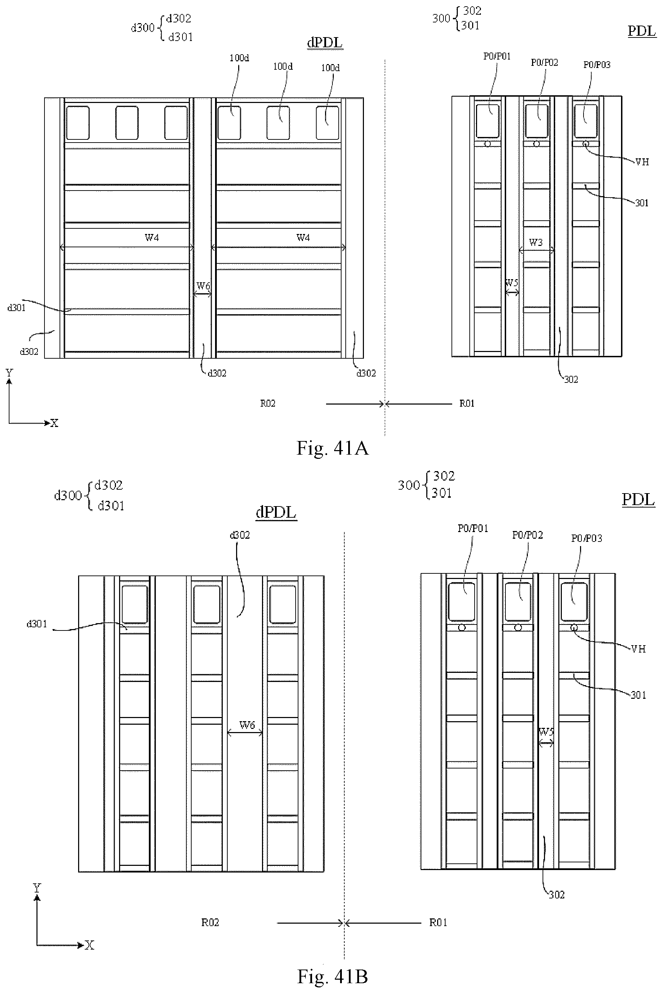

Fig. 41A is a schematic diagram of a display substrate provided by an embodiment of the present disclosure. For example, as shown in Fig. 41A, the display substrate further includes a dummy pixel defining layer dPDL, the dummy pixel defining layer dPDL includes a plurality of dummy defining portions d300 (second dummy defining portions d302) arranged in the second direction X, the extending direction of the second dummy defining portion d302 is the same as the extending direction of the second defining portion 302, and the spacing W4 between two adjacent dummy defining portions d300 (second dummy defining portions d302) is greater than the spacing W3 between two adjacent second defining portions 302. Fig. 41A further shows a plurality of first dummy defining portions d301 extending in the second direction X. As shown in Fig. 41, multiple first dummy defining portions d301 are provided between adjacent second dummy defining portions d302. Fig. 41A shows a display region R01 and a peripheral region R02. The spacing W4 is greater than the spacing W3, which is beneficial to the wiring of the peripheral region R02. For example, the spacing W4 can be a maximum spacing, that is, the maximum spacing W4 between two adjacent dummy defining portions d300 is greater than the maximum spacing W3 between two adjacent second defining portions 302. For example, the spacing W4 can be a minimum spacing, that is, the minimum spacing W4 between two adjacent dummy defining portions d300 is greater than the minimum spacing W3 between two adjacent second defining portions 302. Fig. 41A is illustrated by taking that three columns of dummy sub-pixels 100d are provided between two adjacent second dummy defining portions d302 as an example, but it is not limited to this case, and one column, two columns or more than three columns of dummy sub-pixels 100d can be provided between two adjacent second dummy defining portions d302. That is, at least one column of dummy sub-pixels 100d is provided between two adjacent second dummy defining portions d302.

It should be noted that in Fig. 41A takes that the peripheral region R02 is provided with the first dummy defining portion d301 extending in the second direction X as an example, but it is not limited to this case. In some embodiments, the peripheral region R02 may not be provided with the first dummy defining portion d301. In this case, the dummy pixel defining layer dPDL only includes the second dummy defining portion d302.

For example, as shown in Fig. 41A, the spacing W4 between two adjacent dummy defining portions d300 is 2-20 times the spacing W3 between two adjacent second defining portions 302. In the case where a plurality of columns of dummy sub-pixels 100d are provided between two adjacent second defining portions 302, the spacing W4 can be multiplied by the spacing W3.

As shown in Fig. 41A, the width W6 of the second dummy defining portion d302 in the second direction X is greater than the width W5 of the second defining portion 302 in the second direction X. For example, the width W6 and the width W5 can refer to the maximum widths. Of course, the width W6 and the width W5 can also refer to the minimum widths.

Fig. 41B is a schematic diagram of a display substrate provided by another embodiment of the present disclosure. As shown in Fig. 41B, the width W6 is greater than the width W5, which can refer to the description of Fig. 41A. Fig. 41B is illustrated by taking that one column of dummy sub-pixels 100d is provided between two adjacent second dummy defining portions d302 as an example. The dummy pixel defining layer dPDL in Fig. 41B may include only the second dummy defining portion d302, and the first dummy defining portion d301 may not be provided.

Of course, in some other embodiments, the width W6 can be equal to the width W5.

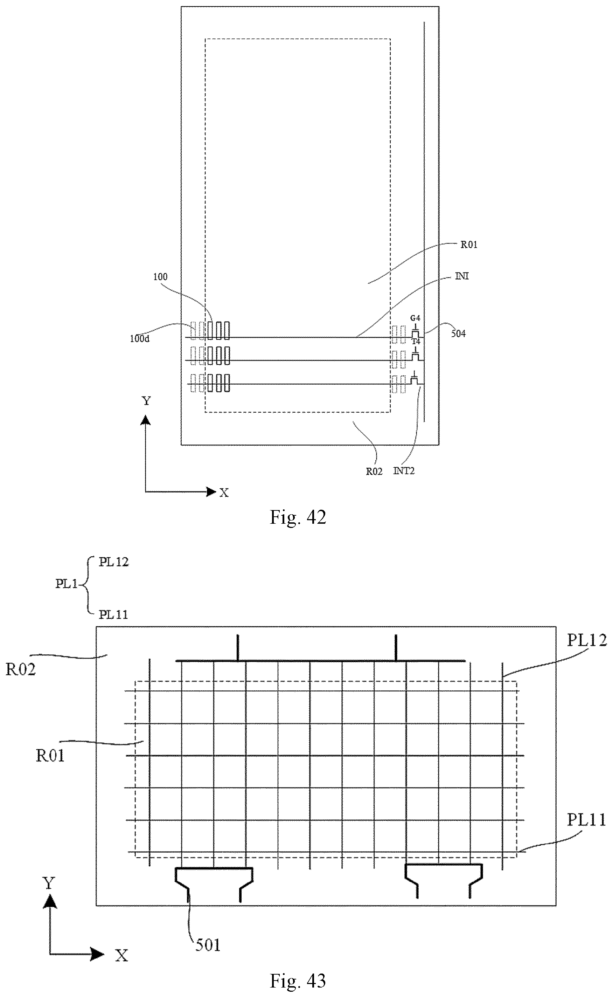

Fig. 42 is a schematic diagram of a display substrate provided by an embodiment of the present disclosure. For example, as shown in Fig. 3-Fig. 5 and Fig. 42, the display substrate further includes a reset transistor T4, an initialization line INT2, and an initialization bus 504, the initialization bus 504 is arranged at the outer side of the display region R01 of the display substrate, the first electrode of the reset transistor T4 is connected to the initialization bus 504, the first electrode T4a of the reset transistor T4 is connected to the initialization bus 504 through the initialization line INT2, the second electrode T4b of the reset transistor T4 is connected to the light-emitting element 100b through the driving transistor T3, and the reset transistor T4 is connected to a row of sub-pixels 100. In terms of the same row of sub-pixels, in order to reduce power consumption, the number (a count) of reset transistors T4 is less than the number (a count) of sub-pixels 100. Fig. 42 is illustrated by taking that one row of sub-pixels corresponds to one reset transistor T4 as an example.

As shown in Fig. 42, the second electrode of the reset transistor T4 is connected to the reset signal transmission line INI. As shown in Fig. 42, the reset signal transmission line INI is connected to the sub-pixel 100. As shown in Fig. 5, the reset signal transmission line INI is connected to the first electrode E1 of the light-emitting element 100b through the driving transistor T3. Referring to Fig. 5-Fig. 8E, the second electrode T5b of the light-emitting control transistor T5 and the second electrode T3b of the driving transistor T3 are connected through the reset signal transmission line INI.

As shown in Fig. 42, the reset transistor T4 is located in the peripheral region R02. As shown in Fig. 42, the initialization bus 504 is located in the peripheral region R02.

Fig. 43 is a schematic diagram of a display substrate provided by an embodiment of the present disclosure. For example, as shown in Fig. 5 and Fig. 43, the display substrate further includes a light-emitting control transistor T5, a first power line PL1, and a first power bus 501, the first power line PL1 is configured to provide a first voltage signal to the pixel circuit 100a, the first power line PL1 is connected to the first power bus 501, the first power line PL1 includes a first power connection line PL12 extending in the first direction Y and a first power signal line PL11 extending in the second direction X, the first electrode of the light-emitting control transistor T5 is connected to the first power line PL1, the second electrode of the light-emitting control transistor T5 is connected to the second electrode of the driving transistor T3, and the number (a count) of light-emitting control transistors T5 of sub-pixels 100 in one row can be equal to the number (a count) of sub-pixels 100 in the row.

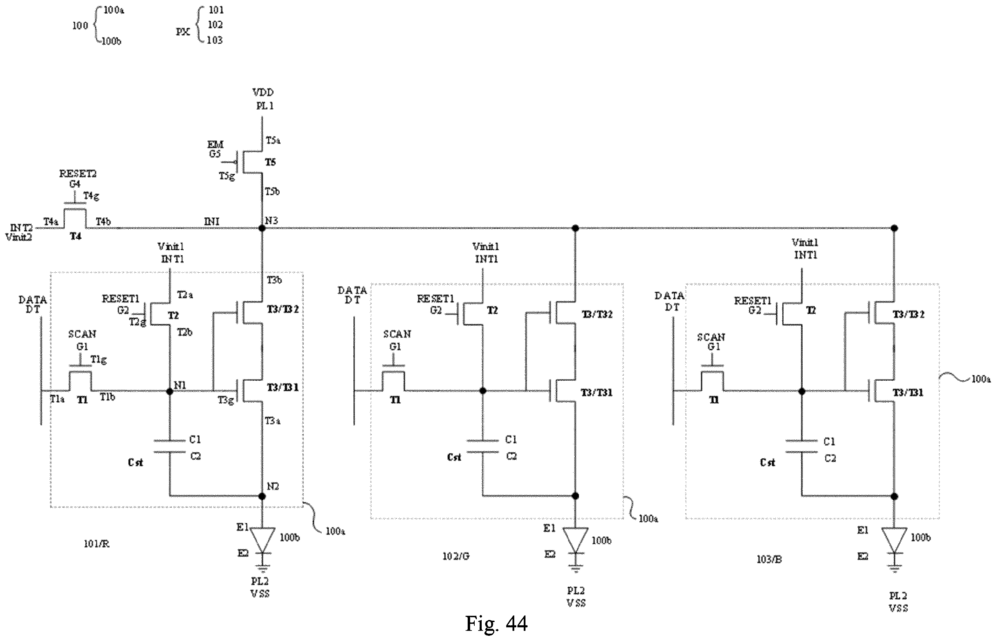

Fig. 44 is a circuit diagram of a display substrate provided by an embodiment of the present disclosure. As shown in Fig. 44, the number (a count) of light-emitting control transistors T5 of sub-pixels 100 in one row is less than the number (a count) of sub-pixels 100 in the row. For example, three sub-pixels 100 in one pixel PX are all connected to the same light-emitting control transistor T5.

For example, in the case where three sub-pixels 100 in each pixel PX are connected to the same light-emitting control transistor T5 and different pixels PX are connected to different light-emitting control transistors T5, the number (a count) of light-emitting control transistors T5 of sub-pixels 100 in one row is greater than the number (a count) of reset transistors T4 in the row.

Referring to Fig. 3-Fig. 6 and Fig. 9-Fig. 14, the embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca, and the display substrate satisfies the following relationship: a value range of $(W*L+S2)*M1/M2$ is $[0.014, 0.133]$ and $P= k0*(W/L)*Uc$, where a value range of k0 is $[2.8*E-07, 5.8*E-06]$, W is the width of the channel of the driving transistor T3, L is the length of the channel of the driving transistor T3, S2 is the facing area between the second electrode plate Cb and the first electrode plate Ca, M1 is the number (a count) of pixel openings P0 in the display substrate, M2 is the area of the display substrate, Uc is the cross voltage of the light-emitting element 100b, and P is power consumption of the sub-pixel 100.

The display substrate provided by the embodiment of the present disclosure satisfies the following relationship: the value range of $(W*L+S2)*M1/M2$ is $[0.014, 0.133]$, and $P=k0*(W/L)*Uc$, which is helpful to obtain a display substrate with lower power consumption.

Referring to Fig. 3-Fig. 6, Fig. 9-Fig. 14, Fig. 33A, Fig. 33B and Fig. 34, the embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca, a first defining portion 301 is arranged between two pixel openings P0 that are adjacent to each other in the first direction Y, a second defining portion 302 is arranged between two pixel openings P0 that are adjacent to each other in the second direction X, and the first direction Y intersects with the second direction X; the thickness of the first defining portion 301 is H1, the thickness of the second defining portion 302 is H2, and $H1 \neq H2$; the display substrate satisfies the following relationship: $P=k0*(W/L)*Uc$, where a value range of k0 is $[2.8*E-07, 5.8*E-06]$, W is the width of the channel of the driving transistor T3, L is the length of the channel of the driving transistor T3, Uc is the cross voltage of the light-emitting element 100b, and P is power consumption of the sub-pixel 100.

Referring to Fig. 3-Fig. 6, Fig. 9-Fig. 14, Fig. 33A, Fig. 33B and Fig. 36, the embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca; the display substrate further includes an insulating layer ISL, a barrier dam 701, and an encapsulation layer EPS, the light-emitting element 100b includes a first electrode E1, a second electrode E2, and a light-emitting functional layer FL located between the first electrode E1 and the second electrode E2, the first electrode E1 of the light-emitting element 100b is connected to the pixel circuit 100a through a via hole VH penetrating the insulating layer ISL, the encapsulation layer EPS is configured to encapsulate the light-emitting element 100b, the encapsulation layer EPS includes a stack of an inorganic encapsulation film and an organic encapsulation film, an encapsulation adhesive 702 is provided at the outer side of the encapsulation layer EPS, the insulating layer ISL includes a planarization layer PLN, the planarization layer PLN includes a first planarization portion PLN1 and a second planarization portion PLN2, a groove GR is arranged between the first planarization portion PLN1 and the second planarization portion PLN2, the barrier dam 701 is located at the periphery of the display region R01 of the display substrate, and the orthographic projection of the barrier dam 701 on the base substrate BS covers the orthographic projection of the groove GR on the base substrate BS; the display substrate satisfies the following relationship: P=k0*(W/L)*Uc, where a value range of k0 is [2.8*E-07, 5.8*E-06], W is the width of the channel of the driving transistor T3, L is the length of the channel of the driving transistor T3, Uc is the cross voltage of the light-emitting element 100b, and P is power consumption of the sub-pixel 100.

The display substrate provided by the embodiment of the present disclosure satisfies the following relationship: P=k0*(W/L)*Uc, which is helpful to obtain a display substrate with lower power consumption; and the orthographic projection of the barrier dam 701 on the base substrate BS covers the orthographic projection of the groove GR on the base substrate BS, so as to alleviate or prevent the water and oxygen from entering the display region R01 along the planarization layer PLN and avoid affecting the light-emitting elements in the display region R01.

Referring to Fig. 3-Fig. 5 and Fig. 9-Fig. 13, the embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca, and the display substrate satisfies the following relationship: P=k0*(W/L)*Uc, where a value range of k0 is [2.8*E-07, 5.8*E-06], W is the width of the channel of the driving transistor T3, L is the length of the channel of the driving transistor T3, Uc is the cross voltage of the light-emitting element 100b, and P is power consumption of the sub-pixel 100.

The display substrate provided by the embodiment of the present disclosure satisfies the following relationship: P=k0*(W/L)*Uc, which is helpful to obtain a display substrate with lower power consumption; and the second electrode plate Cb is arranged in the same layer as the channel of the driving transistor T3, so as to improve the holding capacity of the capacitor, and be beneficial to increasing the area ratio of the storage capacitor to the pixel opening, increasing the area proportion of the storage capacitor, and improving the display quality.

The embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca; the display substrate further includes a data line DT, a gate line G1, a gate line G2, and an initialization line INT1, the pixel circuit 100a further includes a data writing transistor T1 and a reset transistor T2, the first electrode of the data writing transistor T1 is connected to the data line DT, the gate electrode of the driving transistor T3 is connected to the second electrode of the data writing transistor T1, the gate electrode of the data writing transistor T1 is connected to the gate line G1, the first electrode of the reset transistor T2 is connected to the initialization line INT1, the second electrode of the reset transistor T2 is connected to the gate electrode of the driving transistor T3, the gate electrode of the reset transistor T2 is connected to the gate line G2, a dummy sub-pixel 100d is arranged in the vicinity of an edge of the display substrate, the dummy sub-pixel 100d is provided with a dummy driving transistor dT3 and a dummy reset transistor dT2, the dummy reset transistor dT2 is connected to the gate electrode of the dummy driving transistor dT3, and the dummy reset transistor dT2 is disconnected from the initialization line INT1; the display substrate satisfies the following relationship: P=k0*(W/L)*Uc, where a value range of k0 is [2.8*E-07, 5.8*E-06], W is the width of the channel of the driving transistor T3, L is the length of the channel of the driving transistor T3, Uc is the cross voltage of the light-emitting element 100b, and P is power consumption of the sub-pixel 100.

The display substrate provided by the embodiment of the present disclosure satisfies the following relationship: P=k0*(W/L)*Uc, which is helpful to obtain a display substrate with lower power consumption; and the dummy reset transistor dT2 is disconnected from the initialization line INT1, which is beneficial to reducing power consumption.

The embodiments of the present disclosure further provide a display substrate, which includes a base substrate BS and a plurality of sub-pixels 100 disposed on the base substrate BS. The sub-pixel 100 includes a pixel circuit 100a and a light-emitting element 100b, the pixel circuit 100a includes a driving transistor T3 and a storage capacitor Cst, the storage capacitor Cst includes a first electrode plate Ca and a second electrode plate Cb, the first electrode plate Ca of the storage capacitor Cst is connected to the gate electrode of the driving transistor T3, and the second electrode plate Cb of the storage capacitor Cst is connected to the first electrode of the driving transistor T3; the light-emitting element 100b is electrically connected to the pixel circuit 100a, the pixel circuit 100a is configured to drive the light-emitting element 100b, the sub-pixel 100 includes a pixel opening P0, the pixel opening P0 is configured to define a light-emitting region of the sub-pixel 100, the orthographic projection of the storage capacitor Cst on the base substrate BS overlaps with the orthographic projection of the pixel opening P0 on the base substrate BS, the orthographic projection of the channel of the driving transistor T3 on the base substrate BS overlaps with the orthographic projection of the pixel opening P0 on the base substrate BS, the second electrode plate Cb is arranged in the same layer as the channel of the driving transistor T3, the second electrode plate Cb is closer to the base substrate BS than the first electrode plate Ca; the display substrate further includes a pixel defining layer PDL, the pixel defining layer PDL includes a defining portion 300, the pixel opening P0 is defined by the defining portion 300, the light-emitting element 100b includes a first electrode E1 and a light-emitting functional layer FL, the pixel defining layer PDL is configured to expose at least a part of the first electrode E1, the light-emitting functional layer FL covers the sidewall SW of the defining portion 300 (as shown in Fig. 6), and the display substrate satisfies the following relationship: $P=k0*(W/L)*Uc$, where a value range of k0 is [2.8*E-07, 5.8*E-06], W is the width of the channel of the driving transistor T3, L is the length of the channel of the driving transistor T3, Uc is the cross voltage of the light-emitting element 100b, and P is power consumption of the sub-pixel 100.

In the display substrate provided by the embodiment of the present disclosure, the light-emitting functional layer FL covers the sidewall SW of the defining portion 300, and the following relationship is satisfied: $P=k0*(W/L)*Uc$, which is helpful to obtain a display substrate with lower power consumption.

For example, in some embodiments, the first voltage signal VDD is 17V, the second voltage signal VSS is 2V, k0=2.8*E-07, W=2 microns, L=30 microns, Uc=15V, then according to $P=k0*(W/L)*Uc$, P=2.8*E-07 watts.

The above power consumption P is the power consumption of a single sub-pixel. For sub-pixels emitting light of different colors, different designs can be carried out to solve the power consumption matching problem of sub-pixels with different colors and reduce the power consumption of the whole panel. For example, for a red sub-pixel, a green sub-pixel, and a blue sub-pixel, the power consumption of the red sub-pixel is less than the power consumption of the green sub-pixel, and the power consumption of the green sub-pixel is less than the power consumption of the blue sub-pixel, so as to solve the problem of three-color power consumption matching and reduce the power consumption of the whole panel.

For example, in any of the above display substrates satisfying $P=k0*(W/L)*Uc$, the display substrate can further satisfy the following relationship: a value range of $(W*L+S2)*M1/M2$ is [0.014, 0.133], S2 is the facing area between the second electrode plate Cb and the first electrode plate Ca, M1 is the number (a count) of pixel openings P0 in the display substrate, and M2 is the area of the display substrate, so as to facilitate the formation of a display substrate with better performance using inkjet printing technology

For example, in the embodiment of the present disclosure, the display substrate can satisfy at least one of the following settings: a value range of $(W*L+S2)*M1/M2$ is [0.014, 0.133], a value range of $S2/(W*L)$ is [2.82, 28.85], and $P=k0*(W/L)*Uc$. The meanings of each formula can refer to the above descriptions, and details will not be repeated here.

In the embodiment of the present disclosure, "*" in the formula represents the multiplication sign, "/" is the division sign, a range [Mx, My] represents greater than or equal to Mx and less than or equal to My, Mx and My are numbers, and the numbers with E in [] are numerical values expressed by scientific counting method.

Fig. 45 is a schematic diagram of a display substrate provided by an embodiment of the present disclosure. As shown in Fig. 45, the light-emitting functional layer FL includes a hole injection layer HIL, a hole transport layer HTL, a light-emitting layer EML and an electron injection layer EIL, and the materials of the hole injection layer HIL, the hole transport layer HTL and the light-emitting layer EML are located in the pixel opening defined by the pixel definition layer PDL, while the electron injection layer EIL is a common layer. Fig. 45 further shows that the display substrate includes a light extraction layer (capping layer) CPL to facilitate the improvement of light extraction efficiency. For example, the hole injection layer HIL and the hole transport layer HTL can adopt a gradient doping mode, or can adopt a stack arrangement of single layers. Of course, the structure of the display substrate provided by the embodiment of the present disclosure is not limited to that shown in Fig. 45.

Fig. 46 is a schematic diagram of a brightness test of a display substrate provided by an embodiment of the present disclosure. As shown in Fig. 46, the display substrate includes a display region R01 and a peripheral region R02, and the sub-pixels are located in the display region R01. A plurality of test points are selected from the display region. Nine test points are selected in Fig. 46. And the brightness of each test point can be measured. Fig. 46 shows that the sub-pixels can be divided into a plurality of sub-pixel groups PG, and Fig. 46 shows a sub-pixel group PG1, a sub-pixel group PG2, and a sub-pixel group PG3. For example, in some embodiments, each sub-pixel group PG can correspond to one or more rows of sub-pixels. For example, in some embodiments, each sub-pixel group PG can correspond to one or more columns of sub-pixels.

As shown in Fig. 46, the first to third test points are three test points at different positions of the sub-pixel group PG1, the fourth to sixth test points are three test points at different positions of the sub-pixel group PG2, and the seventh to ninth test points are three test points at different positions of the sub-pixel group PG3.

For example, the brightness of the sub-pixels in each sub-pixel group PG can be the average of the brightness at the test points corresponding to the sub-pixel group PG. As shown in Fig. 46, the brightness of the sub-pixels in the sub-pixel group PG1 is the average of the brightness values of the first test point, the second test point, and the third test point; the brightness of the sub-pixels in the sub-pixel group PG2 is the average of the brightness values of the fourth test point, the fifth test point, and the sixth test point; the brightness of the sub-pixels in the sub-pixel group PG3 is the average of the brightness values of the seventh test point, the eighth test point, and the ninth test point.

As shown in Fig. 46, for the same sub-pixel group, the test point at the middle position can be in the middle of the test points close to the boundary of the display region. For example, the distance between the second test point and the first test point is equal to the distance between the second test point and the third test point. Accordingly, the distance between the fifth test point and the fourth test point is equal to the distance between the fifth test point and the sixth test point, and the distance between the eighth test point and the seventh test point is equal to the distance between the eighth test point and the ninth test point.

For example, as shown in Fig. 46, when testing the brightness of the whole display substrate, the distance between the fourth test point and the first test point is equal to the distance between the fourth test point and the seventh test point, the distance between the fifth test point and the second test point is equal to the distance between the fifth test point and the eighth test point, and the distance between the sixth test point and the third test point is equal to the distance between the sixth test point and the ninth test point, but it is not limited to this case.

As shown in Fig. 46, the following principles can be adopted when selecting test points. Fig. 46 shows the length Ly and width Lx of the display region R01. The distance Lx0 between the test point and the boundary of the display region R01 in the second direction X is greater than or equal to Lx/10, and the distance Ly0 between the test point and the boundary of the display region R01 in the first direction Y is greater than or equal to Ly/10.

As shown in Fig. 24 and Fig. 29, the data line DT includes a data line DT1, a data line DT2, and a data line DT3. The data line DT1 provides a data signal for the first sub-pixel 101, the data line DT2 provides a data signal for the second sub-pixel 102, and the data line DT3 provides a data signal for the third sub-pixel 103.

As shown in Fig. 5, Fig. 24 and Fig. 29, because the first power line PL1 and the initialization line INT1 of the pixel circuit 100a are formed by using two conductive pattern layers, parts of the first power line PL1 and parts of the initialization line INT1 extending in the first direction Y are all formed in segments. Parts of the first power line PL1 and parts of the initialization line INT1 extending in the second direction X are all located in the second conductive pattern layer LY2.

As shown in Fig. 5, Fig. 24 and Fig. 29, the signal connection line 412 includes at least one of a first power connection line PL12 and an initialization connection line INT12.

For example, as shown in Fig. 24 and Fig. 29, the display substrate further includes a data line DT, the data line DT is configured to provide a data voltage to the sub-pixel 100, and the orthographic projection of at least one of the signal connection line 412 and the data line DT on the base substrate BS overlaps with the orthographic projection of the pixel opening P0 of at least one sub-pixel among the plurality of sub-pixels 100 on the base substrate BS.

When inkjet printing is performed, the flatter the bottom surface of the pixel opening P0 of the sub-pixel 100 (i.e., the first electrode E1 of the light-emitting element), the more color shift can be alleviated or avoided, and the better the display effect of the display substrate.

The part, directly below the pixel opening P0, of the data line DT or the signal connection line 412 located in the second conductive pattern layer LY2 can play a role of leveling to improve the display quality.

For example, the signal connection line 412 includes at least one of a part of the first power line PL1 extending in the first direction Y and a part of the initialization line extending in the first direction Y.

For example, as shown in Fig. 5, Fig. 24 and Fig. 29, the signal connection line 412 and the signal transmission line 411 are connected through a via hole.

For example, as shown in Fig. 5, Fig. 24 and Fig. 29, in order to level the bottom surface of the pixel opening P0 of the sub-pixel 100, the display substrate further includes a signal transmission line 512, the signal transmission line 512 is configured to provide a voltage signal to the sub-pixel 100, the signal transmission line 512 extends in the second direction X, and the orthographic projection of the signal transmission line 512 on the base substrate BS overlaps with the orthographic projection of the pixel opening P0 of at least one sub-pixel among the plurality of sub-pixels 100 on the base substrate BS. Therefore, it is beneficial to the longitudinal flow leveling of ink during inkjet printing, and alleviating the color shift of the up and down viewing angles.

For example, referring to Fig. 5, Fig. 24, and Fig. 29, the signal transmission line 512 includes at least one of a gate line G1, a gate line G2, and a part of the initialization line INT11 extending in the second direction X.

In the embodiments of the present disclosure, at least one of the reset transistor T4 and the light-emitting control transistor T5 may not be provided in the pixel circuit 100a, and the structure of the pixel circuit 100a is not limited to that shown in the figure, and can be provided as needed.

In the accompanying drawings of the embodiments of the present disclosure, the orthographic projection of the pixel opening P0 of the sub-pixel on the base substrate does not overlap with the orthographic projection of the via hole VH on the base substrate, which is illustrated as an example. But in some other embodiments, the orthographic projection of the pixel opening P0 of the sub-pixel on the base substrate can overlap with the orthographic projection of the via hole VH on the base substrate.

For example, in the embodiment of the present disclosure, the design of the backplane film layer, such as the design of elements in the second conductive pattern layer, can be adapted to the pixel openings of the sub-pixels with different sizes, so as to improve the flatness of the light-emitting functional layer and further alleviate the color shift of the left and right viewing angles of the display substrate.

Because the luminous efficiency of sub-pixels emitting light of different colors is different, the color shift can be alleviated and the display quality can be improved by adjusting the size of the pixel opening of the sub-pixel, adjusting the size of the third electrode plate of the storage capacitor, and overlapping the opening with the signal line.

For example, in the embodiment of the present disclosure, the thickness of an element refers to the size of the element in the direction perpendicular to the base substrate.

For example, in some embodiments, the size of the pixel opening P0 of the first sub-pixel 101 in the second direction X is in the range of 28-36 microns, the size of the pixel opening P0 of the second sub-pixel 102 in the second direction X is in the range of 30-38 microns, and the size of the pixel opening P0 of the third sub-pixel 103 in the second direction X is in the range of 68-74 microns. Of course, the size of the pixel opening P0 of the sub-pixel 100 is not limited to this case, and can be determined as needed.

For example, referring to Fig. 6, the insulating layer ISL includes a passivation layer PVX and a planarization layer PLN, the material of the passivation layer PVX includes an inorganic insulating material, and the material of the planarization layer PLN includes an organic insulating material. For example, the thickness of the planarization layer PLN is in the range of 3-7 microns.

The display substrate provided by the embodiment of the present disclosure can alleviate the color shift between the left and right viewing angles to less than 0.015. In addition, in the display substrate provided by the embodiment of the present disclosure, by overlapping the pixel opening of the sub-pixel with the signal connection line (designing the position of the longitudinal wiring), the color shift problem of the second sub-pixel (green sub-pixel) is obviously improved, and the deviation between the left and right 60-degree viewing angle is small.

In traditional inkjet printing products, the thickness of the planarization layer PLN is thicker than that of an evaporation product. However, in the display substrate provided by the embodiment of the present disclosure, the thickness of the planarization layer can be effectively reduced through the backplane design. Further, the width of the via hole VH is reduced to significantly alleviate the color shift. For example, in the embodiment of the present disclosure, the thickness of the planarization layer is in the range of 3-7 microns.

For example, the insulating layer ISL shown in Fig. 6 can be formed of an inorganic material layer, or an organic material layer, or an organic material layer and an organic material layer. The preparation of via holes in the insulating layer ISL is not limited to one-time manufacture. In order to reduce the diameter of via hole, the form of preparing sleeve holes by multiple-time manufacture is adopted, which is beneficial to the flatness of the light-emitting functional layer and further alleviating the color shift. For example, the ratio of the diameter of the uppermost via hole to the width of the pixel opening of the sub-pixel is less than 0.3. The width of the pixel opening of the sub-pixel can refer to the maximum size of the pixel opening of the sub-pixel in the second direction X.

For example, the gate line G1 can be referred to as a first gate line, the gate line G2 can be referred to as a second gate line, the gate line G4 can be referred to as a third gate line, the reset transistor T2 can be referred to as a first reset transistor, and the reset transistor T4 can be referred to as a second reset transistor. In this case, the display substrate further includes a data line, a first gate line, a second gate line, a third gate line, a first power line, a first initialization line, and a second initialization line; the data line is configured to provide a data voltage to the pixel circuit, the first gate line is configured to provide a scan signal to the pixel circuit, the second gate line is configured to provide a first reset control signal to the pixel circuit, the third gate line is configured to provide a second reset control signal to the pixel circuit, the first power line is configured to provide a first voltage signal to the pixel circuit, the first initialization line is configured to provide a first initialization signal to the pixel circuit, and the second initialization line is configured to provide a second initialization signal to the pixel circuit; the pixel circuit further includes a data writing transistor, a first reset transistor, and a second reset transistor, the first electrode of the data writing transistor is connected to the data line, the gate electrode of the data writing transistor is connected to the first gate line, and the second electrode of the data writing transistor is connected to the gate electrode of the driving transistor; the first electrode of the first reset transistor is connected to the first initialization line, the second electrode of the first reset transistor is connected to the gate electrode of the driving transistor, and the gate electrode of the first reset transistor is connected to the second gate line; the first electrode of the second reset transistor is connected to the second initialization line, the second electrode of the second reset transistor is connected to the first electrode of the light-emitting element, and the gate electrode of the second reset transistor is connected to the third gate line; the first power line includes a first power signal line extending in the second direction and a first power connection line extending in the first direction, and the first power signal line is connected to the first power connection line; the first initialization line includes a first initialization signal line extending in the second direction and a first initialization connection line extending in the first direction, and the first initialization signal line is connected to the first initialization connection line; the second initialization line includes a second initialization signal line extending in the second direction and a second initialization connection line extending in the first direction, and the second initialization signal line is connected to the second initialization connection line; and the orthographic projection of at least one of the first power connection line, the first initialization connection line, and the second initialization connection line on the base substrate overlaps with the orthographic projection of the pixel opening of the sub-pixel on the base substrate.

For example, the gate line G5 can be referred to as a fourth gate line, and the display substrate further includes a fourth gate line and a light-emitting control transistor, the fourth gate line is configured to provide a light-emitting control signal to the light-emitting control transistor, and the second electrode of the driving transistor is connected to the first power line through the light-emitting control transistor.

For example, the active layer of each transistor can include a source region, a drain region, and a channel between the source region and the drain region. For example, the channel has semiconductor characteristics; the source region and the drain region are located on both sides of the channel and can be doped with impurities, so they have conductivity and can serve as the first and second electrodes of the transistor respectively. One of the first and second electrodes of the transistor is the source electrode, and the other of the first and second electrodes of the transistor is the drain electrode.

For example, the material of the semiconductor layer (semiconductor pattern) used to manufacture the active layer can include oxide semiconductor, organic semiconductor, amorphous silicon, or polysilicon, etc. For example, the oxide semiconductor includes metal oxide semiconductor (such as indium gallium zinc oxide (IGZO)), and the polysilicon includes low-temperature polysilicon or high-temperature polysilicon, etc., which is not limited in the embodiment of the present disclosure. It should be noted that the above-mentioned source region and drain region can be regions doped with N-type impurities or P-type impurities, which is not limited by the embodiment of the present disclosure.

For example, the base substrate BS, the buffer layer BL, the barrier layer BR, the gate insulating layer GI, the interlayer insulating layer ILD, the planarization layer PLN, and the pixel defining layer PDL are all made of insulating materials. For example, the base substrate BS includes a flexible material, such as polyimide, etc., but it is not limited thereto. At least one of the buffer layer BF, the barrier layer BR, the gate insulating layer GI, and the interlayer insulating layer ILD is made of an inorganic insulating material or an organic insulating material. For example, the inorganic insulating material includes silicon oxide, silicon nitride, silicon oxynitride, etc., and the organic insulating material includes resin, but is not limited thereto. For example, the pixel defining layer PDL and the planarization layer PLN can be made of an organic material, and for example, the organic material includes resin, but is not limited thereto.

For example, both the first conductive pattern layer LY1 and the second conductive pattern layer LY2 are made of metal materials, and the specific materials can be determined as needed. For example, the material of the first conductive pattern layer LY1 includes molybdenum (Mo). The material of the second conductive pattern layer LY2 includes titanium (Ti) and aluminum (Al), and a structure in which three layers of Ti/Al/Ti are stacked can be adopted, but it is not limited to this case.

For example, the material of the first electrode E1 of the light-emitting element includes a conductive material, such as at least one of silver (Ag) or indium tin oxide (ITO), but is not limited thereto. For example, the first electrode E1 of the light-emitting element has a structure in which three layers of ITO/Ag/ITO are stacked, but it is not limited thereto. In some other embodiments, the material of the first electrode E1 of the light-emitting element includes aluminum (Al) and tungsten oxide (WOx). For example, the first electrode E1 includes a stack of an aluminum layer and an tungsten oxide layer, and the aluminum layer is closer to the base substrate than the tungsten oxide layer.

For example, the material of the second electrode E2 of the light-emitting element includes a conductive material, such as silver (Ag), but is not limited thereto.

In the embodiment of the present disclosure, the patterns of each single layer and the via holes can be manufactured by a patterning process. For example, forming a specific pattern includes forming a thin film, forming a photoresist pattern on the thin film, and patterning the thin film with the photoresist pattern as a mask to form the specific pattern. The first conductive pattern layer LY1, the second conductive pattern layer LY2, the first electrode layer LY3, the third conductive pattern layer LY4, and the via holes in the insulating layer can be formed by this method. In terms of the active layer LY0, a semiconductor pattern can be formed first, and then doped by a doping process, so that the semiconductor pattern is formed into an active layer including a channel, a source region, and a drain region, an insulating layer is formed on the active layer, a first conductive pattern layer LY1 is formed on the insulating layer, and subsequent film layers are formed in turn.

It should be noted that the layout of the sub-pixels of the display substrate provided by the embodiment of the present disclosure is not limited to that shown in Fig. 5, and transformations can be made based on Fig. 5 to form other layout diagrams. The above description takes the sub-pixel having the 4T1C pixel circuit as an example, but the embodiment of the present disclosure is not limited to this case. For example, each sub-pixel 101 can further include other numbers of transistors or other numbers of capacitors, and the pixel circuit works under the control of the data signal transmitted through the data line, the gate scan signal transmitted through the gate line, and the light-emitting control signal provided by the light-emitting control signal line to drive the light-emitting element to emit light, so as to realize operations, such as display, etc.

It should be noted that the number of thin film transistors and the number of capacitors included in the pixel circuit are not limited in the embodiment of the present disclosure.

The display substrate provided by the embodiment of the present disclosure can adopt any other suitable layout diagram, and the wiring mode is not limited to that shown in the drawings.

At least one embodiment of the present disclosure provides a display device, which includes any one of the display substrates described above. The display device can be a large-sized display device, and at least one film layer in the light-emitting functional layer is manufactured by adopting inkjet printing process.

For example, the display device can be an organic light-emitting diode display device. The display device can be any product or component including organic light-emitting diode display and having display function, such as a TV, a digital camera, a mobile phone, a watch, a tablet computer, a notebook computer, a navigator, etc.

What have been described above are only specific implementations of the present disclosure, the protection scope of the present disclosure is not limited thereto. Any changes or substitutions easily occur to those skilled in the art within the technical scope of the present disclosure should be covered in the protection scope of the present disclosure. Therefore, the protection scope of the present disclosure should be based on the protection scope of the claims.

**Claims**

1. A display substrate, comprising: a base substrate and a plurality of sub-pixels disposed on the base substrate; wherein each of the plurality of sub-pixels comprises:

   a pixel circuit, comprising a driving transistor and a storage capacitor, the storage capacitor comprising a first electrode plate and a second electrode plate, and the first electrode plate of the storage capacitor being connected to a gate electrode of the driving transistor; and
   a light-emitting element, electrically connected to the pixel circuit, the pixel circuit being configured to drive the light-emitting element,
   wherein the sub-pixel comprises a pixel opening, the pixel opening is configured to define a light-emitting region of the sub-pixel,
   an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate, and
   the display substrate satisfies a following relationship: a value range of (W*L+S2)*M1/M2 is [0.014, 0.133], and a value range of S2/(W*L) is [2.82, 28.85],
   where W is a width of the channel of the driving transistor, L is a length of the channel of the driving transistor, S2 is a facing area between the second electrode plate and the first electrode plate, M1 is a count of pixel openings in the display substrate, and M2 is an area of the display substrate.

2. The display substrate according to claim 1, wherein the second electrode plate of the storage capacitor is connected to a first electrode of the driving transistor, the storage capacitor further comprises a third electrode plate, the third electrode plate and the second electrode plate are connected to each other, and the third electrode plate and the second electrode plate are arranged at both sides of the first electrode plate, respectively.

3. The display substrate according to claim 1 or 2, wherein the second electrode plate comprises a first plate-shaped portion, and the first plate-shaped portion and the channel of the driving transistor are of an integral structure.

4. The display substrate according to claim 3, wherein the second electrode plate further comprises a second plate-shaped portion, the first plate-shaped portion and the second plate-shaped portion are separated from each other, and an area of the first plate-shaped portion is greater than an area of the second plate-shaped portion, or both the first plate-shaped portion and the second plate-shaped portion are connected with the channel of the driving transistor.

5. The display substrate according to any one of claims 1-4, wherein the channel of the driving transistor is made of a semiconductor material, and the second electrode plate is a conductor obtained by doping on a same semiconductor material as the channel of the driving transistor.

**6.** The display substrate according to any one of claims 1-5, wherein the channel of the driving transistor extends in a first direction, the pixel opening has a central axis extending in the first direction, a maximum size of the pixel opening in a second direction is WO, the first direction intersects with the second direction, a distance between the channel of the driving transistor and the central axis is D1, and a value range of 2*D11WO is [0.2, 0.4] or [0.6, 0.8].

**7.** The display substrate according to claim 6, further comprising a plurality of signal lines located at one side of the storage capacitor, wherein each of the plurality of signal lines extends in the second direction, orthographic projections of the plurality of signal lines on the base substrate overlap with the orthographic projection of the pixel opening on the base substrate, a size of the pixel opening in the first direction is H0, a distance between farthest edges of the plurality of signal lines in the first direction is Hs, and a value range of L/(H0-Hs) is [0.16, 0.61].

**8.** The display substrate according to claim 7, further comprising a data line, a first gate line, a second gate line, and a first initialization line, wherein the pixel circuit further comprises a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line,

a first electrode of the first reset transistor is connected to the first initialization line, a second electrode of the first reset transistor is connected to the gate electrode of the driving transistor, and a gate electrode of the first reset transistor is connected to the second gate line, and
the plurality of signal lines comprise the first gate line, the second gate line, and the first initialization line.

**9.** The display substrate according to any one of claims 1-4, wherein an area of the pixel opening is S0, a sum of the facing area between the second electrode plate and the first electrode plate and an area of the channel of the driving transistor is Ss, and a relationship between Ss and S0 satisfies: Ss=A*S0+B, where a value range of A is [0.42, 0.82] and a value range of B is [-2700, -3100].

**10.** The display substrate according to claim 2, wherein the orthographic projection of the pixel opening on the base substrate overlaps with an orthographic projection of the third electrode plate on the base substrate,

the third electrode plate comprises a first edge extending in a first direction and a second edge extending in the first direction, and the pixel opening comprises a first edge extending in the first direction and a second edge extending in the first direction,
the first edge of the third electrode plate is closer to the first edge of the pixel opening than the second edge of the third electrode plate, and the second edge of the third electrode plate is closer to the second edge of the pixel opening than the first edge of the third electrode plate, the sub-pixel satisfies a following formula:
$\Delta U=|U02-U01|$, where U01 is a coordinate distance between a chromaticity coordinate point at a first viewing angle and a chromaticity coordinate point at a 0-degree viewing angle, U02 is a coordinate distance between a chromaticity coordinate point at a second viewing angle and the chromaticity coordinate point at the 0-degree viewing angle, and $\Delta U$ is an absolute value of a difference between U02 and U01, the chromaticity coordinate point at the 0-degree viewing angle is a chromaticity coordinate point at a normal line passing through a center of the display substrate, the first viewing angle and the second viewing angle are arranged at opposite sides of the normal line and have an equal included angle value with the normal line, and
$\Delta U \leq 0.0020$.

**11.** The display substrate according to claim 10, further comprising a first power line, wherein the first power line is configured to provide a first voltage signal to the pixel circuit, the first power line comprises a first power connection line extending in the first direction and a first power signal line extending in a second direction, an orthographic projection of the first power connection line on the base substrate overlaps with the orthographic projection of the pixel opening on the base substrate,

a facing area between the third electrode plate and the first electrode plate is Sc1, and an overlapping area between the orthographic projection of the third electrode plate on the base substrate and the orthographic projection of the pixel opening on the base substrate is Sc2, and $Sc2/Sc1 \geq 0.9$;
a width of the first power connection line is W1, an overlapping width between the first power connection line and the pixel opening is W2, and $W2/W1 \geq 0.9$.

**12.** The display substrate according to claim 10, wherein a maximum size of the pixel opening in a second direction is WO, a value range of 2×W2/WO is [0.71, 0.99], and

a value range of cross voltage Uc/size Lg is [0.32, 0.74], where the cross voltage Uc is a cross voltage of the light-emitting element, a unit of the cross voltage Uc is volts, the size Lg is a diagonal length of the display substrate, and a unit of the size Lg is inches.

13. The display substrate according to claim 10, wherein the pixel opening has a central axis extending in the first direction, a minimum distance between the first power connection line and the central axis is Xd1, a minimum distance between the third electrode plate and the central axis is Xd2, and a value range of Xd1/Xd2 is [0.9, 1.1].

14. The display substrate according to claim 10, further comprising a plurality of signal lines located at one side of the storage capacitor, wherein orthographic projections of the plurality of signal lines on the base substrate overlap with the orthographic projection of the pixel opening on the base substrate, the plurality of signal lines are arranged in the first direction, each of the plurality of signal lines extends in a second direction, the first direction intersects with the second direction, a distance between the third electrode plate and one of the plurality of signal lines closest to the third electrode plate is Xd3, a width of the signal line is Xd4, and a value range of Xd3/Xd4 is [0.9, 1.1].

15. The display substrate according to claim 10, further comprising a first power line, wherein the first power line is configured to provide a first voltage signal to the pixel circuit, the first power line comprises a first power connection line extending in the first direction and a first power signal line extending in a second direction, the pixel opening has a central axis extending in the first direction, a minimum distance between the first power connection line and the central axis is Xd1, a minimum distance between the first power connection line and the third electrode plate is Xd0, DP=|Xd1-Xd0|/2, a maximum size of the pixel opening in the second direction is WO, and a value range of DP/WO is [0.01, 0.19].

16. The display substrate according to claim 10, further comprising a first signal line, wherein the first signal line extends in the first direction, the plurality of sub-pixels comprises a first sub-pixel and a second sub-pixel that are adjacent to each other in a second direction, the first signal line is configured to provide a data signal to the pixel circuit of the first sub-pixel, the pixel opening of the first sub-pixel and the pixel opening of the second sub-pixel are separated from each other, and the first signal line is located between the pixel opening of the first sub-pixel and the pixel opening of the second sub-pixel.

17. The display substrate according to claim 16, wherein a minimum distance between the pixel opening of the first sub-pixel and the first signal line is Xa1, a minimum distance between the pixel opening of the second sub-pixel and the first signal line is Xa2, and a value range of Xa1/Xa2 is [0.8, 1.2].

18. The display substrate according to claim 16, further comprising a second signal line, wherein the second signal line extends in the first direction, the first signal line and the second signal line are located at opposite sides of a same third electrode plate, and an orthographic projection of the second signal line on the base substrate overlaps with an orthographic projection of the pixel opening of the second sub-pixel on the base substrate.

19. The display substrate according to claim 18, wherein a distance between the third electrode plate and the second signal line is Xa3, a distance between the third electrode plate and the first signal line is Xa4, and a value range of Xa3/Xa4 is [0.8, 1.2].

20. The display substrate according to claim 18, further comprising a third signal line, wherein the third signal line extends in the first direction,

an orthographic projection of the third signal line on the base substrate overlaps with an orthographic projection of the pixel opening of the first sub-pixel on the base substrate,
a minimum distance between the third electrode plate of the first sub-pixel and the third signal line is Xa5, a minimum distance between the third signal line and the first signal line is Xa6, and a value range of Xa5/Xa6 is [0.8, 1.2].

21. The display substrate according to claim 20, wherein the first signal line comprises a data line, and at least one of the second signal line and the third signal line comprises a first power connection line.

22. The display substrate according to any one of claims 1-4, further comprising a data line and a first power line, wherein the data line is configured to provide a data voltage to the pixel circuit, and the data line extends in a first direction,

the first power line is configured to provide a first voltage signal to the pixel circuit, and the first power line comprises a first power connection line extending in the first direction and a first power signal line extending in a second direction,

the plurality of sub-pixels comprise a first sub-pixel and a second sub-pixel that are adjacent to each other in the second direction, and an orthographic projection of the first power connection line on the base substrate overlaps with an orthographic projection of the pixel opening of the first sub-pixel on the base substrate, and overlaps with an orthographic projection of the pixel opening of the second sub-pixel on the base substrate.

23. The display substrate according to claim 22, wherein two data lines are arranged at two sides of the first power connection line, respectively, and orthographic projections of the two data lines on the base substrate overlap with the orthographic projections of the pixel opening of the first sub-pixel and the pixel opening of the second sub-pixel on the base substrate, respectively.

24. The display substrate according to claim 22, wherein two data lines are arranged at two sides of the first power connection line, respectively, and orthographic projections of the two data lines on the base substrate do not overlap with the orthographic projection of the pixel opening of the first sub-pixel on the base substrate, and do not overlap with the orthographic projection of the pixel opening of the second sub-pixel on the base substrate.

25. The display substrate according to any one of claims 1-4, further comprising a first power line, wherein the first power line is configured to provide a first voltage signal to the pixel circuit, the first power line comprises a first power connection line extending in a first direction and a first power signal line extending in a second direction, and an orthographic projection of the first power connection line on the base substrate overlaps with the orthographic projection of the pixel opening on the base substrate,

a maximum size of the pixel opening in the second direction is WO,
the plurality of sub-pixels comprise a first sub-pixel and a second sub-pixel that are adjacent to each other in the second direction,
a size of one of two first power connection lines in the second direction is Xb1, a size of the other of the two first power connection lines in the second direction is Xb2, and
a value range of (Xb1+Xb2)/WO is [0.08, 0.48].

26. The display substrate according to any one of claims 1-4, further comprising a driving circuit, wherein the driving circuit is located at one side of the display substrate, one sub-pixel away from the driving circuit has a first brightness L1, one sub-pixel close to the driving circuit has a second brightness L2, and a value range of |L1-L2| is [1, 9].

27. The display substrate according to any one of claims 1-4, further comprising two driving circuits, wherein the two driving circuits are located at opposite sides of a display region of the display substrate, one sub-pixel at a central axis of the display substrate has a third brightness L3, one sub-pixel close to one of the two driving circuits has a fourth brightness L4, an extending direction of the central axis of the display substrate is the same as an extending direction of one of the two driving circuits, and a value range of |L3-L4| is [1, 9].

28. The display substrate according to any one of claims 1-4, wherein

a first defining portion is arranged between two pixel openings that are adjacent to each other in a first direction, a second defining portion is arranged between two pixel openings that are adjacent to each other in a second direction, and the first direction intersects with the second direction;
a thickness of the first defining portion is H1, a thickness of the second defining portion is H2, and H1≠H2.

29. The display substrate according to claim 28, wherein H1 is less than H2.

30. The display substrate according to any one of claims 1-4, further comprising an insulating layer, a barrier dam, and an encapsulation layer, wherein the light-emitting element comprises a first electrode, a second electrode, and a light-emitting functional layer located therebetween, and the first electrode of the light-emitting element is connected to the pixel circuit through a via hole penetrating the insulating layer,

the encapsulation layer is configured to encapsulate the light-emitting element,
the encapsulation layer comprises a stack of an inorganic encapsulation film and an organic encapsulation film,
an encapsulation adhesive is provided at an outer side of the encapsulation layer,

the insulating layer comprises a planarization layer, the planarization layer comprises a first planarization portion and a second planarization portion, and a groove is arranged between the first planarization portion and the second planarization portion,

the barrier dam is located at a periphery of a display region of the display substrate, and an orthographic projection of the barrier dam on the base substrate covers an orthographic projection of the groove on the base substrate.

31. The display substrate according to any one of claims 1-4, further comprising a data line, a first gate line, a second gate line, and a first initialization line, wherein the pixel circuit further comprises a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line,

a first electrode of the first reset transistor is connected to the first initialization line, a second electrode of the first reset transistor is connected to the gate electrode of the driving transistor, and a gate electrode of the first reset transistor is connected to the second gate line,

a dummy sub-pixel is arranged in a vicinity of an edge of the display substrate, the dummy sub-pixel is provided with a dummy driving transistor and a first dummy reset transistor, the first dummy reset transistor is connected to a gate electrode of the dummy driving transistor, and

the first dummy reset transistor is disconnected from the first initialization line.

32. The display substrate according to claim 31, further comprising a dummy data line, wherein the dummy data line extends in a first direction, the dummy data line and the data line are insulated from each other,

the dummy sub-pixel comprises at least two dummy sub-pixels that are adjacent to each other in a second direction,

dummy data lines of the at least two dummy sub-pixels are connected to each other.

33. The display substrate according to claim 32, wherein the dummy data line is connected to a constant voltage terminal, so as to be configured to provide a constant voltage.

34. The display substrate according to claim 31 or 32, wherein the at least two dummy sub-pixels comprise a first dummy sub-pixel, a second dummy sub-pixel, and a third dummy sub-pixel, and

three dummy data lines of the first dummy sub-pixel, the second dummy sub-pixel, and the third dummy sub-pixel are connected to each other.

35. The display substrate according to any one of claims 31-34, further comprising a first power line, wherein the pixel circuit further comprises a light-emitting control transistor, a first electrode of the light-emitting control transistor is connected to the first power line, a second electrode of the light-emitting control transistor is connected to a second electrode of the driving transistor,

the dummy sub-pixel further comprises a dummy light-emitting control transistor, a first electrode of the dummy light-emitting control transistor is disconnected from the first power line, and a second electrode of the dummy light-emitting control transistor is connected to a second electrode of the dummy driving transistor.

36. The display substrate according to any one of claims 1-4, further comprising a pixel defining layer, wherein the pixel defining layer comprises a defining portion, the pixel opening is defined by the defining portion, the light-emitting element comprises a first electrode and a light-emitting functional layer, the pixel defining layer is configured to expose at least a part of the first electrode of the light-emitting element, and

the light-emitting functional layer covers a sidewall of the defining portion.

37. The display substrate according to claim 36, wherein the light-emitting element further comprises a second electrode, the light-emitting functional layer is located between the first electrode and the second electrode of the light-emitting element, and the second electrode of the light-emitting element is in contact with a top wall of the defining portion.

38. The display substrate according to claim 36, further comprising an insulating layer, wherein the first electrode of the light-emitting element is connected to the pixel circuit through a via hole penetrating the insulating layer, the defining portion comprises a first defining portion and a second defining portion, a thickness of the first defining portion is less than a thickness of the second defining portion, and an orthographic projection of the via hole on the base substrate overlaps with an orthographic projection of the first defining portion on the base substrate.

39. The display substrate according to claim 38, further comprising a dummy pixel defining layer, wherein the dummy pixel defining layer comprises a plurality of dummy defining portions, and an extending direction of each of the plurality of dummy defining portions is the same as an extending direction of the second defining portion, and a spacing between two adjacent dummy defining portions is greater than a spacing between two adjacent second defining portions.

40. The display substrate according to claim 39, wherein the spacing between two adjacent dummy defining portions is 2-20 times the spacing between two adjacent second defining portions.

41. The display substrate according to any one of claims 1-4, further comprising a second reset transistor, a second initialization line, and an initialization bus, wherein the initialization bus is arranged at an outer side of a display region of the display substrate,

    a first electrode of the second reset transistor is connected to the initialization bus through the second initialization line, a second electrode of the second reset transistor is connected to the light-emitting element through the driving transistor,
    the second reset transistor is connected to a row of sub-pixels, and in terms of a same row of sub-pixels, a count of second reset transistors is less than a count of sub-pixels.

42. The display substrate according to claim 41, further comprising a light-emitting control transistor, a first power line, and a first power bus, wherein the first power line is configured to provide a first voltage signal to the pixel circuit, and the first power line is connected to the first power bus,

    a first electrode of the light-emitting control transistor is connected to the first power line, and a second electrode of the light-emitting control transistor is connected to a second electrode of the driving transistor,
    a count of light-emitting control transistors of sub-pixels in one row is less than a count of sub-pixels in the row.

43. The display substrate according to claim 42, wherein a count of light-emitting control transistors of sub-pixels in one row is greater than a count of second reset transistors in the row.

44. The display substrate according to any one of claims 1-43, wherein the second electrode plate is arranged in a same layer as the channel of the driving transistor, the second electrode plate is closer to the base substrate than the first electrode plate, and an orthographic projection of the second electrode plate on the base substrate overlaps with the orthographic projection of the pixel opening on the base substrate.

45. A display substrate, comprising: a base substrate and a plurality of sub-pixels disposed on the base substrate; wherein each of the plurality of sub-pixels comprises:

    a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and
    a light-emitting element, electrically connected to the pixel circuit, the pixel circuit being configured to drive the light-emitting element,
    wherein the sub-pixel comprises a pixel opening, the pixel opening is configured to define a light-emitting region of the sub-pixel,
    an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,
    the second electrode plate is arranged in a same layer as the channel of the driving transistor, the second electrode plate is closer to the base substrate than the first electrode plate, and
    the display substrate satisfies a following relationship: a value range of $(W*L+S2)*M1/M2$ is [0.014, 0.133], and $P=k0*(W/L)*Uc$, where a value range of $k0$ is [2.8*E-07, 5.8*E-06],
    where $W$ is a width of the channel of the driving transistor, $L$ is a length of the channel of the driving transistor, $S2$ is a facing area between the second electrode plate and the first electrode plate, $M1$ is a count of pixel openings in the display substrate, $M2$ is an area of the display substrate, $Uc$ is a cross voltage of the light-emitting element, and $P$ is power consumption of the sub-pixel.

46. A display substrate, comprising: a base substrate and a plurality of sub-pixels disposed on the base substrate;

wherein each of the plurality of sub-pixels comprises:

a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and

a light-emitting element, electrically connected to the pixel circuit, the pixel circuit being configured to drive the light-emitting element,

wherein the sub-pixel comprises a pixel opening, the pixel opening is configured to define a light-emitting region of the sub-pixel,

an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,

the second electrode plate is arranged in a same layer as the channel of the driving transistor, the second electrode plate is closer to the base substrate than the first electrode plate,

a first defining portion is arranged between two pixel openings that are adjacent to each other in a first direction, a second defining portion is arranged between two pixel openings that are adjacent to each other in a second direction, and the first direction intersects with the second direction;

a thickness of the first defining portion is H1, a thickness of the second defining portion is H2, and H1≠H2; and

the display substrate satisfies a following relationship: a value range of S2/(W*L) is [2.82, 28.85],

where W is a width of the channel of the driving transistor, L is a length of the channel of the driving transistor, S2 is a facing area between the second electrode plate and the first electrode plate.

47. The display substrate according to claim 46, wherein the display substrate satisfies a following relationship: a value range of (W*L+S2)*M1/M2 is [0.014, 0.133],

where M1 is a count of pixel openings in the display substrate, and M2 is an area of the display substrate.

48. The display substrate according to claim 46 or 47, wherein the display substrate satisfies a following relationship: P=k0*(W/L)*Uc, where a value range of k0 is [2.8*E-07, 5.8*E-06], Uc is a cross voltage of the light-emitting element, and P is power consumption of the sub-pixel.

49. A display substrate, comprising: a base substrate and a plurality of sub-pixels disposed on the base substrate; wherein each of the plurality of sub-pixels comprises:

a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and

a light-emitting element, electrically connected to the pixel circuit, the pixel circuit being configured to drive the light-emitting element,

wherein the sub-pixel comprises a pixel opening, the pixel opening is configured to define a light-emitting region of the sub-pixel,

an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,

the second electrode plate is arranged in a same layer as the channel of the driving transistor, the second electrode plate is closer to the base substrate than the first electrode plate,

the display substrate further comprises an insulating layer, a barrier dam, and an encapsulation layer, wherein the light-emitting element comprises a first electrode, a second electrode, and a light-emitting functional layer located therebetween, and the first electrode of the light-emitting element is connected to the pixel circuit through a via hole penetrating the insulating layer,

the encapsulation layer is configured to encapsulate the light-emitting element,

the encapsulation layer comprises a stack of an inorganic encapsulation film and an organic encapsulation film,

an encapsulation adhesive is provided at an outer side of the encapsulation layer,

the insulating layer comprises a planarization layer, the planarization layer comprises a first planarization portion and a second planarization portion, and a groove is arranged between the first planarization portion and the second planarization portion,

the barrier dam is located at a periphery of a display region of the display substrate, and an orthographic projection of the barrier dam on the base substrate covers an orthographic projection of the groove on the base substrate; and

the display substrate satisfies a following relationship: a value range of S2/(W*L) is [2.82, 28.85], where W is a width of the channel of the driving transistor, L is a length of the channel of the driving transistor, S2 is a facing area between the second electrode plate and the first electrode plate.

50. The display substrate according to claim 49, wherein the display substrate satisfies a following relationship: a value range of (W*L+S2)*M1/M2 is [0.014, 0.133], where M1 is a count of pixel openings in the display substrate, and M2 is an area of the display substrate.

51. The display substrate according to claim 49 or 50, wherein the display substrate satisfies a following relationship: P=k0*(W/L)*Uc, where a value range of k0 is [2.8*E-07, 5.8*E-06], Uc is a cross voltage of the light-emitting element, and P is power consumption of the sub-pixel.

52. A display substrate, comprising: a base substrate and a plurality of sub-pixels disposed on the base substrate; wherein each of the plurality of sub-pixels comprises:

a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and

a light-emitting element, electrically connected to the pixel circuit, the pixel circuit being configured to drive the light-emitting element,

wherein the sub-pixel comprises a pixel opening, the pixel opening is configured to define a light-emitting region of the sub-pixel,

an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,

the second electrode plate is arranged in a same layer as the channel of the driving transistor, the second electrode plate is closer to the base substrate than the first electrode plate,

the display substrate satisfies a following relationship: a value range of S2/(W*L) is [2.82, 28.85], where W is a width of the channel of the driving transistor, L is a length of the channel of the driving transistor, S2 is a facing area between the second electrode plate and the first electrode plate.

53. The display substrate according to claim 52, wherein the display substrate satisfies a following relationship: a value range of (W*L+S2)*M1/M2 is [0.014, 0.133], where M1 is a count of pixel openings in the display substrate, and M2 is an area of the display substrate.

54. The display substrate according to claim 52 or 53, wherein the display substrate satisfies a following relationship: P=k0*(W/L)*Uc, where a value range of k0 is [2.8*E-07, 5.8*E-06], Uc is a cross voltage of the light-emitting element, and P is power consumption of the sub-pixel.

55. A display substrate, comprising: a base substrate and a plurality of sub-pixels disposed on the base substrate; wherein each of the plurality of sub-pixels comprises:

a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and

a light-emitting element, electrically connected to the pixel circuit, the pixel circuit being configured to drive the light-emitting element,

wherein the sub-pixel comprises a pixel opening, the pixel opening is configured to define a light-emitting region of the sub-pixel,

an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,

the second electrode plate is arranged in a same layer as the channel of the driving transistor, the second electrode plate is closer to the base substrate than the first electrode plate,

the display substrate further comprises a data line, a first gate line, a second gate line, and a first initialization line, wherein the pixel circuit further comprises a data writing transistor and a first reset transistor, a first electrode of the data writing transistor is connected to the data line, the gate electrode of the driving transistor is connected to a second electrode of the data writing transistor, and a gate electrode of the data writing transistor is connected to the first gate line,

a first electrode of the first reset transistor is connected to the first initialization line, a second electrode of the first reset transistor is connected to the gate electrode of the driving transistor, and a gate electrode of the first reset transistor is connected to the second gate line,

a dummy sub-pixel is arranged in a vicinity of an edge of the display substrate, the dummy sub-pixel is provided with a dummy driving transistor and a first dummy reset transistor, the first dummy reset transistor is connected to a gate electrode of the dummy driving transistor,

the first dummy reset transistor is disconnected from the first initialization line; and

the display substrate satisfies a following relationship: a value range of $S2/(W*L)$ is [2.82, 28.85],

where W is a width of the channel of the driving transistor, L is a length of the channel of the driving transistor, S2 is a facing area between the second electrode plate and the first electrode plate.

56. The display substrate according to claim 55, wherein the display substrate satisfies a following relationship: a value range of $(W*L+S2)*M1/M2$ is [0.014, 0.133],
where M1 is a count of pixel openings in the display substrate, and M2 is an area of the display substrate.

57. The display substrate according to claim 55 or 56, wherein the display substrate satisfies a following relationship: $P=k0*(W/L)*Uc$, where a value range of k0 is [2.8*E-07, 5.8*E-06], Uc is a cross voltage of the light-emitting element, and P is power consumption of the sub-pixel.

58. A display substrate, comprising: a base substrate and a plurality of sub-pixels disposed on the base substrate; wherein each of the plurality of sub-pixels comprises:

a pixel circuit, comprising a driving transistor and a storage capacitor, the storage capacitor comprising a first electrode plate and a second electrode plate, the first electrode plate of the storage capacitor being connected to a gate electrode of the driving transistor, and the second electrode plate of the storage capacitor being connected to a first electrode of the driving transistor; and

a light-emitting element, electrically connected to the pixel circuit, the pixel circuit being configured to drive the light-emitting element,

wherein the sub-pixel comprises a pixel opening, the pixel opening is configured to define a light-emitting region of the sub-pixel,

an orthographic projection of the storage capacitor on the base substrate overlaps with an orthographic projection of the pixel opening on the base substrate, an orthographic projection of a channel of the driving transistor on the base substrate overlaps with the orthographic projection of the pixel opening on the base substrate,

the second electrode plate is arranged in a same layer as the channel of the driving transistor, the second electrode plate is closer to the base substrate than the first electrode plate,

the display substrate further comprises a pixel defining layer, wherein the pixel defining layer comprises a defining portion, the pixel opening is defined by the defining portion, the light-emitting element comprises a first electrode and a light-emitting functional layer, the pixel defining layer is configured to expose at least a part of the first electrode of the light-emitting element,

the light-emitting functional layer covers a sidewall of the defining portion, and

the display substrate satisfies a following relationship: a value range of $S2/(W*L)$ is [2.82, 28.85],

where W is a width of the channel of the driving transistor, L is a length of the channel of the driving transistor, S2 is a facing area between the second electrode plate and the first electrode plate.

59. The display substrate according to claim 58, wherein the display substrate satisfies a following relationship: a value range of $(W*L+S2)*M1/M2$ is [0.014, 0.133],
where M1 is a count of pixel openings in the display substrate, and M2 is an area of the display substrate.

60. The display substrate according to claim 58 or 59, wherein the display substrate satisfies a following relationship: $P=k0*(W/L)*Uc$, where a value range of k0 is [2.8*E-07, 5.8*E-06], Uc is a cross voltage of the light-emitting element, and P is power consumption of the sub-pixel.

61. A display device, comprising the display substrate according to any one of claims 1-60.

Fig. 1

Fig. 2

Fig. 3

Fig. 4

Fig. 5

Fig. 6

Fig. 7A

LY1

PL1/PL12/40/400/412

CEe

DTa

CEd

CEc

PLa

C1/Ca

DTc

CEa

PLc

CEb

412c

Y

X

Fig. 7B

V7

V6

V8

V12

Vc V4 V5 Va

V3

Vd

V2

Vb

V1 V13

V10 V9

Y

V0

V11

X

Fig. 7C

LY2

INT1/INT11/40/401/411

G2

G1

CEf

DTb

C2/Cc

412b/PLb

INI

G5

Y

PL1/PL11/40/400/411

X

Fig. 7D

ISL

▦ VH

Y
↑
└→ X

Fig. 7E

LY3

E1

Fig. 7F

PDL

P0

Y

X

Fig. 7G

Fig. 8A

Fig. 8B

Fig. 8C

Fig. 8D

LY0+LY1+PDL

Fig. 8E

Fig. 8F

Fig. 9

Fig. 10

Fig. 11

Fig. 12

Fig. 13

Fig. 14

Fig. 15

EP 4 580 360 A1

Fig. 16

69

LY0+LY1

PL1/PL12/40/400/412

CEe

DTa

CEd

T2a T2b

T1a T1b

CEc

C2/Cb

T3c1

T3c2

T3a

C1/Ca

T3b

DTc

T5b

T5a CEa

CEb

412c

Y

X

Fig. 17

Fig. 18

Fig. 19

LY1+LY2+PDL

PL1/PL12/40/400/412

KL4

INT1/INT11/40/401/411

DTa

G2

G1

C2/Cc

CL4

CL1

P0

KL1

DTb

KL2

CL2

412b/PLb

CL3

KL3

DTc

Y

X

Fig. 20

Fig. 21

Fig. 22

Fig. 23

Fig. 24

Fig. 25

Fig. 26

Fig. 27

Fig. 28

100/132

100/131

Fig. 29

EP 4 580 360 A1

100/151

100/152

R01

R02

Y

X

CCT

Fig. 30

CCT/CCT2

R01

100/161

CR

100/162

R02

X

CCT/CCT1

Fig. 31

Fig. 32

$300 \begin{cases} 302 \\ 301 \end{cases}$

PDL

P0/P01  P0/P02  P0/P03

VH

301

Y

X

0301   0301   0301

302

Fig. 33A

PDL

P0/P02

$300 \begin{cases} 302 \\ 301 \end{cases}$  0301   0301   302   0301   P0/P03

P0/P01

VH

301

Y

X

Fig. 33B

Fig. 34

Fig. 35

Fig. 36

**EP 4 580 360 A1**

Fig. 37

88

Fig. 38

Fig. 39

Fig. 40

Fig. 41A

Fig. 41B

Fig. 42

Fig. 43

Fig. 44

Fig. 45

Fig. 46

## INTERNATIONAL SEARCH REPORT

| International application No. |
|---|
| **PCT/CN2022/132588** |

**A.     CLASSIFICATION OF SUBJECT MATTER**

H10K59/121(2023.01)i

According to International Patent Classification (IPC) or to both national classification and IPC

**B.     FIELDS SEARCHED**

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNABS, CNTXT: 面板, 基板, 长度, 宽度, 面积, 电容, 交叠, 沟道区, 极板, 像素, 开口, 平坦, 阻挡坝; VEN, USTXT: panel, base, substrate, length, width, area, capacitor, overlap, channel region, pixel, aperture, planarization, barrier dam

**C.     DOCUMENTS CONSIDERED TO BE RELEVANT**

| Category* | Citation of document, with indication, where appropriate, of the relevant passages | Relevant to claim No. |
|---|---|---|
| A | CN 113272963 A (BOE TECHNOLOGY GROUP CO., LTD. et al.) 17 August 2021 (2021-08-17) <br> description, paragraphs 91-238, and figures 1-14 | 1-61 |
| A | CN 111785759 A (WUHAN CHINA STAR OPTOELECTRONICS SEMICONDUCTOR DISPLAY TECHNOLOGY CO., LTD.) 16 October 2020 (2020-10-16) <br> description, paragraphs 43-80 and figures 1-6B | 1-61 |
| A | CN 113141779 A (BOE TECHNOLOGY GROUP CO., LTD. et al.) 20 July 2021 (2021-07-20) <br> description, paragraphs 37-114, and figures 1-16 | 1-61 |
| A | CN 113516947 A (WUHAN TIANMA MICRO-ELECTRONICS CO., LTD.) 19 October 2021 (2021-10-19) <br> entire document | 1-61 |
| A | CN 114093918 A (BOE TECHNOLOGY GROUP CO., LTD. et al.) 25 February 2022 (2022-02-25) <br> entire document | 1-61 |

☑ Further documents are listed in the continuation of Box C.    ☑ See patent family annex.

| | |
|---|---|
| *     Special categories of cited documents: <br> "A"   document defining the general state of the art which is not considered to be of particular relevance <br> "D"   document cited by the applicant in the international application <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
|---|---|
| **26 July 2023** | **03 August 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2022/132588** |

**C.     DOCUMENTS CONSIDERED TO BE RELEVANT**

| Category* | Citation of document, with indication, where appropriate, of the relevant passages | Relevant to claim No. |
| --- | --- | --- |
| A | US 2016225318 A1 (SAMSUNG DISPLAY CO., LTD.) 04 August 2016 (2016-08-04)<br>entire document | 1-61 |
| A | JP 2010151865 A (SONY CORP.) 08 July 2010 (2010-07-08)<br>entire document | 1-61 |

Form PCT/ISA/210 (second sheet) (July 2022)

# EP 4 580 360 A1

**INTERNATIONAL SEARCH REPORT**
Information on patent family members

International application No.

**PCT/CN2022/132588**

| Patent document cited in search report | | | Publication date (day/month/year) | Patent family member(s) | | | Publication date (day/month/year) |
|---|---|---|---|---|---|---|---|
| CN | 113272963 | A | 17 August 2021 | WO | 2021081753 | A1 | 06 May 2021 |
| | | | | US | 2023095733 | A1 | 30 March 2023 |
| CN | 111785759 | A | 16 October 2020 | CN | 213150776 | U | 07 May 2021 |
| | | | | US | 2022020836 | A1 | 20 January 2022 |
| | | | | WO | 2022011896 | A1 | 20 January 2022 |
| CN | 113141779 | A | 20 July 2021 | WO | 2021097690 | A1 | 27 May 2021 |
| | | | | EP | 4064358 | A1 | 28 September 2022 |
| CN | 113516947 | A | 19 October 2021 | US | 2022277691 | A1 | 01 September 2022 |
| | | | | CN | 113516947 | B | 17 January 2023 |
| CN | 114093918 | A | 25 February 2022 | CN | 217035641 | U | 22 July 2022 |
| US | 2016225318 | A1 | 04 August 2016 | KR | 20160095306 | A | 11 August 2016 |
| | | | | KR | 102457466 | B1 | 21 October 2022 |
| | | | | US | 10019946 | B2 | 10 July 2018 |
| JP | 2010151865 | A | 08 July 2010 | JP | 5422991 | B2 | 19 February 2014 |

Form PCT/ISA/210 (patent family annex) (July 2022)